(19) Europäisches Patentamt
European Patent Office
Office européen des brevets

(11) EP 3 247 765 B1

(12) # EUROPÄISCHE PATENTSCHRIFT

(45) Veröffentlichungstag und Bekanntmachung des Hinweises auf die Patenterteilung:
**07.11.2018 Patentblatt 2018/45**

(21) Anmeldenummer: **16702343.1**

(22) Anmeldetag: **20.01.2016**

(51) Int Cl.:
***C09K 11/06*** *(2006.01)* ***H01L 51/50*** *(2006.01)*
***H01L 51/00*** *(2006.01)*

(86) Internationale Anmeldenummer:
**PCT/EP2016/051084**

(87) Internationale Veröffentlichungsnummer:
**WO 2016/116485 (28.07.2016 Gazette 2016/30)**

(54) **AZOLE ZUR VERWENDUNG IN OPTOELEKTRONISCHEN BAUELEMENTEN**
AZOLES FOR USE IN OPTOELECTRONIC COMPONENTS
AZOLES À UTILISER DANS DES COMPOSANTS OPTOÉLECTRONIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.01.2015 EP 15151870**
**20.05.2015 DE 102015107906**

(43) Veröffentlichungstag der Anmeldung:
**29.11.2017 Patentblatt 2017/48**

(73) Patentinhaber: **cynora GmbH**
**76646 Bruchsal (DE)**

(72) Erfinder:
- **AMBROSEK, David**
  **10437 Berlin (DE)**
- **DANZ, Michael**
  **76344 Eggenstein-Leopoldshafen (DE)**
- **FLÜGGE, Harald**
  **76135 Karlsruhe (DE)**
- **FRIEDRICHS, Jana**
  **76137 Karlsruhe (DE)**
- **GRAB, Tobias**
  **76133 Karlsruhe (DE)**
- **JACOB, Andreas**
  **30449 Hannover (DE)**
- **SEIFERMANN, Stefan**
  **77815 Bühl (DE)**
- **VOLZ, Daniel**
  **76137 Karlsruhe (DE)**

(74) Vertreter: **Hoppe, Georg Johannes**
**Darani Anwaltskanzlei**
**Beuckestrasse 20**
**14163 Berlin (DE)**

(56) Entgegenhaltungen:
**EP-A1- 1 493 797** **EP-A2- 0 879 868**
**WO-A1-2008/149828** **JP-A- H10 226 785**
**US-A1- 2007 222 376**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 247 765 B1

Printed by Jouve, 75001 PARIS (FR)

## Beschreibung

Die Erfindung betrifft rein organische Moleküle und deren Verwendung in organischen lichtemittierenden Dioden (OLEDs) und in anderen optoelektronischen Bauelementen.

## Stand der Technik

In den letzten Jahren hat sich die auf OLED (organische lichtemittierende Dioden) basierende Technik im Bereich Bildschirmtechnik etabliert, so dass nun die ersten hierauf aufbauenden kommerziellen Produkte erhältlich werden. Neben der Bildschirmtechnik eignen sich OLEDs auch für die Anwendung in flächiger Beleuchtungstechnik. Aus diesem Grund wird bezüglich der Entwicklung neuer Materialien intensive Forschung betrieben.

OLEDs sind in der Regel in Schichtenstrukturen realisiert, welche überwiegend aus organischen Materialien bestehen. Zum besseren Verständnis ist in Figur 1 ein vereinfachter Aufbau exemplarisch dargestellt. Herzstück solcher Bauteile ist die Emitterschicht, in der in der Regel emittierende Moleküle in einer Matrix eingebettet sind. In dieser Schicht treffen sich negative Ladungsträger (Elektronen) und positive Ladungsträger (Löcher), die zu sogenannten Exzitonen (= angeregte Zustände) rekombinieren. Die in den Exzitonen enthaltene Energie kann von den entsprechenden Emittern in Form von Licht abgegeben werden, wobei man in diesem Fall von Elektrolumineszenz spricht. Einen Überblick über die Funktion von OLEDs findet sich beispielsweise bei H. Yersin, Top. Curr. Chem. 2004, 241, 1 und H. Yersin, "Highly Efficient OLEDs with Phosphorescent Materials"; Wiley-VCH, Weinheim, Germany, 2008.

Seit den ersten Berichten bezüglich OLEDs (Tang et al. Appl. Phys. Lett. 1987, 51, 913) ist diese Technik besonders auf dem Gebiet der Emittermaterialien immer weiterentwickelt worden. Während die ersten Materialien, die auf rein organischen Molekülen beruhen, aufgrund von Spinstatistik maximal 25 % der Exzitonen in Licht umwandeln konnten, konnte durch die Verwendung von phosphoreszierenden Verbindungen dieses grundsätzliche Problem umgangen werden, so dass zumindest theoretisch alle Exzitonen in Licht umgewandelt werden können. Bei diesen Materialien handelt es sich in der Regel um Übergangsmetall-Komplexverbindungen, in denen das Metall aus der dritten Periode der Übergangsmetalle gewählt wird. Hierbei werden vorwiegend sehr teure Edelmetalle wie Iridium, Platin oder auch Gold eingesetzt. (Siehe dazu auch H. Yersin, Top. Curr. Chem. 2004, 241, 1 und M. A. Baldo, D. F. O'Brien, M. E. Thompson, S. R. Forrest, Phys. Rev. B 1999, 60, 14422). Neben den Kosten ist auch die Stabilität der Materialien zum Teil nachteilig für die Verwendung.

Eine neue Generation von OLEDs basiert auf der Ausnutzung von verzögerter Fluoreszenz (TADF: thermally activated delayed fluorescence oder auch singlet harvesting). Hierbei können beispielsweise Cu(I)-Komplexe verwendet werden, die aufgrund eines geringen Energieabstandes zwischen dem untersten Triplett-Zustand $T_1$ und dem darüberliegenden Singulett-Zustand $S_1$ ($\Delta E(S_1$-$T_1)$ Triplett-Exitonen thermisch in einen Singulett-Zustand rückbesetzen können. Neben der Verwendung von Übergangsmetallkomplexen können auch rein organische Moleküle diesen Effekt ausnutzen.

Einige solcher TADF-Materialien wurden bereits in ersten optoelektronischen Bauelementen eingesetzt. Die bisherigen Lösungen weisen jedoch Nachteile und Probleme auf: Die TADF-Materialien weisen in den optoelektronischen Bauelementen oftmals keine ausreichende Langzeitstabilität, keine ausreichende thermische oder keine ausreichende chemische Stabilität gegenüber Wasser und Sauerstoff auf. Außerdem sind nicht alle wichtigen Emissionsfarben verfügbar. Weiterhin sind einige TADF-Materialien nicht verdampfbar und dadurch für den Einsatz in kommerziellen optoelektronischen Bauteilen nicht geeignet. Auch weisen einige TADF-Materialien keine passenden Energielagen zu den weiteren im optoelektronischen Bauteil verwendeten Materialien (z.B. HOMO-Energien von TADF-Emittern von größer gleich -5,9 eV) auf. Nicht mit allen TADF-Materialien lassen sich ausreichend hohe Effizienzen der optoelektronischen Bauelemente bei hohen Stromdichten bzw. hohe Leuchtdichten erreichen. Weiterhin sind die Synthesen einiger TADF-Materialien aufwendig.

Moleküle, die der Erfindung ähneln sind aus EP0879868 A2, WO2008/149828 A1 und US2007/222376 A1 bekannt.

## Beschreibung

Die Erfindung betrifft in einem ersten Aspekt die Bereitstellung von organischen Molekülen, die eine Struktur der Formel 1 aufweisen oder eine Struktur der Formel 1 haben:

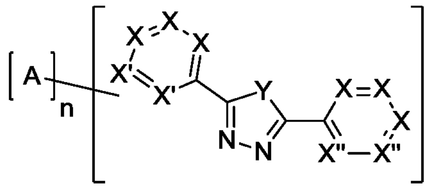

**Formel 1**

wobei Formel 1 eine Teilstruktur A der Formel 1a aufweist

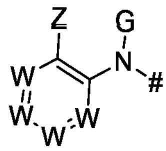

**Formel 1a**

und wobei gilt:

| | |
|---|---|
| n | ist eine ganze Zahl von 1 bis 4; |
| X, X' und X" | sind unabhängig voneinander ausgewählt aus der Gruppe bestehend aus aus N, CR* und C-A; |
| # | kennzeichnet die Stelle über die die Teilstruktur A an das C-Atom von C-A gebunden ist; |
| Y | ausgewählt aus der Gruppe bestehend aus O, S, Se und NR*; |
| W | unabhängig voneinander ausgewählt aus N, CR* oder CR**, wobei mindestens ein CR** vorhanden ist; |
| Z | Rest R*, wobei R* optional mit G zusammen Teil eines annelierten oder nichtannelierten 5-, 6-, 7- oder 8-gliedrigen Ringsystems, ausgewählt aus der Gruppe aus mit elektronenreichen Resten substituiertem Carbazol oder Indol, Hydroindol, Hydrocarbazol, Pyrol, Chinolin, Hydrochinolin, Azepin, Benzoazepin, Dibenzoazepin, Hydroazepin, Hydrobenzoazepin, Hydrodibenzoazepin, Tribenzoazepin, Phenazin, Indolocarbazol, Indenoindol, Phenoxazin, Phenothiazin oder Dihydroacridin, ist; |
| G | Rest R*, wobei R* optional mit Z zusammen Teil eines annelierten oder nichtannelierten 5-, 6-, 7- oder 8-gliedrigen Ringsystems, ausgewählt aus der Gruppe aus mit elektronenreichen Resten substituiertem Carbazol oder Indol, Hydroindol, Hydrocarbazol, Pyrol, Chinolin, Hydrochinolin, Azepin, Benzoazepin, Dibenzoazepin, Hydroazepin, Hydrobenzoazepin, Hydrodibenzoazepin, Tribenzoazepin, Phenazin, Indolocarbazol, Indenoindol, Phenoxazin, Phenothiazin oder Dihydroacridin, ist; |

und wobei gilt, dass

- bei n = 1 die Anknüpfung der Einheit A an einem X' erfolgt;
- bei n = 2 die Anknüpfung von mindestens einer Einheit A an einem X' erfolgt und dass insbesondere die Anknüpfung der zweiten Einheit A an einem X" erfolgt;
- bei n = 3 die Anknüpfung von mindestens einer Einheit A an einem X' erfolgt und dass insbesondere die Anknüpfung der zweiten und dritten Einheit A an einem X' oder X" erfolgt;
- bei n = 4 die Anknüpfung von mindestens einer Einheit A an einem X' erfolgt und dass insbesondere die Anknüpfung der zweiten, dritten und vierten Einheit A an einem X' oder X" erfolgt;

und wobei gilt:
Rest R** ist bei jedem Auftreten unabhängig voneinander ausgewählt aus einem elektronenreichen Rest wie Alkyl (linear, verzweigt oder cyclisch), Methoxy, Ethoxy, Phenoxy, Alkoxy, $NR_2$, Diphenylamin, Amin, Carbazol, Indol, Hydroindol, Hydrocarbazol, Pyrol, Chinolin, Hydrochinolin, Azepin, Benzoazepin, Dibenzoazepin, Hydroazepin, Hydrobenzoazepin, Hydrodibenzoazepin, Tribenzoazepin, Phenazin, Indolocarbazol, Indenoindol, Phenoxazin, Phenothiazin oder Dihydroacridin oder Acridin;
und wobei weiterhin gilt:

R* ist bei jedem Auftreten unabhängig voneinander ausgewählt aus der Gruppe bestehend aus H, Deuterium, Phenyl, Naphthyl, $N(R^2)_2$, -CN, -NC, -SCN, $-CF_3$, $-NO_2$, C(=O)OH, $C(=O)OR^3$, $C(=O)N(R^3)_2$, $C(=O)SR^3$, $C(=S)SR^3$, $Si(R^4)_3$, $B(OR^5)_2$, $B(N(R^6)_2)_2$, $C(=O)R^3$, $P(=O)(R^7)_2$, $As(=O)(R^7)_2$, $P(=S)(R^7)_2$, $As(=S)(R^7)_2$, $S(=O)R^3$, $S=NR^3$,

$S(=O)NR^3$, $S(=O)_2NR^3$, $S(=O)_2R^3$, $O-S(=O)_2R^3$, $SF_5$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C=C-, bzw. eine benachbarte $CH_2$-Gruppe durch $-Si(R^4)_2-$, $-Ge(R^4)_2-$, $-Sn(R^4)_2$, -C(=O)-, -C(=S)-, -C(=Se)-,-C=N-, -C(=O)O-, $-C(=O)N(R^3)-$, $-P(=O)(R^7)-$, $-As(=O)(R^7)-$, $-P(=S)(R^7)$, $-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten R* auch miteinander ein mono- oder polycyclisches, aliphatisches, aromatisches und/oder benzoannelliertes Ringsystem bilden. In einer Ausführungsform ist das Ringsystem, das gebildet werden kann auf ein monozyklisches aliphatisches Ringsystem mit insgesamt fünf oder sechs Ringgliedern beschränkt.

$R^2$ ist bei jedem Auftreten unabhängig voneinander ausgewählt aus der Gruppe bestehend aus H, Deuterium, Phenyl, Naphthyl, $CF_3$, $C(=O)OR^3$, $C(=O)N(R^2)_2$, $Si(R^4)_3$, $C(=O)R^3$, $P(=O)(R^7)_2$, $As(=O)(R^7)_2$ $P(=S)(R^7)_2$, $As(=S)(R^7)_2$, $S(=O)R^3$, $S(=O)_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, $-C\equiv C-$, bzw. eine benachbarte $CH_2$-Gruppe durch $-Si(R^4)_2-$,$-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$,$-As(=O)(R^7)-$, $-P(=S)(R^7)-$, $-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^2$ auch miteinander ein mono- oder polycyclisches, aliphatisches, aromatisches und/oder benzoannelliertes Ringsystem bilden;

$R^3$ ist bei jedem Auftreten unabhängig voneinander ausgewählt aus der Gruppe bestehend aus H, Deuterium, Phenyl, Naphthyl, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^3$ auch miteinander ein mono- oder polycyclisches, aliphatisches Ringsystem bilden;

$R^4$ ist bei jedem Auftreten unabhängig voneinander ausgewählt aus der Gruppe bestehend aus H, Deuterium, Phenyl, Naphthyl, $N(R^2)_2$, CN, $CF_3$, OH, $C(=O)OR^3$, $C(=O)N(R^3)_2$, $C(=O)R^3$, $P(=O)(R^7)_2$, $As(=O)(R^7)_2$, $P(=S)(R^7)_2$, $As(=S)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch-$R^9C=CR^9-$, $-C\equiv C-$, bzw. eine benachbarte $CH_2$-Gruppe durch $-Si(R^4)_2-$, $-Ge(R^4)_2-$, $-Sn(R^4)_2$,-C(=O)-, -C(=S)-, -C(=Se)-, -C=N-, -C(=O)O-, $-C(=O)N(R^3)-$, $-P(=O)(R^7)-$, $-As(=O)(R^7)-$,$-P(=S)(R^7)$, $-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^4$ auch miteinander ein mono- oder polycyclisches, aliphatisches, aromatisches und/oder benzoannelliertes Ringsystem bilden;

$R^5$ ist bei jedem Auftreten unabhängig voneinander ausgewählt aus der Gruppe bestehend aus Phenyl, Naphthyl,

$CF_3$, $C(=O)R^3$, $P(=O)(R^7)_2$, $As(=O)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch-$R^9C=CR^9$-, -C≡C-, bzw. eine benachbarte $CH_2$-Gruppe durch -$Si(R^4)_2$-, -$Ge(R^4)_2$-, -$Sn(R^4)_2$,-C(=O)-, -C(=S)-, -C(=Se)-, -C=N-, -C(=O)O-, -$C(=O)N(R^3)$-, -$P(=O)(R^7)$-, -$As(=O)(R^7)$-,-$P(=S)(R^7)$-, -$As(=S)(R^7)$-, -S(=O)-, -$S(=O)_2$-, -$NR^2$-, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^5$ auch miteinander ein mono- oder polycyclisches, aliphatisches, aromatisches und/oder benzoannelliertes Ringsystem bilden;

$R^6$ ist bei jedem Auftreten unabhängig voneinander ausgewählt aus der Gruppe bestehend aus Phenyl, Naphthyl, $CF_3$, $Si(R^4)_3$, $C(=O)R^3$, $P(=O)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch-$R^9C=CR^9$-, -C≡C-, bzw. eine benachbarte $CH_2$-Gruppe durch -$Si(R^4)_2$-, -$Ge(R^4)_2$-, -$Sn(R^4)_2$,-C(=O)-, -C(=S)-, -C(=Se)-, -C=N-, -C(=O)O-, -$C(=O)N(R^3)$-, -$P(=O)(R^7)$-, -$As(=O)(R^7)$-,-$P(=S)(R^7)$, -$As(=S)(R^7)$-, -S(=O)-, -$S(=O)_2$-, -$NR^2$-, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste R* substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^6$ auch miteinander ein mono- oder polycyclisches, aliphatisches, aromatisches und/oder benzoannelliertes Ringsystem bilden;

$R^7$ ist bei jedem Auftreten unabhängig voneinander ausgewählt aus der Gruppe bestehend aus, Phenyl, Naphthyl, $N(R^2)_2$, CN, $CF_3$, $C(=O)OR^3$, $C(=O)N(R^3)_2$, $Si(R^4)_3$, $C(=O)R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch -$R^9C=CR^9$-, -C≡C-, bzw. eine benachbarte $CH_2$-Gruppe durch -$Si(R^4)_2$-, -$Ge(R^4)_2$-, -$Sn(R^4)_2$,-C(=O)-, -C(=S)-, -C(=Se)-, -C=N-, -C(=O)O-,-$C(=O)N(R^3)$-, -$P(=O)(R^7)$-, -$As(=O)(R^7)$-, -$P(=S)(R^7)$, -$As(=S)(R^7)$-, -S(=O)-, -$S(=O)_2$-, -$NR^2$-,-O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^3$ substituiert sein kann, oder eine Kombination dieser Systeme; dabei können zwei oder mehrere dieser Substituenten $R^7$ auch miteinander ein mono- oder polycyclisches, aliphatisches, aromatisches und/oder benzoannelliertes Ringsystem bilden;

$R^8$ ist bei jedem Auftreten unabhängig voneinander ausgewählt aus der Gruppe bestehend aus H, Deuterium, Phenyl, Naphthyl, F, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^8$ auch miteinander ein mono- oder polycyclisches, aliphatisches Ringsystem bilden;

$R^9$ ist bei jedem Auftreten unabhängig voneinander ausgewählt aus der Gruppe bestehend aus H, Deuterium, Phenyl, Naphthyl, $N(R^2)_2$, CN, $CF_3$, $NO_2$, OH, COOH, $C(=O)OR^3$, $C(=O)N(R^3)_2$, $Si(R^4)_3$, $B(OR^5)_2$, $C(=O)R^3$, $P(=O)(R^7)_2$, $P(=S)(R^7)_2$, $As(=O)(R^7)_2$, $P(=S)(R^7)_2$, $S(=O)R^3$, $S(=O)_2R^3$, $OSO_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die

jeweils mit einem oder mehreren Resten $R^8$ substituiert sein kann, wobei eine oder mehrere nicht benachbarte $CH_2$-Gruppen durch $-R^3C=CR^3-$, -C≡C-, bzw. eine benachbarte $CH_2$-Gruppe durch $-Si(R^4)_2-$, $-Ge(R^4)_2-$, $-Sn(R^4)_2$,-C(=O)-, -C(=S)-, -C(=Se)-,-C=N-, -C(=O)O-, $-C(=O)N(R^3)-$, $-P(=O)(R^7)-$, $-As(=O)(R^7)-$, $-P(=S)(R^7)$, $-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^3$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^8$ substituiert sein kann, oder eine Kombination dieser Systeme; dabei können zwei oder mehrere dieser Substituenten $R^9$ auch miteinander ein mono- oder polycyclisches, aliphatisches, aromatisches und/oder benzoannelliertes Ringsystem bilden.

Eine Arylgruppe im Sinne dieser Erfindung enthält 6 bis 60 aromatische Ringatome; eine Heteroarylgruppe im Sinne dieser Erfindung enthält 5 bis 60 aromatische Ringatome, von denen mindestens eines ein Heteroatom darstellt. Die Heteroatome sind insbesondere N, O, und S. Werden in der Beschreibung der vorliegenden Erfindung andere Definitionen angegeben, beispielsweise bezüglich der Zahl der aromatischen Ringatome oder der enthaltenen Heteroatome, so gelten diese anderen Definitionen.

Dabei wird unter einer Arylgruppe bzw. Heteroarylgruppe ein einfacher aromatischer Cyclus, also Benzol, bzw. ein einfacher heteroaromatischer Cyclus, beispielsweise Pyridin, Pyrimidin oder Thiophen, oder ein heteroaromatischer Polycyclus, beispielsweise Napthalin, Phenanthren, Chinolin oder Carbazol verstanden. Ein kondensierter (annelierter) aromatischer bzw. heteroaromatischer Polycyclus besteht im Sinne der vorliegenden Anmeldung aus zwei oder mehr miteinander kondensierten einfachen aromatischen bzw. heteroaromatischen Cyclen.

Unter einer Aryl- oder Heteroarylgruppe, die jeweils mit den oben genannten Resten substituiert sein kann und die über beliebige Positionen am Aromaten bzw. Heteroaromaten verknüpft sein kann, werden insbesondere Gruppen verstanden, welche abgeleitet sind von Benzol, Naphthalin, Anthracen, Phenanthren, Pyren, Dihydropyren, Chrysen, Perylen, Fluoranthen, Benzanthracen, Benzphenanthren, Tetracen, Pentacen, Benzpyren, Furan, Benzofuran, Isobenzofuran, Dibenzofuran, Thiophen, Benzothiophen, Isobenzothiophen, Dibenzothiophen; Pyrrol, Indol, Isoindol, Carbazol, Pyridin, Chinolin, Isochinolin, Acridin, Phenanthridin, Benzo-5,6-chinolin, Isochinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Napthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benztriazol, 1,2,3-Oxadiazol, 1,2,4-Oxadiazol, 1,2,5-Oxadiazol, 1,2,3,4-Tetrazin, Purin, Pteridin, Indolizin und Benzothiadiazol.

Ein aromatisches Ringsystem im Sinne dieser Erfindung enthält 6 bis 60 C-Atome im Ringsystem. Ein heteroaromatisches Ringsystem im Sinne dieser Erfindung enthält 5 bis 60 aromatische Ringatome, von denen mindestens eines ein Heteroatom darstellt. Die Heteroatome sind insbesondere ausgewählt aus, N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nichtaromatische Einheit (insbesondere weniger als 10% der verschiedenen Atome), wie z.B. ein sp3-hybridisiertes C-, Si-, oder N-Atom, ein sp2-hybridisiertes C-, N- oder O-Atom oder ein sp-hybridisiertes C-Atom, verbunden sein können. So sollen beispielsweise auch System wie 9,9'-Diarylfluoren, Triarylamin, Diarylether, Stilben etc als aromatische Ringsysteme im Sinne dieser Erfindung verstanden werden, und ebenso Systeme, in denen zwei oder mehrere Arylgruppen beispielsweise durch eine lineare oder cyclische Alkyl-, Alkenyl- oder Alkinylgruppen oder durch eine Silylgruppe verbunden sind. Weiterhin werden auch Systeme, in denen zwei oder mehr Aryl- oder Heteroyraylgruppen über Einfachbindungen miteinander verknüpft sind, als aromatische oder heteroaromatische Ringsysteme im Sinne dieser Erfindung verstanden, wie beispielsweise Systeme wie Biphenyl, Terphenyl oder Diphenyltriazin.

Unter einem aromatischen oder heteroaromatischen Ringsystem mit 5 bis 60 aromatischen Ringatomen, welches noch jeweils mit Resten wie oben definiert substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Benzphenanthren, Pyren, Chrysen, Perylen, Fluoranthen, Napthacen, Pentacen, Benzpyren, Biphenyl, Biphenylen, Terphenyl, Terphenylen, Quaterphenyl, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyarzinimidazol, Chinoxalinimidazol, Oxazol, Benzoxazol, Napthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,2,3 Oxadiazol, 1,2,3-Thiadiazol, 1,2,5-Thiadiazol, 1,3,4-Thiadiazol, 1,3,5-Triazin, 1,2,4-Triazin, 1,2,3-Triazin, Tetrazol, 1,2,3,5-Tetrazin, 1,2,3,4-Tetrazin, Purin, Pteridin, Indolizin und Benzothiadiazol oder Kombinationen dieser Gruppen.

Eine Ausführungsform betrifft Moleküle aufweisend eine Struktur gemäß Formel 2:

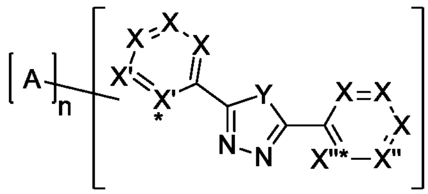

**Formel 2**

wobei die Anknüpfung einer ersten Einheit A an X'* erfolgt;
und wobei im Fall von n > 1 die Anknüpfung einer zweiten Einheit A an X"* erfolgt;
und wobei ansonsten die bei Formel 1 angegebenen Definitionen gelten.

In einer Ausführungsform werden Moleküle nach den Formeln 3 verwendet, wobei # die Anknüpfungsposition für eine Einheit nach Formel 1a darstellt und wobei die für Formel 1 angegebenen Definitionen gelten und wobei X insbesondere CR* ist.

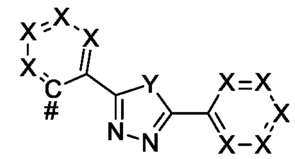
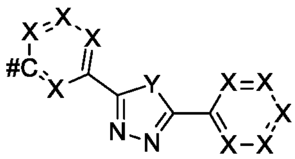
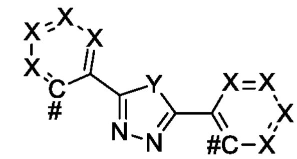
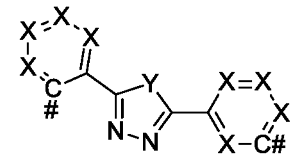
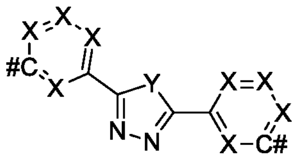
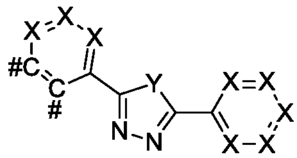
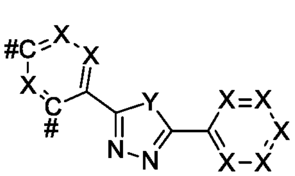
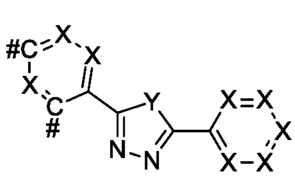
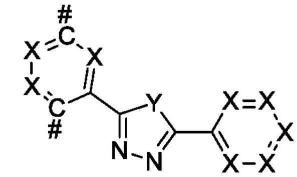
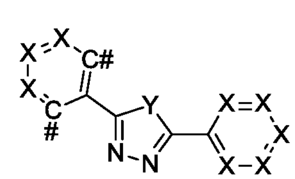
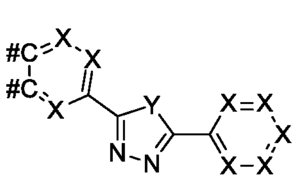
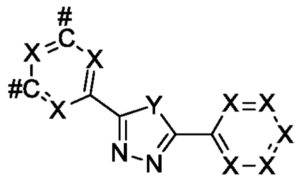
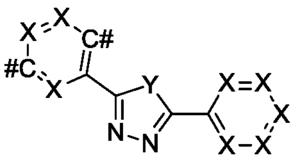
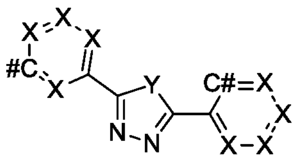
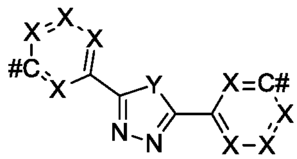
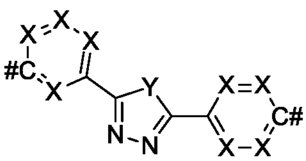
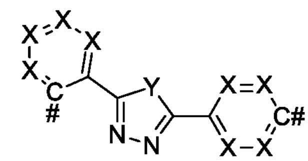
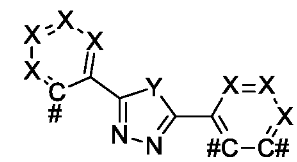
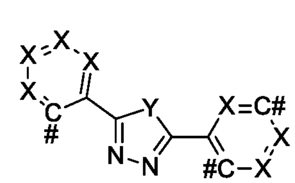
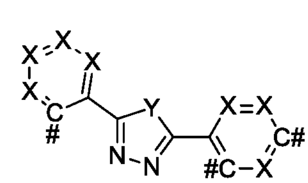
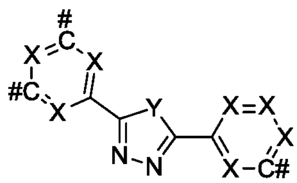
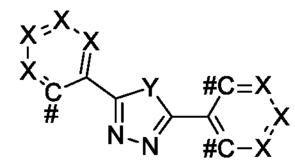
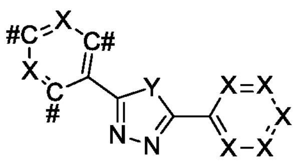
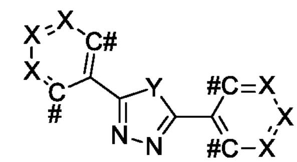
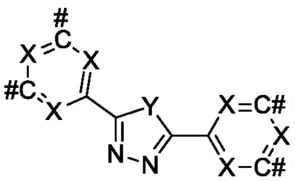
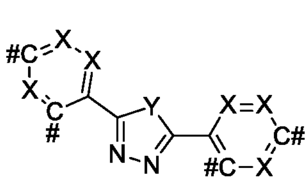
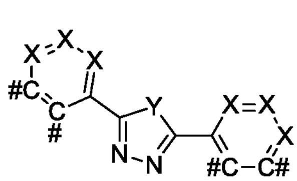

**Formeln 3**

In einer Ausführungsform sind Z und G Teil eines Ringsystems mit 5, 6, 7 oder 8 Gliedern, welche in einer

Ausführungsform mit elektronenreichen Resten substituiert sind, um die HOMO-Energie des Moleküls auf eine aus technischen Gründen vorteilhaften Wert von mehr als -5,8 eV anzuheben. In diesem Fall lassen sich aus den erfindungsgemäßen Molekülen besonders leistungsstarke und langlebige OLED Bauteile fertigen, da die Differenz zur HOMO-Energie von Indium-zinn-oxid (ITO), von -4,9 eV weniger als 1 eV beträgt. Derartige elektronenreiche Reste sind beispielsweise Alkyl (linear, verzweigt oder cyclisch), Methoxy, Ethoxy, Phenoxy, Alkoxy, $NR_2$, Diphenylamin, Amin, Carbazol, Indol, Hydroindol, Hydrocarbazol, Pyrol, Chinolin, Hydrochinolin, Azepin, Benzoazepin, Dibenzoazepin, Hydroazepin, Hydrobenzoazepin, Hydrodibenzoazepin, Tribenzoazepin, Phenazin, Indolocarbazol, Indenoindol, Phenoxazin, Phenothiazin oder Dihydroacridin oder Acridin. Unsubstituiertes Carbazol ist dementsprechend kein erfindungsgemäßer Rest. Ein entsprechendes organisches Molekül ist somit ausgewählt aus einer der Strukturen 3-1 bis 3-27:

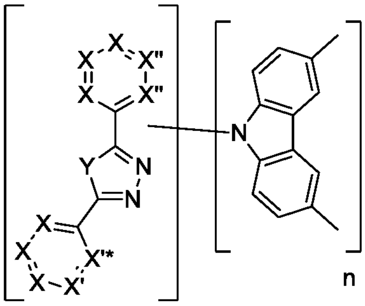

3-1

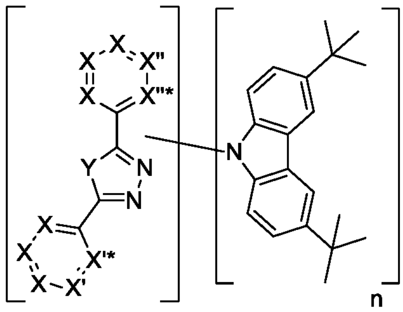

3-2

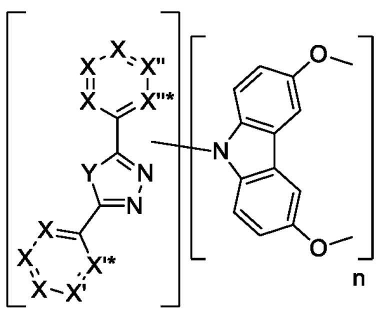

3-3

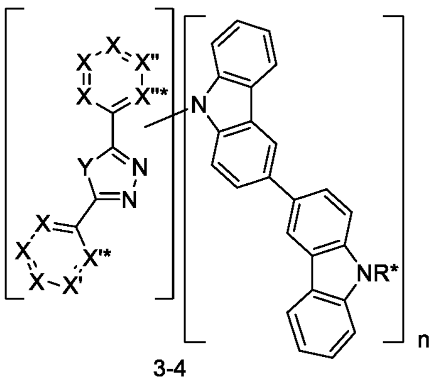

3-4

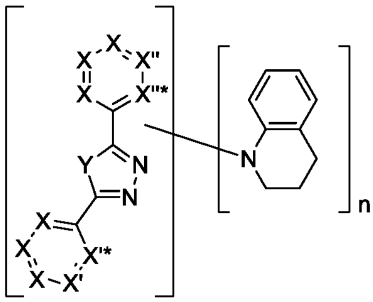

3-5

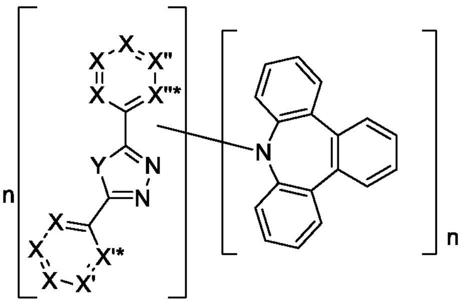

3-6

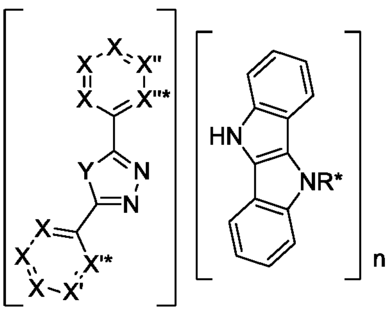

3-7

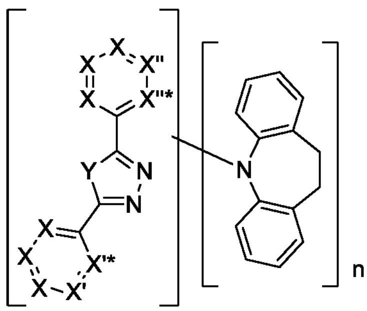

3-8

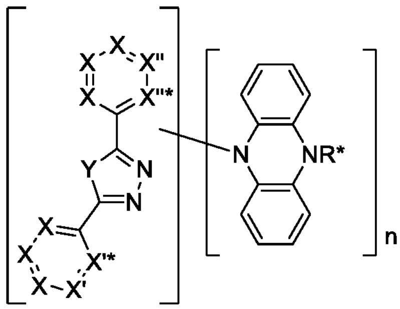

3-9

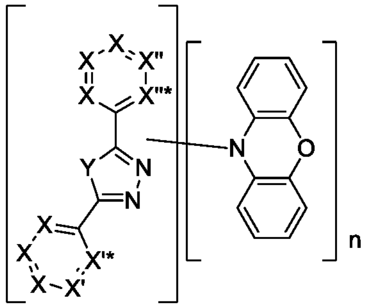

3-10

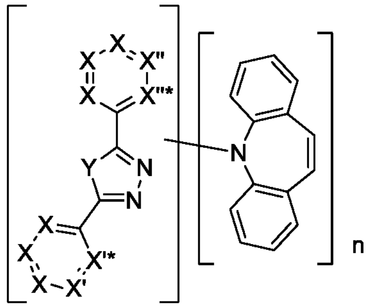

3-11

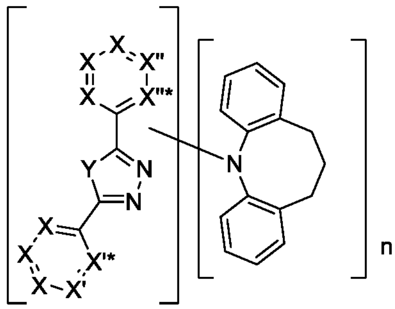

3-12

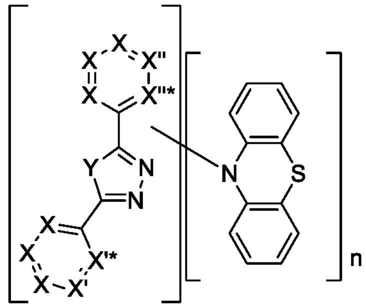

3-13

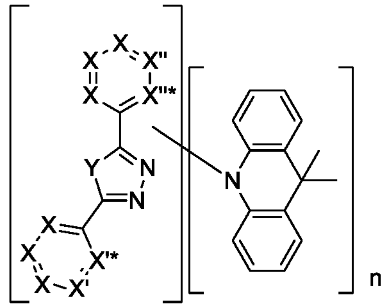

3-14

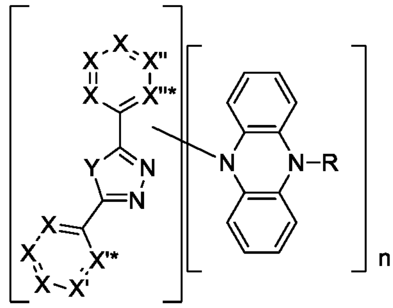

3-15

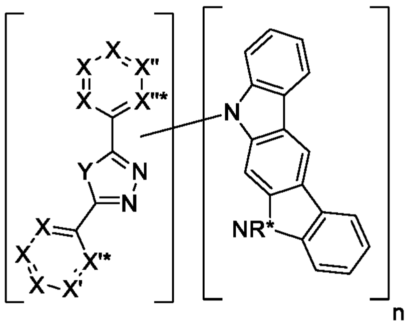

3-16

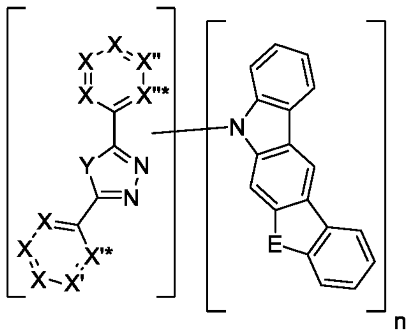

3-17

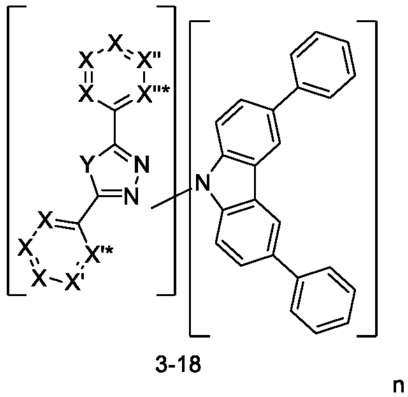

3-18

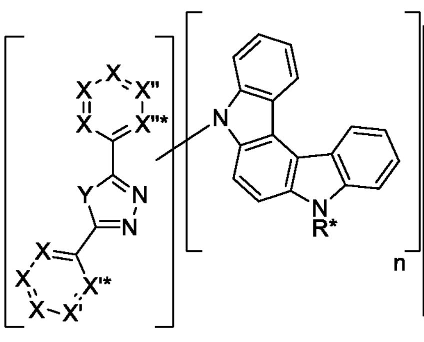

3-19

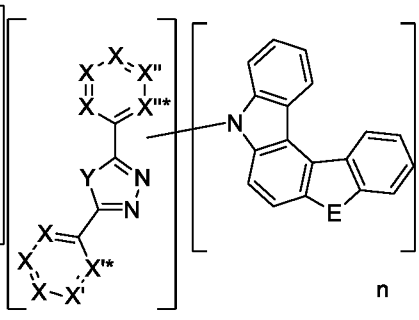

3-20

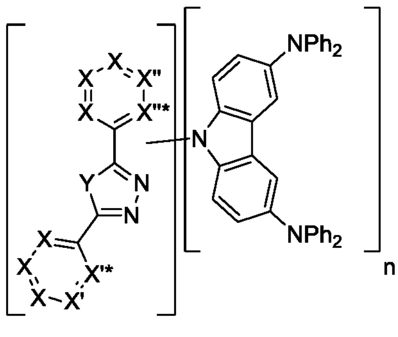

3-21

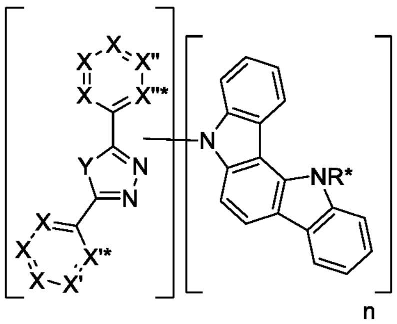

3-22

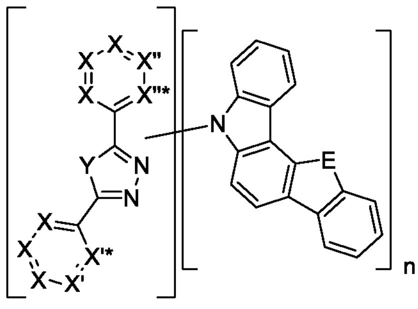

3-23

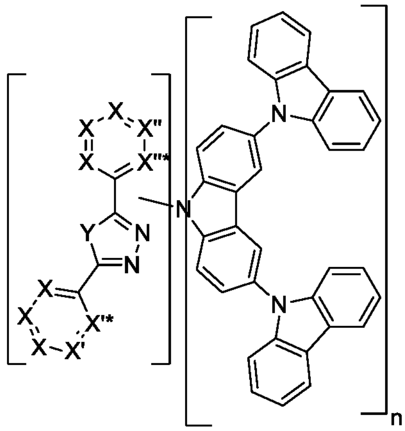

3-24

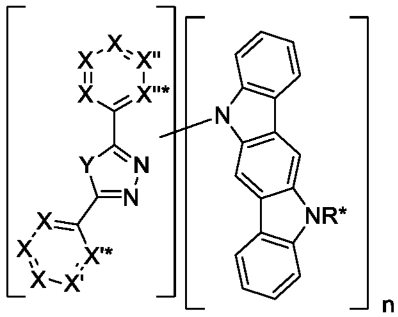

3-25

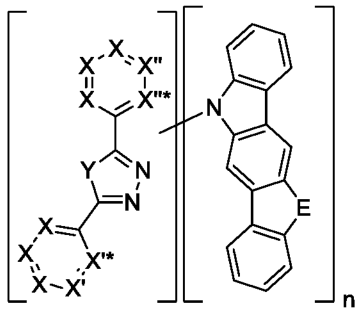

3-26

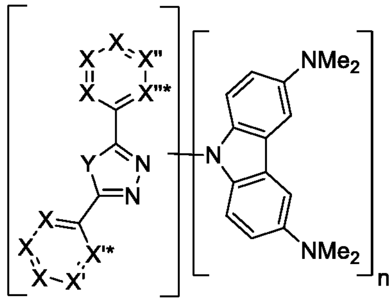

3-27

mit E = O, S, Se, $CR_2$
und wobei ansonsten die für Formel 1 angegebenen Definitionen gelten.

In einer Ausführungsführung haben die erfindungsgemäßen Moleküle eine Struktur der Formel 4a oder 4b:

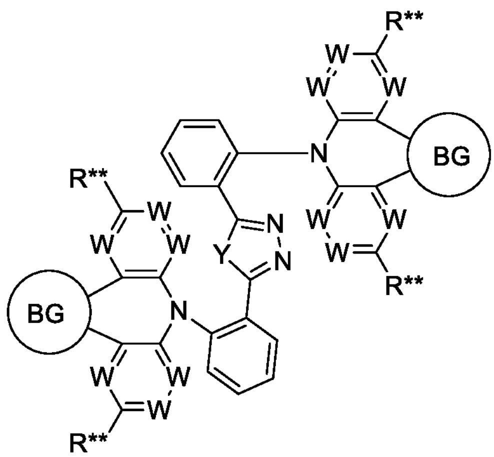

**Formel 4a**

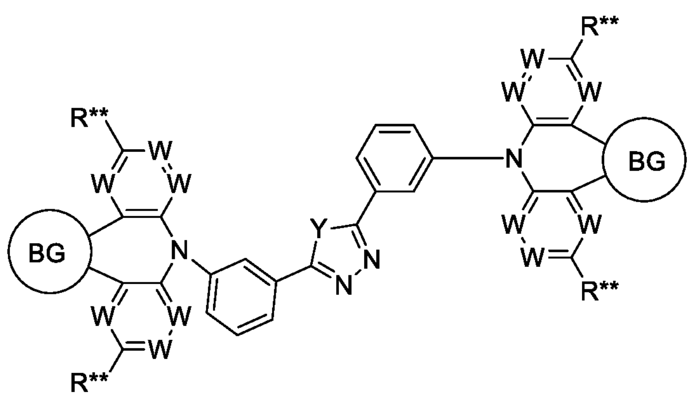

**Formel 4b**

wobei die optional vorhandene Brücke BG unabhängig voneinander ausgewählt ist aus einer Einfachbindung, $CR^*_2$, $CMe_2$, $CPh_2$, NPh, NMe, C=O, C=S, $SO_2$, O, S, $C_2H_4$, $C_2H_2$ oder 1,2-Phenylen;
und wobei bei Vorhandensein einer Einfachbindung als Brücke BG mindestens ein Rest R** ausgewählt ist aus einem elektronenreichen Rest wie Alkyl (linear, verzweigt oder cyclisch), Methoxy, Amin, Carbazol, Phenoxazin, Phenothiazin, Phenazin oder Acridin, um zu gewährleisten dass die HOMO-Energie des Moleküls größer als - 5.9 eV ist.

Auch wenn bei den Formeln 4a und 4b eine Brücke, BG eingezeichnet ist, so ist diese Brücke nur optional, also nur in bestimmten Ausführungsformen der organischen Moleküle vorhanden.

In einer Ausführungsführung haben die erfindungsgemäßen Moleküle eine Struktur der Formel 5a oder 5b:

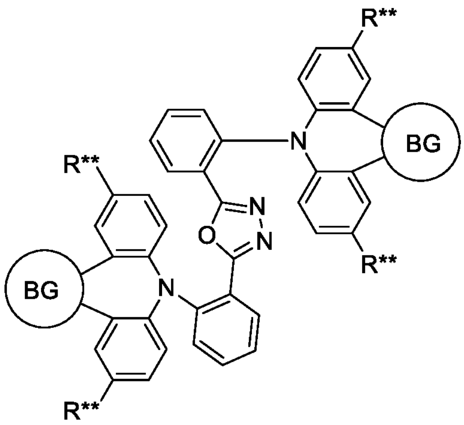

**Formel 5a**

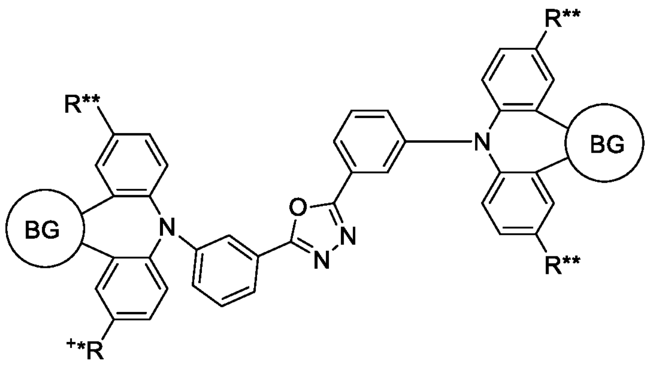

**Formel 5b**

wobei die für Formel 1 und Formel 4a und 4b angegebenen Definitionen gelten.

Auch wenn bei den Formeln 5a und 5b eine Brücke, BG eingezeichnet ist, so ist diese Brücke nur optional, also nur in bestimmten Ausführungsformen der organischen Moleküle vorhanden.

In einer Ausführungsführung haben die erfindungsgemäßen Moleküle eine Struktur der Formel 6a oder 6b:

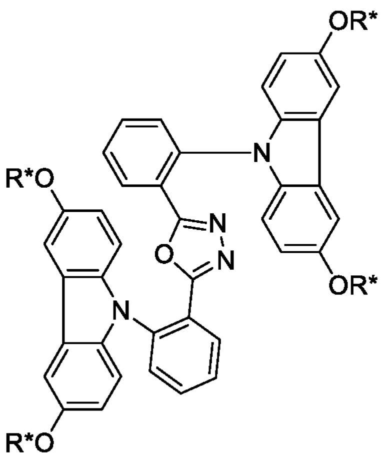

**Formel 6a**

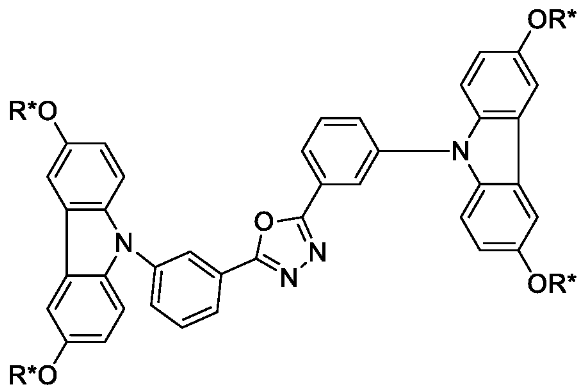

**Formel 6b**

wobei die für Formel 1 angegebenen Definitionen gelten und wobei R* insbesondere aber ein Alkylrest, wie Methyl ist.

In einer Ausführungsform werden an die chemisch substituierbaren Positionen der so erhaltenen organischen Moleküle weitere Reste R angefügt, insbesondere um die Löslichkeit der Emitter zu steigern und/oder die Polymerisierbarkeit zu ermöglichen, ohne dabei die elektronischen Eigenschaften des Moleküls signifikant zu verändern, sodass auch bei Verwendung von R ein Emitter vorliegt, wobei

jedes R ist bei jedem Auftreten unabhängig voneinander ausgewählt aus der Gruppe bestehend aus H, Deuterium, Phenyl, Naphthyl, F, Cl, Br, I, $N(R^2)_2$, -CN, -NC, -SCN, $-CF_3$,$-NO_2$, -OH, C(=O)OH, $C(=O)OR^3$, $C(=O)N(R^3)_2$, $C(=O)SR^3$, $C(=S)SR^3$, $Si(R^4)_3$, $B(OR^5)_2$, $B(N(R^6)_2)_2$, $C(=O)R^3$, $P(=O)(R^7)_2$, $As(=O)(R^7)_2$, $P(=S)(R^7)_2$, $As(=S)(R^7)_2$, $S(=O)R^3$, $S=NR^3$, $S(=O)NR^3$, $S(=O)_2NR^3$, $S(=O)_2R^3$, $O-S(=O)_2R^3$, $SF_5$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch-$R^9C=CR^9$-, -C≡C-, bzw. eine

benachbarte $CH_2$-Gruppe durch -Si($R^4$)$_2$-, -Ge($R^4$)$_2$-, -Sn($R^4$)$_2$,-C(=O)-, -C(=S)-, -C(=Se)-, -C=N-, -C(=O)O-, -C(=O)N($R^3$)-, -P(=O)($R^7$)-, -As(=O)($R^7$)-,-P(=S)($R^7$)-, -As(=S)($R^7$)-, -S(=O)-, -S(=O)$_2$-, -N$R^2$-, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden. In einer Ausführungsform ist das Ringsystem, das gebildet werden kann auf ein monozyklisches aliphatisches Ringsystem mit insgesamt fünf oder sechs Ringgliedern beschränkt.

$R^2$ ist bei jedem Auftreten unabhängig voneinander ausgewählt aus der Gruppe bestehend aus H, Deuterium, Phenyl, Naphthyl, $CF_3$, C(=O)O$R^3$, C(=O)N($R^2$)$_2$, Si($R^4$)$_3$, C(=O)$R^3$, P(=O)($R^7$)$_2$, As(=O)($R^7$)$_2$ P(=S)($R^7$)$_2$, As(=S)($R^7$)$_2$, S(=O)$R^3$, S(=O)$_2$$R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch -$R^9$C=C$R^9$-, -C≡C-, bzw. eine benachbarte $CH_2$-Gruppe durch -Si($R^4$)$_2$-,-Ge($R^4$)$_2$-, -Sn($R^4$)$_2$, -C(=O)-, -C(=S)-, -C(=Se)-, -C=N-, -C(=O)O-, -C(=O)N($R^3$)-, -P(=O)($R^7$)-,-As(=O)($R^7$)-, -P(=S)($R^7$)-, -As(=S)($R^7$)-, -S(=O)-, -S(=O)$_2$-, -N$R^2$-, -O-, oder -S-ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^2$ auch miteinander ein mono- oder polycyclisches, aliphatisches, aromatisches und/oder benzoannelliertes Ringsystem bilden.

$R^3$ ist bei jedem Auftreten unabhängig voneinander ausgewählt aus der Gruppe bestehend aus H, Deuterium, Phenyl, Naphthyl, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^3$ auch miteinander ein mono- oder polycyclisches, aliphatisches Ringsystem bilden.

$R^4$ ist bei jedem Auftreten unabhängig voneinander ausgewählt aus der Gruppe bestehend aus H, Deuterium, Phenyl, Naphthyl, N($R^2$)$_2$, CN, $CF_3$, OH, C(=O)O$R^3$, C(=O)N($R^3$)$_2$, C(=O)$R^3$, P(=O)($R^7$)$_2$, As(=O)($R^7$)$_2$, P(=S)($R^7$)$_2$, As(=S)($R^7$)$_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch-$R^9$C=C$R^9$-, -C≡C-, bzw. eine benachbarte $CH_2$-Gruppe durch -Si($R^4$)$_2$-, -Ge($R^4$)$_2$-, -Sn($R^4$)$_2$-,-C(=O)-, -C(=S)-, -C(=Se)-, -C=N-, -C(=O)O-, -C(=O)N($R^3$)-, -P(=O)($R^7$)-, -As(=O)($R^7$)-,-P(=S)($R^7$)-, -As(=S)($R^7$)-, -S(=O)-, -S(=O)$_2$-, -N$R^2$-, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^4$ auch miteinander ein mono- oder polycyclisches, aliphatisches, aromatisches und/oder benzoannelliertes Ringsystem bilden.

$R^5$ ist bei jedem Auftreten unabhängig voneinander ausgewählt aus der Gruppe bestehend aus Phenyl, Naphthyl, $CF_3$, C(=O)$R^3$, P(=O)($R^7$)$_2$, As(=O)($R^7$)$_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch-$R^9$C=C$R^9$-, -C≡C-, bzw. eine benachbarte $CH_2$-Gruppe durch -Si($R^4$)$_2$-, -Ge($R^4$)$_2$-, -Sn($R^4$)$_2$,-C(=O)-, -C(=S)-, -C(=Se)-, -C=N-, -C(=O)O-, -C(=O)N($R^3$)-, -P(=O)($R_7$)-, -As(=O)($R^7$)-,-P(=S)($R^7$)-, -As(=S)($R^7$)-, -S(=O)-, -S(=O)$_2$-, -N$R^2$-, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Sub-

stituenten $R^5$ auch miteinander ein mono- oder polycyclisches, aliphatisches, aromatisches und/oder benzoannelliertes Ringsystem bilden.

$R^6$ ist bei jedem Auftreten unabhängig voneinander ausgewählt aus der Gruppe bestehend aus Phenyl, Naphthyl, $CF_3$, $Si(R^4)_3$, $C(=O)R^3$, $P(=O)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch-$R^9C=CR^9$-, -C≡C-, bzw. eine benachbarte $CH_2$-Gruppe durch -$Si(R^4)_2$-, -$Ge(R^4)_2$-, -$Sn(R^4)_2$,-C(=O)-, -C(=S)-, -C(=Se)-, -C=N-, -C(=O)O-, -C(=O)N($R^3$)-, -P(=O)($R_7$)-, -As(=O)($R^7$)-,-P(=S)($R^7$)-, -As(=S)($R^7$)-, -S(=O)-, -$S(=O)_2$-, -$NR^2$-, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^6$ auch miteinander ein mono- oder polycyclisches, aliphatisches, aromatisches und/oder benzoannelliertes Ringsystem bilden.

$R^7$ ist bei jedem Auftreten unabhängig voneinander ausgewählt aus der Gruppe bestehend aus Phenyl, Naphthyl, $N(R^2)_2$, CN, $CF_3$, $C(=O)OR^3$, $C(=O)N(R^3)_2$, $Si(R^4)_3$, $C(=O)R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch -$R^9C=CR^9$-, -C≡C-, bzw. eine benachbarte $CH_2$-Gruppe durch -$Si(R^4)_2$-, -$Ge(R^4)_2$-, -$Sn(R^4)_2$, -C(=O)-, -C(=S)-, -C(=Se)-, -C=N-, -C(=O)O-,-C(=O)N($R^3$)-, -P(=O)($R_7$)-, -As(=O)($R^7$)-, -P(=S)($R^7$)-, -As(=S)($R^7$)-, -S(=O)-, -$S(=O)_2$-, -$NR^2$-,-O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^3$ substituiert sein kann, oder eine Kombination dieser Systeme; dabei können zwei oder mehrere dieser Substituenten $R^7$ auch miteinander ein mono- oder polycyclisches, aliphatisches, aromatisches und/oder benzoannelliertes Ringsystem bilden.

$R^8$ ist bei jedem Auftreten unabhängig voneinander ausgewählt aus der Gruppe bestehend aus H, Deuterium, Phenyl, Naphthyl, F, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^8$ auch miteinander ein mono- oder polycyclisches, aliphatisches Ringsystem bilden.

$R^9$ ist bei jedem Auftreten unabhängig voneinander ausgewählt aus der Gruppe bestehend aus H, Deuterium, Phenyl, Naphthyl, $N(R^2)_2$, CN, $CF_3$, $NO_2$, OH, COOH, $C(=O)OR^3$, $C(=O)N(R^3)_2$, $Si(R^4)_3$, $B(OR^5)_2$, $C(=O)R^3$, $P(=O)(R^7)_2$, $P(=S)(R^7)_2$, $As(=O)(R^7)_2$, $P(=S)(R^7)_2$, $S(=O)R^3$, $S(=O)_2R^3$, $OSO_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^8$ substituiert sein kann, wobei eine oder mehrere nicht benachbarte $CH_2$-Gruppen durch -$R^3C=CR^3$-, -C≡C-, bzw. eine benachbarte $CH_2$-Gruppe durch -$Si(R^4)_2$-, -$Ge(R^4)_2$-, -$Sn(R^4)_2$,-C(=O)-, -C(=S)-, -C(=Se)-,-C=N-, -C(=O)O-, -C(=O)N($R^3$)-, -P(=O)($R_7$)-, -As(=O)($R^7$)-, -P(=S)($R^7$)-, -As(=S)($R^7$)-, -S(=O)-, -$S(=O)_2$-, -$NR^2$-, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^3$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^8$ substituiert sein kann, oder eine Kombination dieser Systeme; dabei können zwei oder mehrere dieser Substituenten $R^9$ auch miteinander ein mono- oder polycyclisches, aliphatisches, aromatisches und/oder benzoannelliertes Ringsystem bilden.

Polymerisierbare Reste sind solche Reste, die polymerisierbare funktionelle Einheiten tragen, die mit sich selbst homopolymerisiert oder mit anderen Monomeren copolymiersiert werden können. Somit können die erfindungsgemäßen Moleküle als Polymer mit folgenden Wiederholungseinheiten der Formeln 7 und 8 erhalten werden, die als Polymere in der lichtemittierenden Schicht des optoelektronischen Bauelements Verwendung finden können.

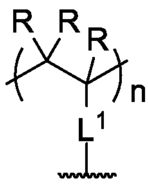
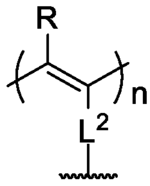

**Formel 7** **Formel 8**

In Formel 7 und 8 stehen L1 und L2 für gleiche oder verschiedene Linkergruppen, die 0 bis 20, insbesondere 1 bis 15, oder 2 bis 10 Kohlenstoffatome aufweisen, und wobei die gewellte Linie die Position kennzeichnet, über die die Linkergruppe an das organische Molekül der Formel 1 angebunden ist. In einer Ausführungsform weist die Linkergruppe L1 und/oder L2 eine Form -X-L3- auf, wobei X für O oder S steht und L3 für eine Linkergruppe ausgewählt aus der Gruppe aus einer substituierten und unsubstituierten Alkylengruppe (linear, verzweigt oder cyclisch) und einer substituierten und unsubstituierten Arylengruppe, insbesondere eine substituierte oder unsubstituierte Alkylengruppe mit 1 bis 10 Kohlenstoffatomen oder eine substituierte oder unsubstituierte Phenylengruppe, wobei auch Kombinationen möglich sind. In einer weiteren Ausführungsform weist die Linkergruppe L1 und/oder L2 eine Form -C(=O)O- auf.

Beispielhafte Ausführungsformen der Wiederholungseinheiten sind Strukturen der Formeln 9 bis 14:

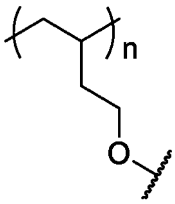
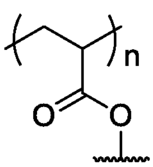
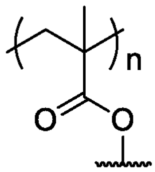
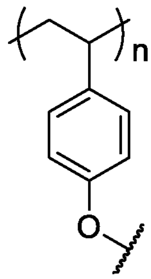
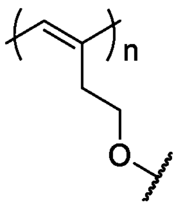
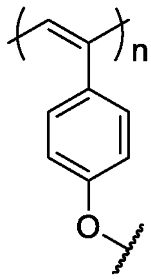

**Formel 9** **Formel 10** **Formel 11** **Formel 12** **Formel 13** **Formel 14**

Zur Herstellung der Polymere, die die Wiederholungseinheiten gemäß Formel 9 bis 14 aufweisen, werden die polymerisierbaren funktionellen Einheiten über eine Linkergruppe der Formeln 15 bis 20, die eine Hydroxyleinheit aufweisen, an das organische Molekül der Formel 1 angebunden und die daraus resultierenden Verbindungen mit sich selbst homopolymerisiert oder mit anderen geeigneten Monomeren copolymerisiert.

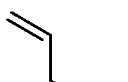
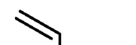
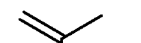
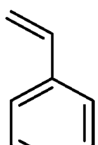
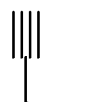
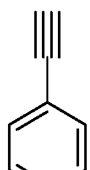

**Formel 15** **Formel 16** **Formel 17** **Formel 18** **Formel 19** **Formel 20**

Polymere, die eine Einheit gemäß Formel 7 oder Formel 8 aufweisen, können dabei entweder ausschließlich Wiederholungseinheiten mit einer Struktur der allgemeinen Formel 7 oder 8, oder Wiederholungseinheiten mit einer anderen Struktur aufweisen. Beispiele von Wiederholungseinheiten mit anderen Strukturen weisen Einheiten auf, die sich aus entsprechenden Monomeren ergeben, die typischerweise in Copolymerisationen eingesetzt oder verwendet werden. Beispiele für derartige Wiederholungseinheiten, die sich aus Monomeren ergeben, sind Wiederholungseinheiten, die ungesättigte Einheiten wie Ethylen oder Styrol aufweisen.

Eine Ausführungsform der Erfindung betrifft organischen Moleküle, welche

- einen $\Delta E(S_1-T_1)$-Wert zwischen dem untersten angeregten Singulett ($S_1$)- und dem darunter liegenden Triplett

($T_1$)-Zustand von kleiner als 0,2 eV, insbesondere kleiner als 0,1 eV aufweisen und/oder
- eine Emissionslebensdauer von höchstens 50 $\mu$s aufweisen.

Die Erfindung betrifft in einem Aspekt die Verwendung eines erfindungsgemäßen organischen Moleküls als lumineszierender Emitter und/oder als Hostmaterial und/oder als Elektronentransportmaterial und/oder als Lochinjektionsmaterial und/oder als Lochblockiermaterial in einem optoelektronischen Bauelement, das insbesondere durch ein Vakuumverdampfungsverfahren oder aus Lösung hergestellt wird, wobei das optoelektronische Bauelement insbesondere ausgewählt ist aus der Gruppe bestehend aus:

- organischen lichtemittierenden Dioden (OLEDs),
- lichtemittierenden elektrochemischen Zellen,
- OLED-Sensoren, insbesondere in nicht hermetisch nach außen abgeschirmten Gas- und Dampf-Sensoren,
- organischen Dioden
- organischen Solarzellen,
- organischen Transistoren,
- organischen Feldeffekttransistoren,
- organischen Lasern und
- Down-Konversions-Elementen.

Der Anteil des erfindungsgemäßen organischen Moleküls am lumineszierenden Emitter und/oder Hostmaterial und/oder Elektronentransportmaterial und/oder Lochinjektionsmaterial und/oder Lochblockiermaterial beträgt in einer Ausführungsform 1 % bis 99 % (Gew%), insbesondere beträgt der Anteil am Emitter in optischen Licht emittierenden Bauelementen, insbesondere in OLEDs, zwischen 5 % und 80 %.

Die Erfindung betrifft in einem weiteren Aspekt optoelektronische Bauelemente, aufweisend ein erfindungsgemäßes organisches Molekül, wobei das optoelektronische Bauelement insbesondere ausgeformt ist als ein Bauelement ausgewählt aus der Gruppe bestehend aus organischer lichtemittierender Diode (OLED), Licht-emittierender elektrochemischer Zelle, OLED-Sensor, insbesondere in nicht hermetisch nach außen abgeschirmten Gas- und Dampf-Sensoren, organischer Diode, organischer Solarzelle, organischem Transistor, organischem Feldeffekttransistor, organischem Laser und Down-Konversion-Element.

Eine Ausführungsform betrifft das erfindungsgemäße optoelektronische Bauelement aufweisend ein Substrat, eine Anode und eine Kathode, wobei die Anode und die Kathode auf das Substrat aufgebracht sind, und mindestens eine lichtemittierende Schicht, welche zwischen Anode und Kathode angeordnet ist und die ein erfindungsgemäßes organisches Molekül enthält.

In einer weiteren Ausführungsform des Bauelements wird das organische Molekül als Emissionsmaterial in einer Emissionsschicht eingesetzt, wobei sie in Kombination mit mindestens einem Hostmaterial oder insbesondere als Reinschicht eingesetzt werden kann. In einer Ausführungsform beträgt dabei der Anteil des organischen Moleküls als Emissionsmaterial in einer Emissionsschicht in optischen Licht-emittierenden Bauelementen, insbesondere in OLEDs, zwischen 5 % und 80 % (Gew%).

In einer weiteren Ausführungsform des erfindungsgemäßen Bauelements ist die ein erfindungsgemäßes organisches Molekül aufweisende lichtemittierende Schicht auf ein Substrat aufgebracht.

In einer Ausführungsform betrifft die Erfindung ein optoelektronisches Bauelement, bei dem die lichtemittierende Schicht ausschließlich ein erfindungsgemäßes organisches Molekül in 100% Konzentration aufweist, wobei die Anode und die Kathode auf das Substrat aufgebracht ist, und die lichtemittierende Schicht zwischen Anode und Kathode aufgebracht ist.

In einer weiteren Ausführungsform weist das optoelektronische Bauelement neben dem erfindungsgemäßen organischen Molekül mindestens ein Hostmaterial auf, wobei insbesondere der angeregte Singulettzustand ($S_1$) und/oder der angeregte Triplettzustand ($T_1$) des mindestens einen Hostmaterials höher ist als der angeregte Singulettzustand ($S_1$) und/oder der angeregte Triplettzustand ($T_1$) des organischen Moleküls, und wobei die Anode und die Kathode auf das Substrat aufgebracht ist, und die lichtemittierende Schicht zwischen Anode und Kathode aufgebracht ist.

In einer weiteren Ausführungsform weist das optoelektronische Bauelement ein Substrat, eine Anode, eine Kathode und mindestens je eine löcherinjizierende und eine elektroneninjizierende Schicht und mindestens eine lichtemittierende Schicht auf, wobei die mindestens eine lichtemittierende Schicht ein erfindungsgemäßes organisches Molekül und ein Hostmaterial aufweist, dessen Triplett ($T_1$)- und Singulett ($S_1$)-Energieniveaus energetisch höher liegen als die Triplett ($T_1$)- und Singulett ($S_1$)-Energieniveaus des organischen Moleküls, und wobei die Anode und die Kathode auf das Substrat aufgebracht ist, und die löcher- und elektroneninjizierende Schicht zwischen Anode und Kathode aufgebracht ist und die lichtemittierende Schicht zwischen löcher- und elektroneninjizierende Schicht aufgebracht ist.

In einer weiteren Ausführungsform weist das optoelektronische Bauelement ein Substrat, eine Anode, eine Kathode und mindestens je eine löcherinjizierende und eine elektroneninjizierende Schicht, und mindestens je eine

löchertransportierende und eine elektronentransportierende Schicht, und mindestens eine lichtemittierende Schicht auf, wobei die mindestens eine lichtemittierende Schicht ein erfindungsgemäßes organisches Molekül sowie ein Hostmaterial aufweist, dessen Triplett ($T_1$)- und Singulett ($S_1$)-Energieniveaus energetisch höher liegen als die Triplett ($T_1$)- und Singulett ($S_1$)-Energieniveaus des organischen Moleküls, und wobei die Anode und die Kathode auf das Substrat aufgebracht ist, und die löcher- und elektroneninjizierende Schicht zwischen Anode und Kathode aufgebracht ist, und die löcher- und elektronentransportierende Schicht zwischen löcher- und elektroneninjizierende Schicht aufgebracht ist, und die lichtemittierende Schicht zwischen löcher- und elektronentransportierende Schicht aufgebracht ist.

In einer weiteren Ausführungsform weist das optoelektronische Bauelement mindestens ein Hostmaterial aus einem Material gemäß Formel 1 auf.

In einer weiteren Ausführungsform des optoelektronischen Bauelements beinhaltet die lichtemittierende Schicht fluoreszente oder phosphoreszente Materialien, welche eine Struktur der Formel 1 aufweisen.

In einer weiteren Ausführungsform des optoelektronischen Bauelements bilden ein organisches Molekül gemäß Formel 1 und ein funktionelles Material, beispielsweise in Form eines weiteren Emitter-Materials, eines Host-Materials, oder eines weiteren organisches Moleküls, welches zur Bildung eines Exciplex mit dem Molekül gemäß Formel 1 befähigt ist, einen Exciplex. Funktionelle Materialien sind beispielsweise Hostmaterialien wie MCP, Elektronentransportmaterialien wie TPBI und Lochtransportmaterialien wie NPD oder MTDATA. Exciplexe sind Addukte aus elektronisch angeregten Molekülen und solchen im elektronischen Grundzustand, die zur Lichtemission fähig sind.

In einer weiteren Ausführungsform des optoelektronischen Bauelements ist die Emission durch thermisch aktivierte verzögerte Fluoreszenz (TADF) charakterisiert.

In einer weiteren Ausführungsform des optoelektronischen Bauelements werden organische Moleküle gemäß Formel 1 als Ladungstransportschicht verwendet.

Die Erfindung betrifft in einem Aspekt ein lichtemittierendes Material, aufweisend ein erfindungsgemäßes organisches Molekül und ein Hostmaterial, wobei die Triplett ($T_1$)- und Singulett ($S_1$)-Energieniveaus des Hostmaterials energetisch höher liegen als die Triplett ($T_1$)- und Singulett ($S_1$)-Energieniveaus des organischen Moleküls, und wobei das organische Molekül Fluoreszenz oder thermisch aktivierte verzögerte Fluoreszenz (TADF) emittiert, und einen $\Delta E(S_1\text{-}T_1)$-Wert zwischen dem untersten angeregten Singulett ($S_1$)- und dem darunter liegenden Triplett ($T_1$)-Zustand von kleiner als 0,2 eV, insbesondere kleiner als 0,1 eV aufweist.

Ein Aspekt der Erfindung betrifft ein Verfahren zur Herstellung eines optoelektronischen Bauelements aufweisend ein erfindungsgemäßes organisches Molekül. In einer Ausführungsform weist das Verfahren die Verarbeitung des organischen Moleküls mittels eines Vakuumverdampfungsverfahrens oder aus einer Lösung auf.

In einer Ausführungsform weist das Verfahren das Aufbringen des organischen Moleküls auf einen Träger auf, wobei das Aufbringen insbesondere nass-chemisch, mittels kolloidaler Suspension oder mittels Sublimation erfolgt.

In einer weiteren Ausführungsform des Verfahrens wird mindestens eine Schicht

- mit einem Sublimationsverfahren beschichtet
- mit einem OVPD (Organic Vapor Phase Deposition) Verfahren beschichtet
- mit Hilfe einer Trägergassublimation beschichtet oder
- aus Lösung oder mit einem beliebigen Druckverfahren hergestellt.

Ein Aspekt der Erfindung betrifft ein Verfahren zur Veränderung der Emissions- und/oder Absorptionseigenschaften eines elektronischen Bauelements, wobei ein erfindungsgemäßes organisches Molekül in ein Matrixmaterial zur Leitung von Elektronen oder Löchern in einem optoelektronischen Bauelement eingebracht wird.

Die Erfindung betrifft zudem in einem weiteren Aspekt die Verwendung eines erfindungsgemäßen Moleküls zur Umwandlung von UV-Strahlung oder von blauem Licht in sichtbares Licht, insbesondere in grünes, gelbes oder rotes Licht (Down-Konversion), insbesondere in einem optoelektronischen Bauelement der hier beschriebenen Art.

In einem weiteren Aspekt betrifft die Erfindung eine Anwendung, in der mindestens ein Material mit einer Struktur gemäß Formel 1, durch äußere energetische Anregung zum Leuchten angeregt wird. Die äußere Anregung kann elektronisch oder optisch oder radioaktiv sein.

Insbesondere die verwendeten elektronenreichen Donorreste A unterscheiden die organischen Moleküle funktionell von Molekülen gemäß dem Stand der Technik. Verwendet werden solche Azole, die mindestens an einem der beiden Aryl-Ringe jeweils mit einem elektronenreichen Rest funktionalisiert wurden. Durch die Anknüpfung über den Stickstoff stehen der Donor und das Azol nicht mehr in direkter Konjugation zueinander. Die Grenzorbitale HOMO und LUMO sind in der Folge auf unterschiedlichen Molekülteilen lokalisiert. Eine Trennung der konjugierten Systeme fand im Stand der Technik nicht statt, insbesondere in Verbindung mit der hier beschriebenen Lokalisierung von HOMO und LUMO auf getrennten Molekülteilen.

Durch das erfindungsgemäße Anknüpfungsmuster wird infolge von sterischer Überfrachtung eine Verdrillung und somit Trennung von Donor und Akzeptor erreicht. Dies führt zu vergleichsweise niedrigen Werten für $\Delta E(S1\text{-}T1)$ und infolgedessen zu kurzen Emissionsabklingdauern von weniger als 200 $\mu$s. Nach dem Stand der Technik weisen

andere Carbazol-basierte TADF-Emitter Emissionsabklingdauern von 2000 μs und mehr auf, was sie für eine Anwendung in OLEDs unattraktiv macht.

Keines dieser Beispiele ist ein OLED-Leuchtstoff, da die Emission all dieser Moleküle im nicht-sichtbaren UV-Bereich liegt. Erst durch die in den Formeln 3-1 bis 3-27 gezeigten Reste werden Moleküle zugänglich, die im für den Menschen sichtbaren Bereich emittieren. Funktionell zeichnen sich alle diese Reste dadurch aus, dass die HOMO Energie um mindestens 100 meV über der HOMO-Energie von Carbazol liegt. Die HOMO-Energie kann beispielsweise durch DFT-Calculation oder Cyclovoltammetrie oder Techniken wie Photoelektronenspektroskopie bestimmt werden.

Das oben beschriebene, überraschend gefundene Anknüpfungsmuster weist gegenüber dem Stand der Technik entscheidende Vorteile auf. So wurden beispielsweise im Stand der Technik (Nature Photonics 2014, 8, 326-332) die beiden Moleküle PPZ-4TPT und PPZ-3TPT offenbart:

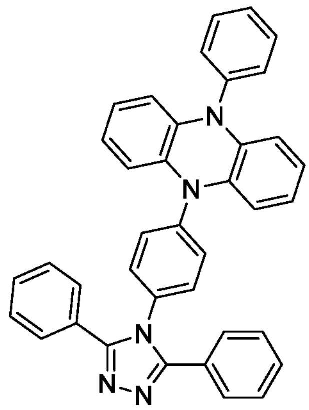

PPZ-4TPT

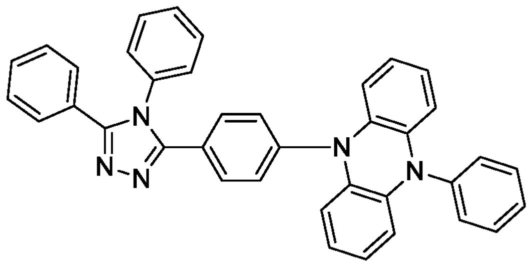

PPZ-3TPT

Die beiden Moleküle weisen mit Emissionsabklingdauern von 28 bzw 5 Millisekunden um mehrere Größenordnungen zu hohe Lebensdauer des angeregten Zustandes auf. Durch die Substitution der erfindungsgemäßen Moleküle werden deutlich geringerer Emissionsabklingdauern von unter einer 1 Millisekunde möglich. Infolge der langen Abklingdauer von PPZ-4TPT und PPZ-3TPT kommt es bei hohen Stromstärken schnell zu Sättigungseffekten, was die Bauteillebensdauer negativ beeinflusst und die Erreichung hoher Helligkeiten verhindert. Die lange Emissionsabklingdauer wird durch eine große Energiedifferenz zwischen dem ersten angeregten Singulett-Zustand und dem niedrigsten Triplett-Zustand hervorgerufen, da die elektronischen Wechselwirkungen über konjugierte Bindungen zwischen Donor und Akzeptor zu groß sind. Bei den erfindungsgemäßen Molekülen wird diese Art der Wechselwirkung durch eine geeignete Wahl des Substitutionsmusters reduziert, so dass in der Folge die Emissionsabklingdauer sinkt. Neben der Größe der Energiedifferenz zwischen dem ersten angeregten Singulett-Zustand und dem niedrigsten Triplett-Zustand wirkt sich die Oszillatorstärke auf die Emissionsabklingdauer aus.

Das Substitutionsmuster der erfindungsgemäßen Moleküle erfüllt dabei insbesondere drei wesentliche funktionelle Merkmale:

- Die HOMO-Energie der Moleküle nach Formel 1 ist um mindestens 100 meV höher als die HOMO-Energie von unsubstituierten Carbazolen ($E_{HOMO}$> -5.9 eV). Dies wird durch die in Formel 1a beschriebenen Einheiten realisiert, die maßgeblich das HOMO des Gesamtmoleküls definieren.
- Durch Unterbrechung der Konjugation durch Anbindung der Einheit aus Formel 1a über ein Stickstoffatom sind die Grenzorbitale prinzipiell auf unterschiedlichen Molekülteilen lokalisiert. Das HOMO ist dabei auf den Einheiten nach Formel 1a lokalisiert.
- Es besteht im gezeigten Anknüpfungsmuster eine minimale Überlappung zwischen HOMO und LUMO. Dies äußert sich durch eine Oszillatorstärke des Übergangs von S1 nach S0 von größer als 0. Die Oszillatorstärke lässt sich spektroskopisch durch UVVIS-Spektroskopie oder quantenchemisch durch DFT-Kalkulation berechnen, was dem Fachmann bekannt ist.

Die erfindungsgemäßen Moleküle weisen durch die benannten Vorteile gegenüber dem Stand der Technik Vorteile auf, wie eine Emissionsabklingdauer von weniger als 100 μs und einer Emissionsquanteneffizienz von mehr als 40 % (siehe Beispiele).

Dadurch lassen sich insbesondere tiefblaue OLED-Leuchtstoffe mit einem Emissionsmaximum von weniger

als 470 nm bereitstellen.

Beispiele

Beispiel 1: Synthese und physikalische Eigenschaften von Molekül 1

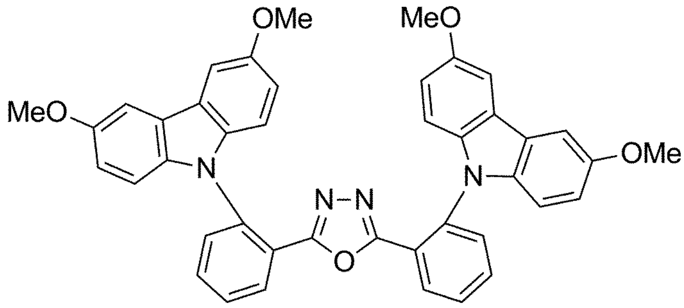

Molekül 1 lässt sich über dem Fachmann bekannte Standardtransformationen herstellen, beispielsweise über ein Cu(I)-katalysierte Ullmann-Reaktion aus dem 2,2'-Diiodphenyltriazol mit Dimethoxycarbazol. Analog können weitere Brom- oder Iod-substituierte Azol-Einheiten mit NH-Donoren wie Carbazol, Phenoxazin, Phenothiazin usw umgesetzt werden. Typischerweise werden dazu Kupfer-Katalysatoren wie CuI, Liganden wie Phenanthrolin oder trans-DACH und Basen wie Kaliumphosphat oder Kaliumcarbonatin Lösungsmitteln wie Dioxan eingesetzt. Typische Reaktionsbedingungen waren dabei Erhitzen am Rückfluss, Ausfällen aus Wasser und Aufreinigung mittels Flash-Chromatografie in Essigester/Cyclohexan.

Weitere erfindungsgemäße Beispiele lassen sich durch nukleophile aromatische Substitution herstellen. Dabei wird ein Fluor-substituiertes Azol mit NH-Donoren umgesetzt. Zusätzlich werden 2 Äquivalente einer Base wie Natriumhydrid oder Kaliumphosphat verwendet.

Das Emissionsmaximum der Verbindung beträgt 475 nm. Die Quanteneffizienz (bestimmt nach Volz et al., Chem Mater. 2013, 25 (17), 3414-3426) beträgt 47 %. Die Emissionsabklingdauer (bestimmt nach Chem Mater. 2013, 25 (17), 3414-3426) beträgt 30 µs. Die Emissionsabklingdauer von vergleichbaren Verbindungen mit höherer Wellenlänge ist dabei oft um Größenordnungen höher, beispielsweise im Bereich von Millisekunden.

**Beispiel 2: DFT-Rechnung**

Durch DFT-Rechnungen (durchgeführt mit Turbomole, Funktional: BP86) lässt sich der besondere Einfluss der erfindungsgemäßen Substitution verdeutlichen.

So liegen die Grenzorbitale HOMO und LUMO beim erfindungsgemäßen Molekül 1 getrennt vor, wobei ein minimaler Überlapp besteht (siehe Figur 3).

Die berechnete Oszillatorstärke OS (T1) beträgt 0,6389. Der Energieunterschied zwischen S1 und T1 beträgt 0,05 eV.

Ohne die erzwungene Verdrillung der in Formel 1a definierten Donoreinheit relativ zur Akzeptoreinheit AF wäre die Trennung von HOMO und LUMO nicht ausgeprägt genug, sodass der Energieunterschied zwischen S1 und T1 zu groß ausfällt. In diesem Fall sind, wie beispielsweise von Yersin et al in J. Am. Chem. Soc. 2014, 136 (45), 16032-16038 dargelegt wurde, die TADF-Eigenschaften nur schlecht ausgeprägt.

**Beispiel 3 bis 60: Weitere DFT-Rechnungen von erfindungsgemäßen Molekülen**

Die hier gezeigten Moleküle wurden mit den in Beispiel 1 offenbarten Verfahren hergestellt. Die DFT-Berechnung wurde analog zu Beispiel 2 durchgeführt. Gezeigt ist der Energieunterschied zwischen S1 und T1 die Energien. Die Orbitalverteilung von HOMO und LUMO bei den Molekülen der Beispiele 3 bis 60 ist in Figur 4 gezeigt.

| Struktur des erfindungsgemäßen Moleküls | $E_{HOMO}$ | $E_{LUMO}$ | ΔE |
|---|---|---|---|
| 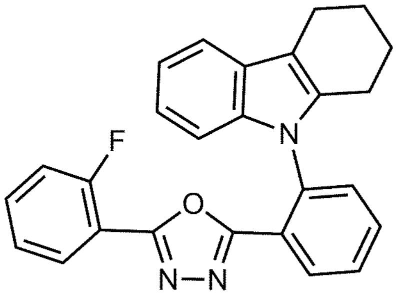 | -4.71342 eV | -2.74583 eV | 0.083eV |
| 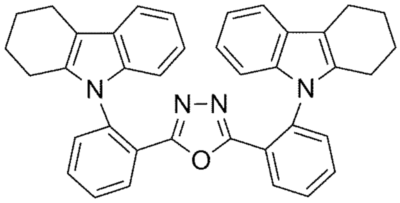 | -4.8199 eV | -2.4762 eV | 0.214eV |
| 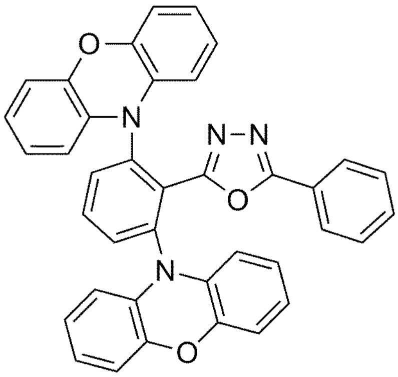 | -4.245 eV | -2.8822 eV | 0.030eV |
| 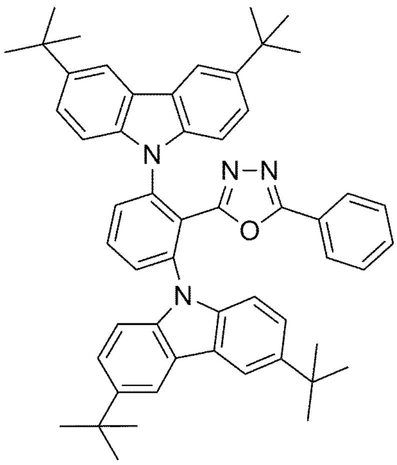 | -4.8359 eV | -2.6479 eV | 0.165eV |
| 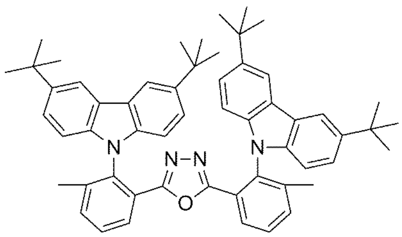 | -4.6487 eV | -2.7861 eV | 0.033eV |

(fortgesetzt)

| Struktur des erfindungsgemäßen Moleküls | $E_{HOMO}$ | $E_{LUMO}$ | ∆E |
|---|---|---|---|
| 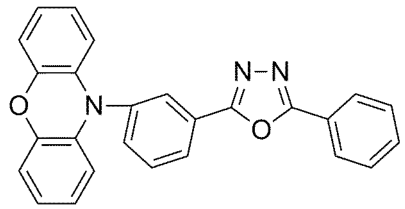 | -4.2911 eV | -2.9073 eV | 0.024eV |
| 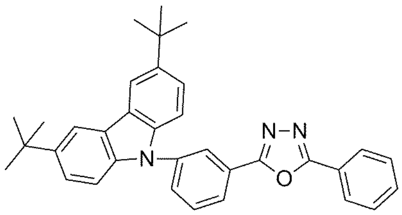 | -4.9749 eV | -2.7956 eV | 0.369eV |
| 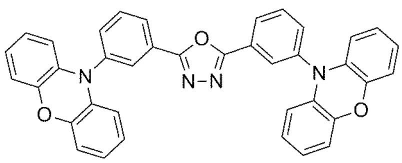 | -4.3333 eV | -3.0953 eV | 0.019eV |
| 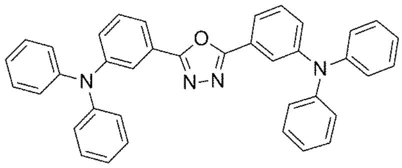 | -4.7699 eV | -2.601 eV | 0.504eV |
| 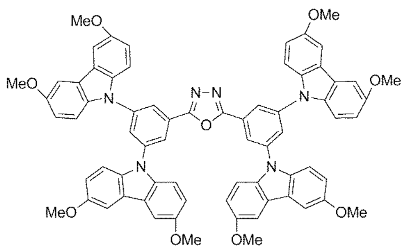 | -4.538 eV | -2.9251 eV | 0.118eV |
| 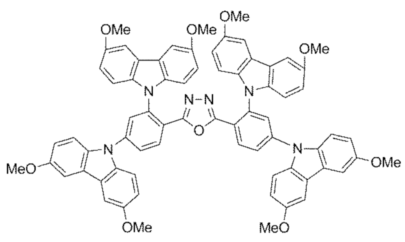 | -4.2925 eV | -2.7541 eV | eV |

(fortgesetzt)

| Struktur des erfindungsgemäßen Moleküls | $E_{HOMO}$ | $E_{LUMO}$ | ΔE |
|---|---|---|---|
| 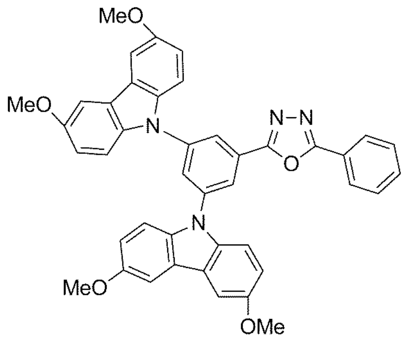 | -4.5477 eV | -2.8266 eV | 0.130eV |
| 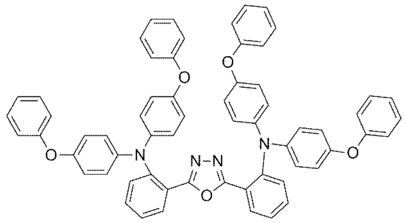 | -4.4986 eV | -2.7379 eV | 0.225eV |
| 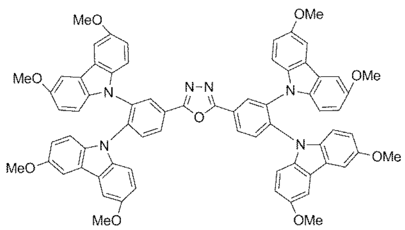 | -4.5482 eV | -2.8098 eV | 0.268eV |
| 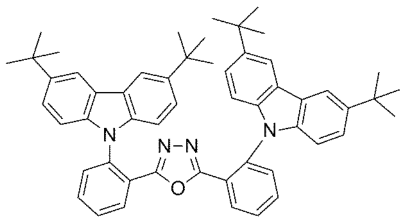 | -4.6836 eV | -2.895 eV | 0.037eV |
| 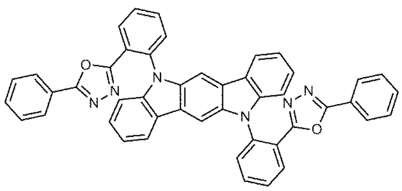 | -4.774 eV | -2.8051 eV | 0.109eV |
| 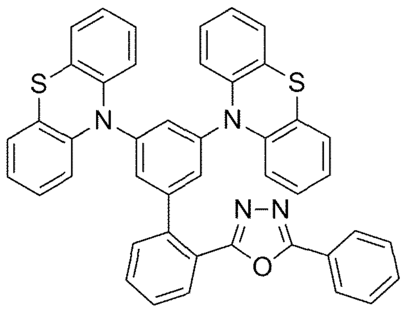 | -4.4495 eV | -2.4827 eV | 0.163eV |

(fortgesetzt)

| Struktur des erfindungsgemäßen Moleküls | $E_{HOMO}$ | $E_{LUMO}$ | ΔE |
|---|---|---|---|
| 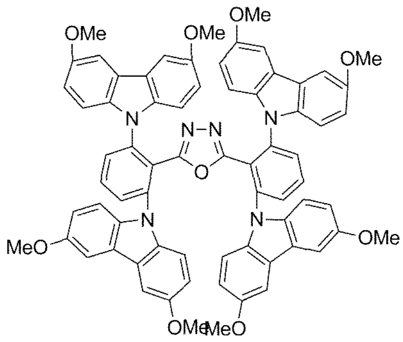 | -4.2638 eV | -2.4871 eV | 0.038eV |
| 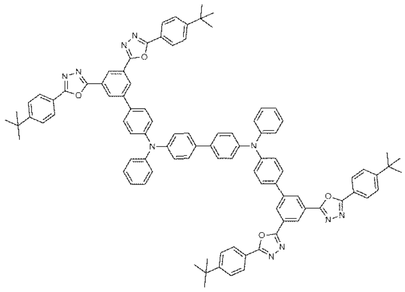 | -4.5361 eV | -2.7738 eV | 0.266eV |
| 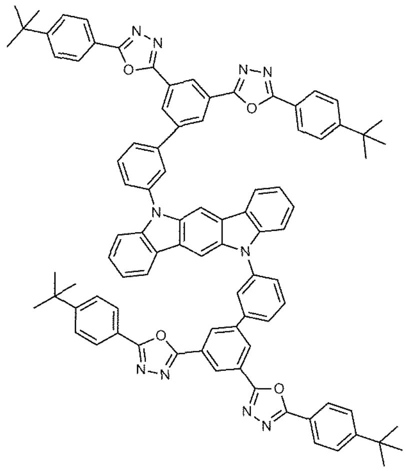 | -4.5027 eV | -2.8467 eV | 0.060eV |
| 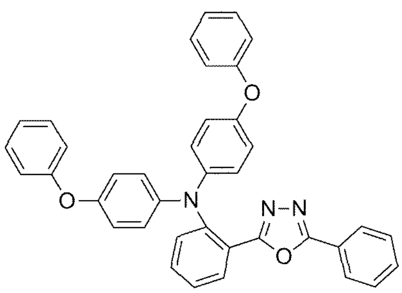 | -4.653 eV | -2.6059 eV | 0.279eV |
| 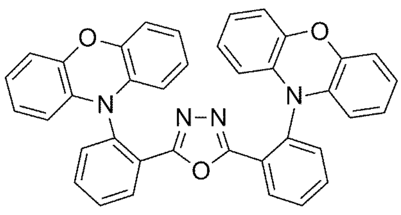 | -4.0657 eV | -2.9959 eV | 0.008eV |

(fortgesetzt)

| Struktur des erfindungsgemäßen Moleküls | $E_{HOMO}$ | $E_{LUMO}$ | ΔE |
|---|---|---|---|
| 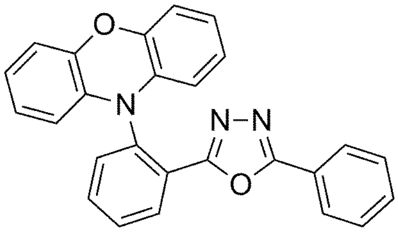 | -4.4041 eV | -2.8267 eV | 0.011eV |
| 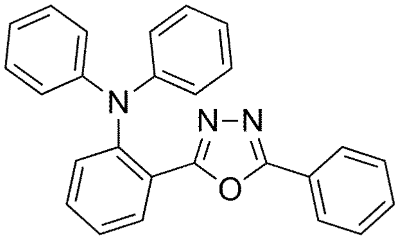 | -4.6546 eV | -2.6126 eV | 0.320eV |
| 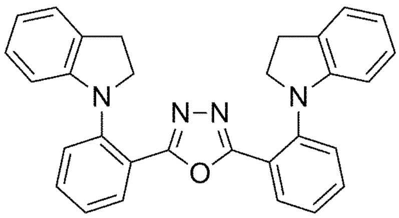 | -4.5156 eV | -2.4313 eV | 0.442eV |
| 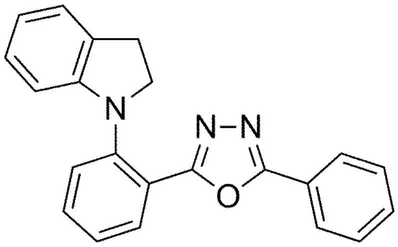 | -4.7665 eV | -2.4997 eV | 0.420eV |
| 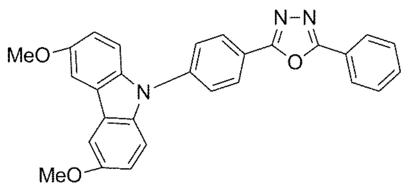 | -4.6284 eV | -2.7022 eV | 0.412eV |
| 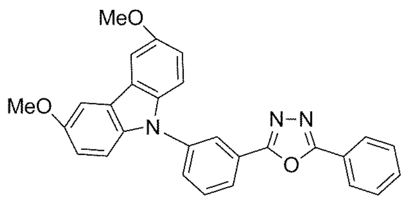 | -4.4836 eV | -2.7592 eV | 0.148eV |
| 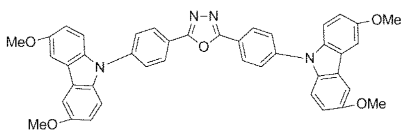 | -4.5872 eV | -2.7244 eV | 0.394eV |

(fortgesetzt)

| Struktur des erfindungsgemäßen Moleküls | $E_{HOMO}$ | $E_{LUMO}$ | ΔE |
|---|---|---|---|
| 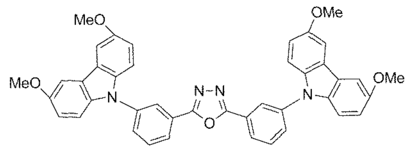 | -4.5445 eV | -2.8394 eV | 0.149eV |
| 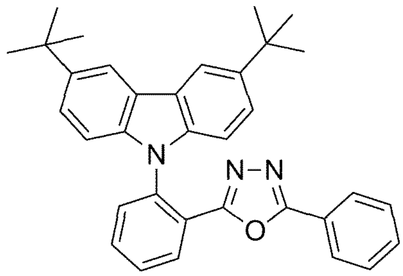 | -4.7455 eV | -2.7916 eV | 0.138eV |
| 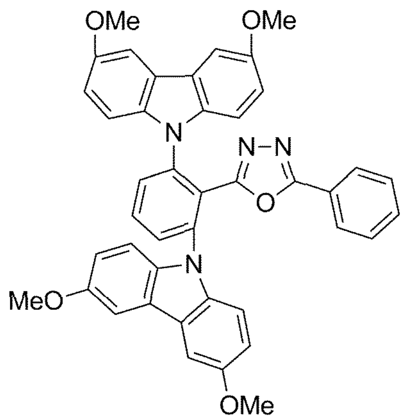 | -4.4375 eV | -2.55 eV | 0.105eV |
| 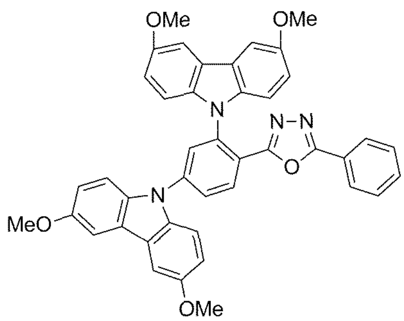 | -4.5734 eV | -2.6986 eV | 0.219eV |
| 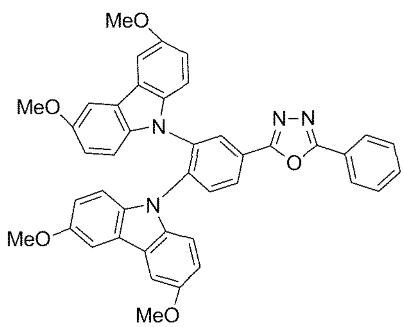 | -4.4578 eV | -2.7693 eV | 0.214eV |

(fortgesetzt)

| Struktur des erfindungsgemäßen Moleküls | $E_{HOMO}$ | $E_{LUMO}$ | ΔE |
|---|---|---|---|
| 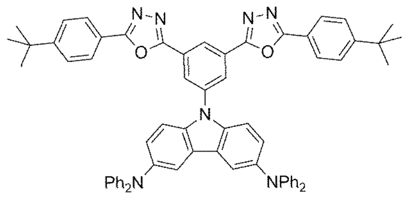 | -4.3601 eV | -2.9885 eV | 0.047eV |
| 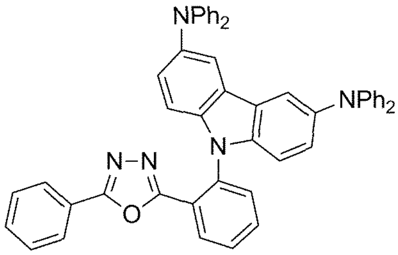 | -4.202 eV | -2.9321 eV | 0.029eV |
| 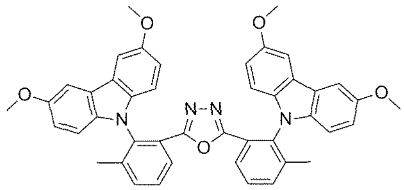 | -4.2598 eV | -2.7512 eV | 0.034eV |
| 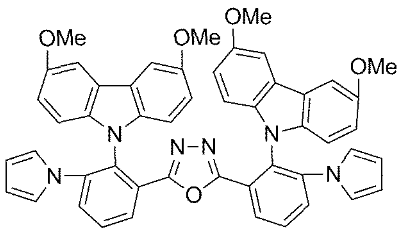 | -4.4366 eV | -2.5657 eV | 0.088eV |
| 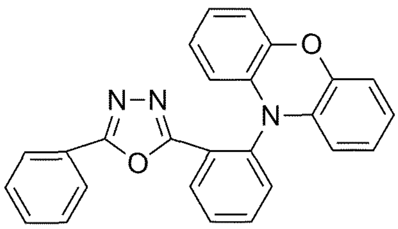 | -4.088 eV | -2.8897 eV | 0.011eV |
| 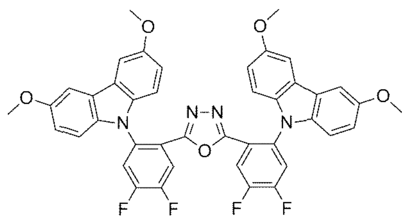 | -4.4543 eV | -2.9469 eV | 0.083eV |
| 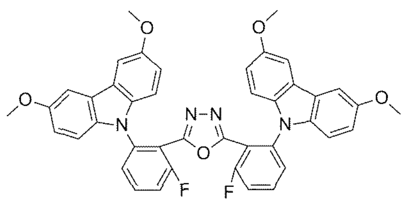 | -4.3502 eV | -2.68 eV | 0.132eV |

(fortgesetzt)

| Struktur des erfindungsgemäßen Moleküls | $E_{HOMO}$ | $E_{LUMO}$ | ΔE |
|---|---|---|---|
| 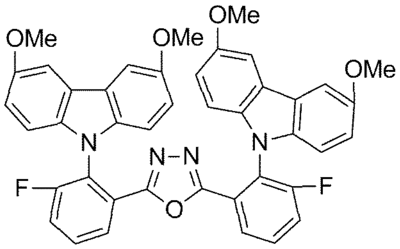 | -4.3513 eV | -2.956 eV | 0.067eV |
| 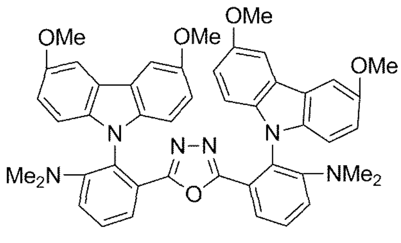 | -4.1591 eV | -2.4581 eV | 0.060eV |
| 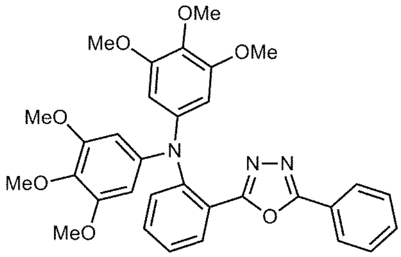 | -4.3317 eV | -2.5335 eV | 0.260eV |
| 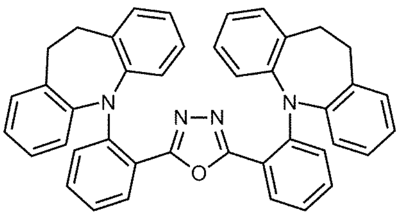 | -4.7308 eV | -2.0858 eV | 0.635eV |
| 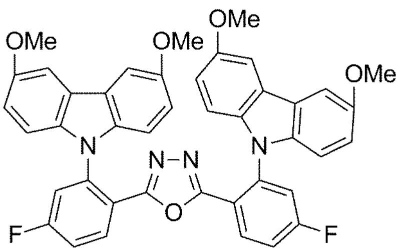 | -4.4612 eV | -2.7721 eV | 0.104eV |
| 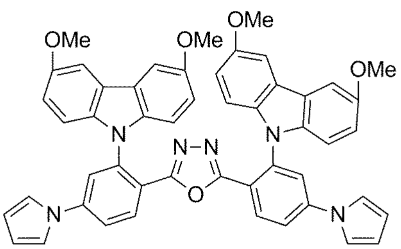 | -4.6148 eV | -2.5811 eV | 0.145eV |

(fortgesetzt)

| Struktur des erfindungsgemäßen Moleküls | $E_{HOMO}$ | $E_{LUMO}$ | ΔE |
|---|---|---|---|
| 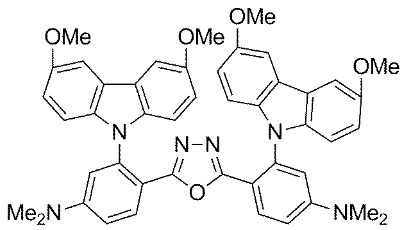 | -4.0664 eV | -2.0458 eV | 0.315eV |
| 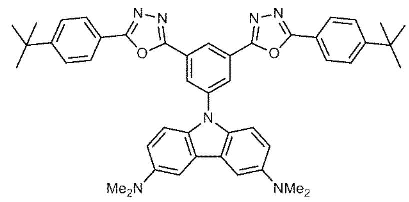 | -3.9904 eV | -2.7447 eV | 0.091eV |
| 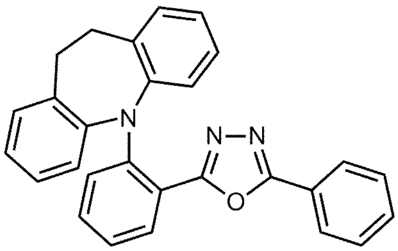 | -4.8305 eV | -2.4034 eV | 0.568eV |
| 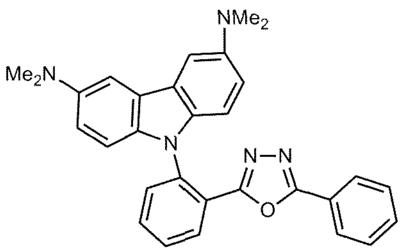 | -3.9461 eV | -2.4952 eV | 0.085eV |
| 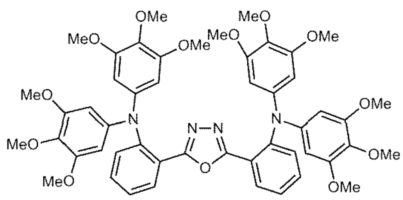 | -4.155 eV | -2.4374 eV | 0.222eV |
| 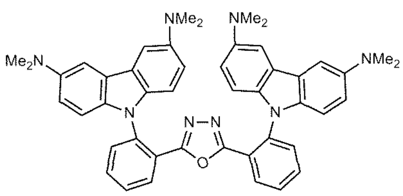 | -3.6672 eV | -2.4186 eV | 0.075eV |

(fortgesetzt)

| Struktur des erfindungsgemäßen Moleküls | $E_{HOMO}$ | $E_{LUMO}$ | ΔE |
|---|---|---|---|
| 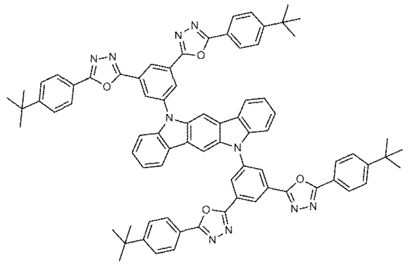 | -4.8223 eV | -2.9977 eV | 0.125eV |
| 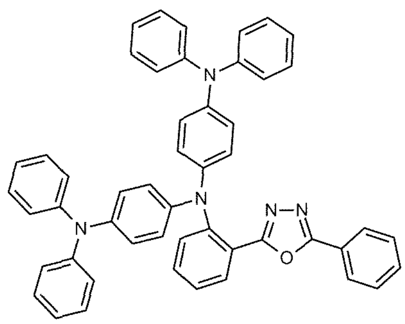 | -4.182 eV | -2.6449 eV | 0.157eV |
| 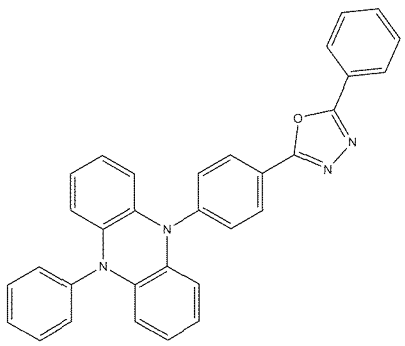 | -3.8771 eV | -2.8158 eV | 0.029eV |
| 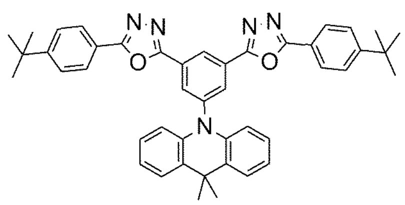 | -4.9779 eV | -2.6822 eV | 0.559eV |
| 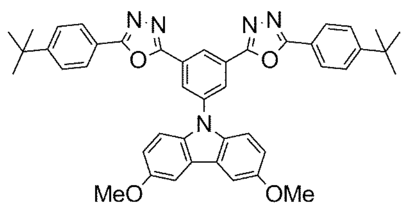 | -4.5533 eV | -2.8912 eV | 0.120eV |

**Beispiel 61 bis 71: Photophysikalische Eigenschaften erfindungsgemäßer Moleküle**

**Photophysikalische Messungen**

*Vorbehandlung von optischen Gläsern*

Alle Gläser (Küvetten und Substrate aus Quarzglas, Durchmesser: 1cm) wurden nach jeder Benutzung gereinigt: Je dreimaliges Spülen mit Dichlormethan, Aceton, Ethanol, demineralisiertem Wasser, Einlegen in 5% Hellmanex-Lösung für 24h, gründliches Ausspülen mit demineralisiertem Wasser. Zum Trocknen wurden die optischen Gläser mit Stickstoff abgeblasen.

***Probenvorbereitung: Lösungen***

1-2 mg der Probe wurden in 100 ml des jeweiligen Lösemittels gelöst, Konzentration $10^{-5}$ mol/L. Die Küvette wurde luftdicht verschlossen und 10 min. entgast.

***Probenvorbereitung, Film: Spin-Coating*** *(*Gerät: Spin150, SPS euro.)

Die Probenkonzentration entsprach 10mg/ml, angesetzt in Toluol oder Chlorbenzol.

Programm: 1) 3 s bei 400 U/min; 2) 20 Sek. bei 1000 U/min bei 1000 Upm/ s. 3) 10s bei 4000 U/min bei 1000 Upm/ s. Die Filme wurden nach dem Beschichten für 1 min bei 70 °C an Luft auf einer Präzisionsheizplatte von LHG getrocknet.

UV-VIS-Spektren wurden auf einem Gerät der Firma Thermo Scientific, Modell Evolution 201 aufgenommen. (Siehe Probenvorbereitung, Film: Spin-Coating)

***Photolumineszenzspektroskopie und TCSPC***

Steady-state Emissionsspektroskopie wurde mit einem Fluoreszenzspektrometer der Firma Horiba Scientific, Modell FluoroMax-4 durchgeführt, ausgestattet mit einer 150 W Xenon-Arc Lampe, Anregungs- und Emissionsmonochromatoren und einer Hamamatsu R928 Photomultiplier-Röhre, sowie einer TCSPC-Option. Emissions- und Anregungsspektren wurden korrigiert durch Standardkorrekturkurven.

Die Emissionsabklingzeiten wurden ebenfalls auf diesem System gemessen unter Verwendung der TCSPC-Methode mit dem FM-2013 Zubehör und einem TCSPC-Hub von Horiba Yvon Jobin. Anregungsquellen: NanoLED 370 (Wellenlänge: 371 nm, Pulsdauer: 1.1 ns), NanoLED 290 (Wellenlänge: 294 nm, Pulsdauer: <1 ns), SpectraLED 310 (Wellenlänge: 314nm), SpectraLED 355 (Wellenlänge: 355nm).

Die Auswertung (exponentielles Fitten) erfolgte mit dem Softwarepaket DataStation und der DAS 6 Auswertungssoftware. Der Fit wurde über die Chi-Quadrat-Methode angegeben

$$c^2 = \sum_{k=1}^{i} \frac{(e_i - o_i)^2}{e_i}$$

mit $e_i$: Durch den Fit vorhergesagte Größe und $o_i$: Gemessenen Größe.

***Quanteneffizienzbestimmung***

Die Messung der Photolumineszenzquantenausbeute (PLQY) erfolgte mittels eines *Absolute PL Quantum Yield Measurement* C9920-03G-Systems der Firma *Hamamatsu Photonics*. Dieses besteht aus einer 150 W Xenon-Gasentladungslampe, automatisch justierbaren Czerny-Turner Monochromatoren (250 - 950 nm) und einer Ulbricht-Kugel mit hochreflektierender Spektralon-Beschichtung (einem Teflon-Derivat), die über ein Glasfaserkabel mit einem PMA-12 Vielkanaldetektor mit BT- (*back thinned*-) CCD-Chip mit 1024 x 122 Pixeln (Größe 24 x 24 μm) verbunden ist. Die Auswertung der Quanteneffizienz und der CIE-Koordinaten erfolgte mit Hilfe der Software U6039-05 Version 3.6.0

Für G9920-OXG (PMA-12). Das Emissionsmaximum wird in nm, die Quantenausbeute $\phi$ in % und die CIE-Farbkoordinaten als x,y-Werte angegeben.

PLQY wurde für Polymerfilme, Lösungen und Pulverproben nach folgendem Protokoll bestimmt:

1) Durchführung der Qualitätssicherung: Als Refernzmaterial dient Anthracene in Ethanol mit bekannter Konzentration.
2) Ermitteln der Anregungswellenlänge: Es wurde zuerst das Absorbtionsmaximum des organischen Moleküls bestimmt und mit diesem angeregt.
3) Durchführung der Probenmessung: Es wurde von entgasten Lösungen und Filmen unter Stickstoff-Atmosphäre die absolute Quantenausbeute bestimmt. Die Berechnung erfolgte systemintern nach folgender Gleichung:

$$\Phi_{PL} = \frac{n_{photon}, emittiert}{n_{photon}, absorbiert} = \frac{\int \frac{\lambda}{hc}\left[Int_{emittiert}^{Probe}(\lambda) - Int_{absorbiert}^{Probe}(\lambda)\right]d\lambda}{\int \frac{\lambda}{hc}\left[Int_{emittiert}^{Referenz}(\lambda) - Int_{absorbiert}^{Referenz}(\lambda)\right]d\lambda}$$

mit der Photonenzahl $n_{photon}$ und der Intensität Int.

Alle Verbindungen wurden nach den in Beispiel 1 geschilderten Verfahren als weiße, feinkristalline Pulver hergestellt. Die Ausbeuten der Synthesen betrugen dabei zwischen 20 und 60%. Die Charakterisierung erfolgte mittels NMR Spektroskopie sowie Massenspektrometrie. Die Reinheit wurde mittels HPLC sichergestellt.

| **Struktur** | $\lambda_{max}$ **[nm]** PL von 10% des Emitters in PMMA | **CIE$_x$** | **CIE$_y$** | **PLQY** [%] |
|---|---|---|---|---|
| 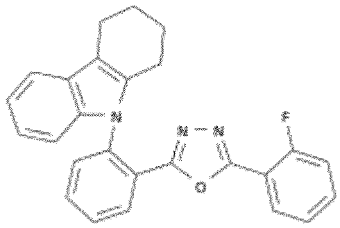 | 458 | 0.18 | 0.20 | 14 |
| 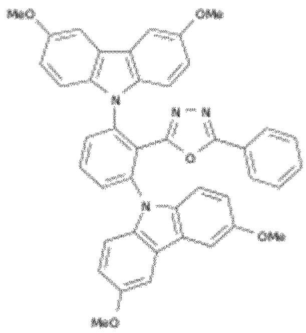 | 482 | 0.20 | 0.32 | 40 |
| 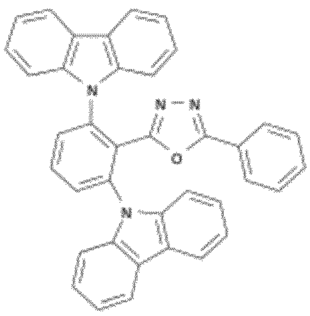 | 413 | 0.15 | 0.06 | 12 |
| 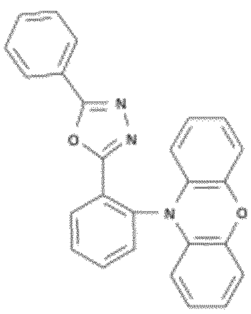 | 508 | 0.27 | 0.49 | 0 |

(fortgesetzt)

| **Struktur** | $\lambda_{max}$ **[nm]** PL von 10% des Emitters in PMMA | **CIE$_x$** | **CIE$_y$** | **PLQY** [%] |
|---|---|---|---|---|
| 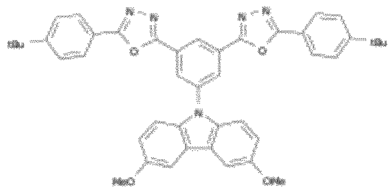 | 486 | 0.21 | 0.34 | 28 |
| 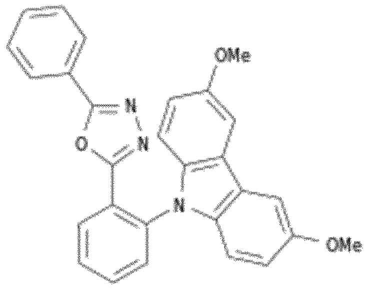 | 467 | 0.17 | 0.21 | 41 |
| 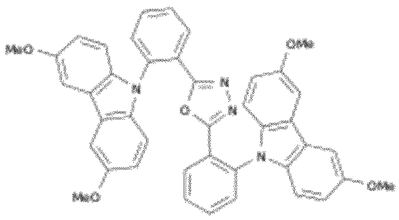 | 475 | 0.19 | 0.28 | 47 |
| 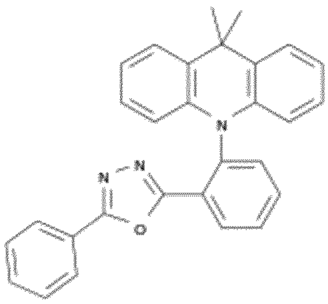 | 442 | 0.17 | 0.16 | 24 |
| 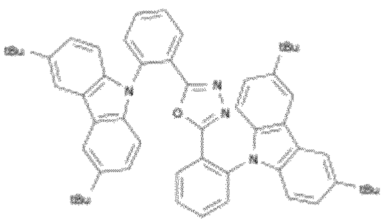 | 415 | 0.15 | 0.07 | 2 |
| 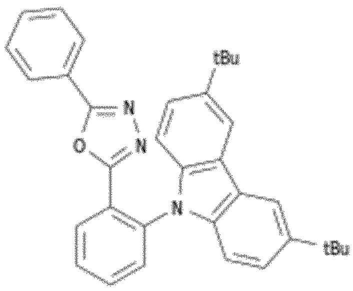 | 413 | 0.15 | 0.06 | 13 |

**Figuren**

Es zeigen

Figur 1: Schematische Darstellung des Aufbaus einer organischen lichtemittierenden Diode (OLED).
Figur 2: Emissionsspektrum von Molekül 1 (Anregung: 290 nm) als Dünnfilm (20 w-%) in PMMA.
Figur 3: Grenzorbitale HOMO und LUMO von Molekül 1.
Figur 4 Grenzorbitale HOMO und LUMO der Moleküle 3 bis 60.

**Patentansprüche**

**1.** Organisches Molekül, aufweisend eine Struktur der Formel 1

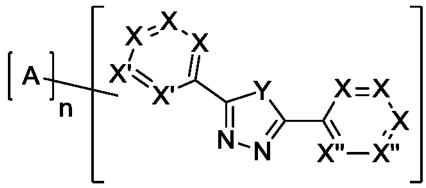

**Formel 1**

welche eine Teilstruktur A der Formel 1a enthält

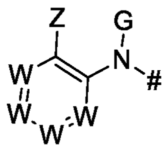

**Formel 1a**

wobei gilt:

n ist eine ganze Zahl von 1 bis 4;
# kennzeichnet über welche Anknüpfungsstelle die Teilstruktur A an das C-Atom von C-A gebunden ist;
Y O, S, Se oder NR*;
X, X’ und X" sind unabhängig voneinander ausgewählt aus der Gruppe bestehend aus N, CR* und C-A;
W unabhängig voneinander ausgewählt aus der Gruppe bestehend aus N, CR* und CR**, wobei mindestens ein CR** vorhanden ist;
Z Rest R*, wobei R* optional mit G zusammen Teil eines annelierten oder nichtannelierten 5-, 6-, 7- oder 8-gliedrigen Ringsystems, ausgewählt aus der Gruppe bestehend aus mit elektronenreichen Resten substituiertem Carbazol oder Indol, Hydroindol, Hydrocarbazol, Pyrol, Chinolin, Hydrochinolin, Azepin, Benzoazepin, Dibenzoazepin, Hydroazepin, Hydrobenzoazepin, Hydrodibenzoazepin, Tribenzoazepin, Phenazin, Indolocarbazol, Indenoindol, Phenoxazin, Phenothiazin oder Dihydroacridin, ist;
G Rest R*, wobei R* optional mit Z zusammen Teil eines annelierten oder nichtannelierten 5-, 6-, 7- oder 8-gliedrigen Ringsystems, ausgewählt aus der Gruppe aus mit elektronenreichen Resten substituiertem Carbazol oder Indol, Hydroindol, Hydrocarbazol, Pyrol, Chinolin, Hydrochinolin, Azepin, Benzoazepin, Dibenzoazepin, Hydroazepin, Hydrobenzoazepin, Hydrodibenzoazepin, Tribenzoazepin, Phenazin, Indolocarbazol, Indenoindol, Phenoxazin, Phenothiazin oder Dihydroacridin, ist;

und wobei gilt, dass

- bei n = 1 die Anknüpfung der Einheit A an einem X’ erfolgt;
- bei n = 2 die Anknüpfung von mindestens einer Einheit A an einem X’ erfolgt und dass insbesondere die Anknüpfung der zweiten Einheit A an einem X" erfolgt;

- bei n = 3 die Anknüpfung von mindestens einer Einheit A an einem X’ erfolgt und dass insbesondere die Anknüpfung der zweiten und dritten Einheit A an einem X’ oder X" erfolgt;
- bei n = 4 die Anknüpfung von mindestens einer Einheit A an einem X’ erfolgt und dass insbesondere die Anknüpfung der zweiten, dritten und vierten Einheit A an einem X’ oder X" erfolgt;

und wobei gilt:

Rest R** ist bei jedem Auftreten unabhängig voneinander ausgewählt aus einem elektronenreichen Rest wie Alkyl, Methoxy, Ethoxy, Phenoxy, Alkoxy, $NR_2$, Diphenylamin, Amin, Carbazol, Indol, Hydroindol, Hydrocarbazol, Pyrol, Chinolin, Hydrochinolin, Azepin, Benzoazepin, Dibenzoazepin, Hydroazepin, Hydrobenzoazepin, Hydrodibenzoazepin, Tribenzoazepin, Phenazin, Indolocarbazol, Indenoindol, Phenoxazin, Phenothiazin oder Dihydroacridin oder Acridin;
R* ist bei jedem Auftreten unabhängig voneinander ausgewählt aus der Gruppe bestehend aus H, Deuterium, Phenyl, Naphthyl, $N(R^2)_2$, -CN, -NC, -SCN, $-CF_3$, $-NO_2$, C(=O)OH, $C(=O)OR^3$, $C(=O)N(R^3)_2$, $C(=O)SR^3$, $C(=S)SR^3$, $Si(R^4)_3$, $B(OR^5)_2$, $B(N(R^6)_2)_2$, $C(=O)R^3$, $P(=O)(R^7)_2$, $As(=O)(R^7)_2$, $P(=S)(R^7)_2$, $As(=S)(R^7)_2$, $S(=O)R^3$, $S=NR^3$, $S(=O)NR^3$, $S(=O)_2NR,^3$ $S(=O)_2R^3$, $O-S(=O)_2R^3$, $SF_5$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C≡C-, oder eine benachbarte $CH_2$-Gruppe durch $-Si(R^4)_2-$, $-Ge(R^4)_2-$, $-Sn(R^4)_2$,-C(=O)-, -C(=S)-, -C(=Se)-,-C=N-, -C(=O)O-, $-C(=O)N(R^3)-$, $-P(=O)(R_7)-$, $-As(=O)(R^7)-$, $-P(=S)(R^7)$, $-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten R* auch miteinander ein mono- oder polycyclisches, aliphatisches, aromatisches und/oder benzoannelliertes Ringsystem bilden;
$R^2$ ist bei jedem Auftreten unabhängig voneinander ausgewählt aus der Gruppe bestehend aus H, Deuterium, Phenyl, Naphthyl, $CF_3$, $C(=O)OR^3$, $C(=O)N(R^2)_2$, $Si(R^4)_3$, $C(=O)R^3$, $P(=O)(R^7)_2$, $As(=O)(R^7)_2$ $P(=S)(R^7)_2$, $As(=S)(R^7)_2$, $S(=O)R^3$, $S(=O)_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C=C-, oder eine benachbarte $CH_2$-Gruppe durch $-Si(R^4)_2-$, - $Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, - $As(=O)(R^7)-$, $-P(=S)(R^7)-$, $-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^2$ auch miteinander ein mono- oder polycyclisches, aliphatisches, aromatisches und/oder benzoannelliertes Ringsystem bilden;
$R^3$ ist bei jedem Auftreten unabhängig voneinander ausgewählt aus der Gruppe bestehend aus H, Deuterium, Phenyl, Naphthyl, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^3$ auch miteinander ein mono- oder polycyclisches, aliphatisches Ringsystem bilden;
$R^4$ ist bei jedem Auftreten unabhängig voneinander ausgewählt aus der Gruppe bestehend aus H, Deuterium, Phenyl, Naphthyl, $N(R^2)_2$, CN, $CF_3$, OH, $C(=O)OR^3$, $C(=O)N(R^3)_2$, $C(=O)R^3$, $P(=O)(R^7)_2$, $As(=O)(R^7)_2$, $P(=S)(R^7)_2$, $As(=S)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch - $R^9C=CR^9-$, -C=C-, oder eine benachbarte $CH_2$-Gruppe durch $-Si(R^4)_2-$, $-Ge(R^4)_2-$, $-Sn(R^4)_2$, - C(=O)-, -C(=S)-, -C(=Se)-, -C=N-,

-C(=O)O-, -C(=O)N($R^3$)-, -P(=O)($R^7$)-, -As(=O)($R^7$)-, - P(=S)($R^7$), -As(=S)($R^7$)-, -S(=O)-, -S(=O)$_2$-, -N$R^2$-, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^4$ auch miteinander ein mono- oder polycyclisches, aliphatisches, aromatisches und/oder benzoannelliertes Ringsystem bilden;

$R^5$ ist bei jedem Auftreten unabhängig voneinander ausgewählt aus der Gruppe bestehend aus Phenyl, Naphthyl, $CF_3$, C(=O)$R^3$, P(=O)($R^7$)$_2$, As(=O)($R^7$)$_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch -$R^9$C=C$R^9$-, -C=C-, oder eine benachbarte $CH_2$-Gruppe durch -Si($R^4$)$_2$-, -Ge($R^4$)$_2$-, -Sn($R^4$)$_2$, - C(=O)-, -C(=S)-, -C(=Se)-, -C=N-, -C(=O)O-, -C(=O)N($R^3$)-, -P(=O)($R^7$)-, -As(=O)($R^7$)-, - P(=S)($R^7$)-, -As(=S)($R^7$)-, -S(=O)-, -S(=O)$_2$-, -N$R^2$-, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^5$ auch miteinander ein mono- oder polycyclisches, aliphatisches, aromatisches und/oder benzoannelliertes Ringsystem bilden;

$R^6$ ist bei jedem Auftreten unabhängig voneinander ausgewählt aus der Gruppe bestehend aus Phenyl, Naphthyl, $CF_3$, Si($R^4$)$_3$, C(=O)$R^3$, P(=O)($R^7$)$_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch - $R^9$C=C$R^9$-, -C=C-, oder eine benachbarte $CH_2$-Gruppe durch-Si($R^4$)$_2$-, -Ge($R^4$)$_2$-, -Sn($R^4$)$_2$, - C(=O)-, -C(=S)-, -C(=Se)-, -C=N-, -C(=O)O-, -C(=O)N($R^3$)-, -P(=O)($R^7$)-, -As(=O)($R^7$)-, - P(=S)($R^7$), -As(=S)($R^7$)-, -S(=O)-, -S(=O)$_2$-, -N$R^2$-, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste R* substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^6$ auch miteinander ein mono- oder polycyclisches, aliphatisches, aromatisches und/oder benzoannelliertes Ringsystem bilden;

$R^7$ ist bei jedem Auftreten unabhängig voneinander ausgewählt aus der Gruppe bestehend aus, Phenyl, Naphthyl, N($R^2$)$_2$, CN, $CF_3$, C(=O)O$R^3$, C(=O)N($R^3$)$_2$, Si($R^4$)$_3$, C(=O)$R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch -$R^9$C=C$R^9$-, -C=C-, oder eine benachbarte $CH_2$-Gruppe durch -Si($R^4$)$_2$-, -Ge($R^4$)$_2$-, -Sn($R^4$)$_2$, -C(=O)-, -C(=S)-, -C(=Se)-, -C=N-, -C(=O)O-, - C(=O)N($R^3$)-, -P(=O)($R^7$)-, -As(=O)($R^7$)-, -P(=S)($R^7$), -As(=S)($R^7$)-, -S(=O)-, -S(=O)$_2$-, -N$R^2$-, - O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^3$ substituiert sein kann, oder eine Kombination dieser Systeme; dabei können zwei oder mehrere dieser Substituenten $R^7$ auch miteinander ein mono- oder polycyclisches, aliphatisches, aromatisches und/oder benzoannelliertes Ringsystem bilden;

$R^8$ ist bei jedem Auftreten unabhängig voneinander ausgewählt aus der Gruppe bestehend aus H, Deuterium,

Phenyl, Naphthyl, F, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^8$ auch miteinander ein mono- oder polycyclisches, aliphatisches Ringsystem bilden;

$R^9$ ist bei jedem Auftreten unabhängig voneinander ausgewählt aus der Gruppe bestehend aus H, Deuterium, Phenyl, Naphthyl, $N(R^2)_2$, CN, $CF_3$, $NO_2$, OH, COOH, $C(=O)OR^3$, $C(=O)N(R^3)_2$, $Si(R^4)_3$, $B(OR^5)_2$, $C(=O)R^3$, $P(=O)(R^7)_2$, $P(=S)(R^7)_2$, $As(=O)(R^7)_2$, $P(=S)(R^7)_2$, $S(=O)R^3$, $S(=O)_2R^3$, $OSO_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^8$ substituiert sein kann, wobei eine oder mehrere nicht benachbarte $CH_2$-Gruppen durch $-R^3C=CR^3-$, -C=C-, oder eine benachbarte $CH_2$-Gruppe durch $-Si(R^4)_2-$, $-Ge(R^4)_2-$, $-Sn(R^4)_2$, -C(=O)-, -C(=S)-, -C(=Se)-, - C=N-, -C(=O)O-, $-C(=O)N(R^3)-$, $-P(=O)(R^7)-$, $-As(=O)(R^7)-$, $-P(=S)(R^7)$, $-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^3$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^8$ substituiert sein kann, oder eine Kombination dieser Systeme; dabei können zwei oder mehrere dieser Substituenten $R^9$ auch miteinander ein mono- oder polycyclisches, aliphatisches, aromatisches und/oder benzoannelliertes Ringsystem bilden.

2. Organisches Molekül nach Anspruch 1, wobei das organische Molekül ausgewählt ist aus einer Struktur nach Formel 2

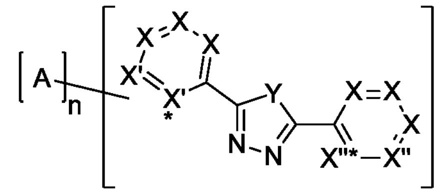

**Formel 2**

wobei die Anknüpfung einer Einheit A an X'* erfolgt;
und wobei im Fall von n > 1 die Anknüpfung einer zweiten Einheit A an X'''* erfolgt;
und wobei ansonsten die in Anspruch 1 angegebenen Definitionen gelten.

3. Organisches Molekül nach Anspruch 2, wobei das Z und G Teil eines 5-, 6-, 7- oder 8-gliedrigen Ringsystems sind, welches mit elektronenreichen Resten, insbesondere mit Alkyl, Methoxy, Ethoxy, Phenoxy, Alkoxy, $NR_2$, Diphenylamin, Amin, Carbazol, Indol, Hydroindol, Hydrocarbazol, Pyrol, Chinolin, Hydrochinolin, Azepin, Benzoazepin, Dibenzoazepin, Hydroazepin, Hydrobenzoazepin, Hydrodibenzoazepin, Tribenzoazepin, Phenazin, Indolocarbazol, Indenoindol, Phenoxazin, Phenothiazin oder Dihydroacridin oder Acridin substituiert ist und wodurch sich entsprechend die Strukturen 3-1 bis 3-27 ergeben:

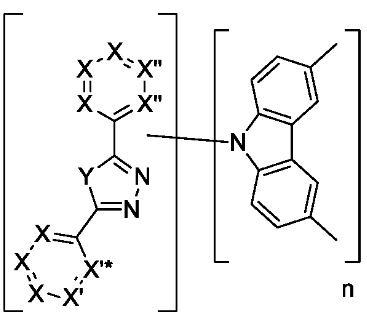

3-1

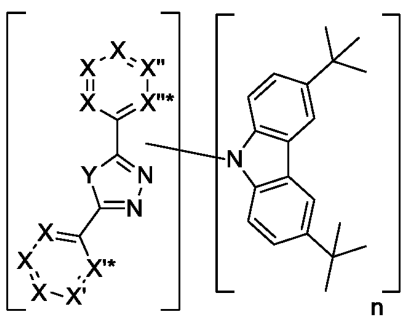

3-2

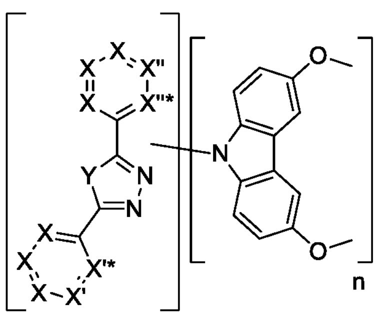

3-3

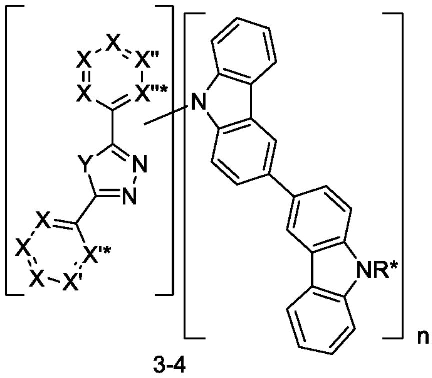

3-4

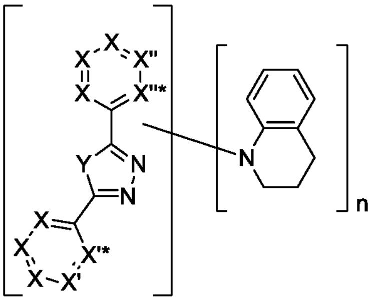

3-5

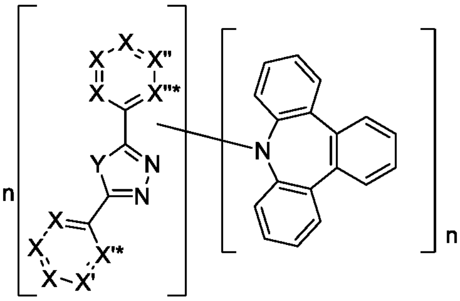

3-6

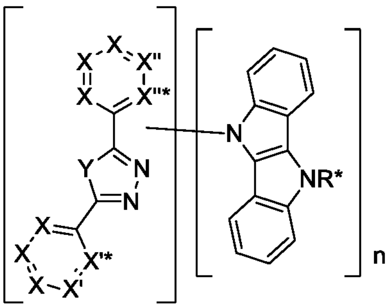

3-7

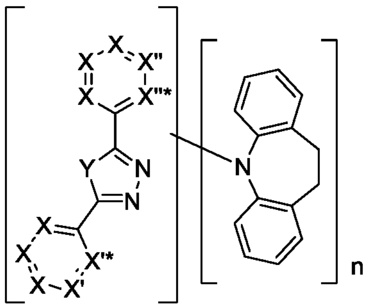

3-8

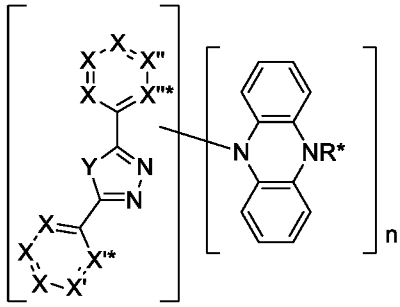

3-9

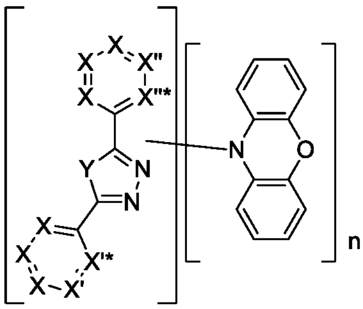

3-10

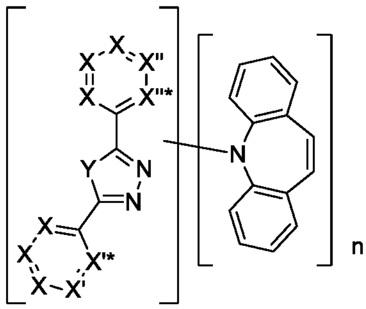

3-11

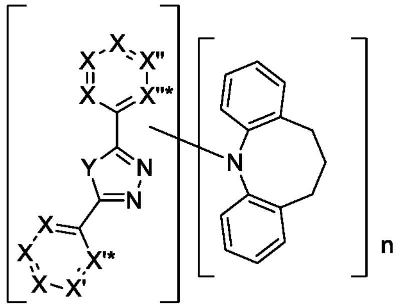

3-12

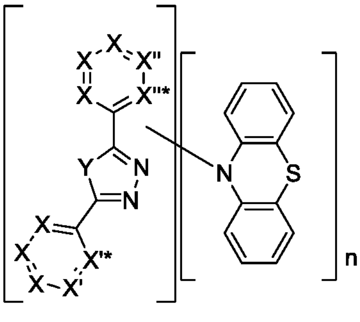

3-13

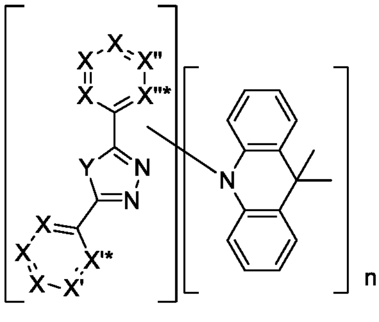

3-14

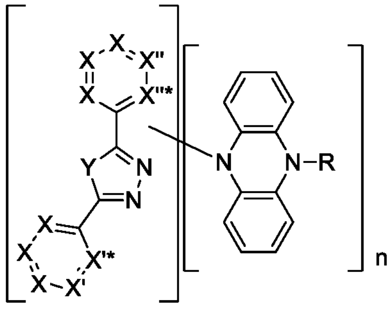

3-15

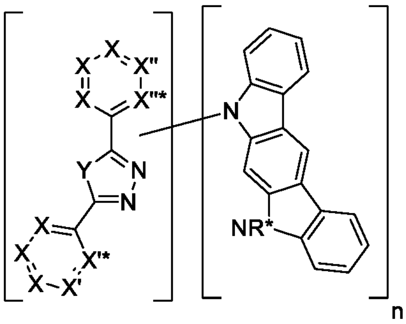

3-16

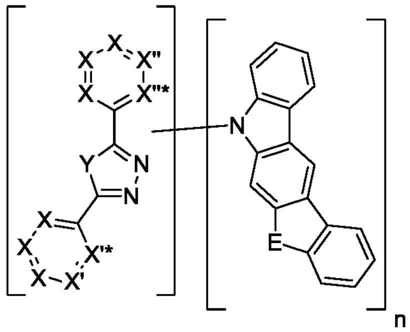

3-17

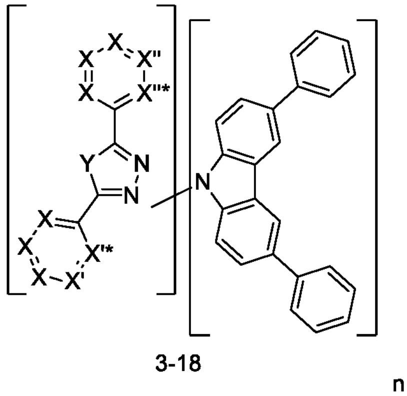

3-18

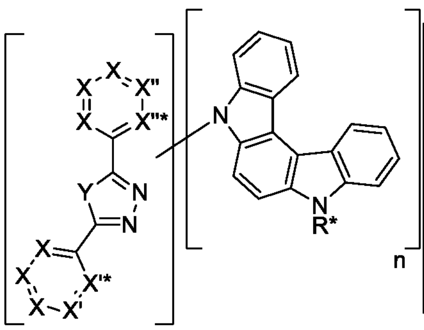

3-19

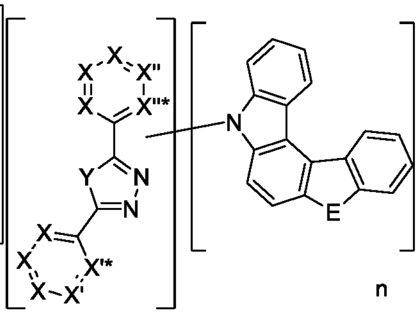

3-20

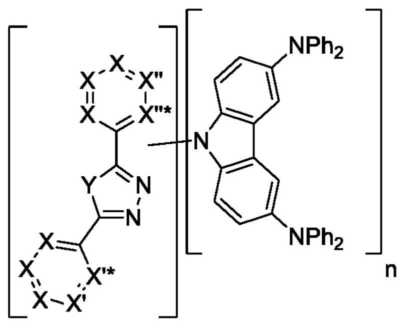

3-21

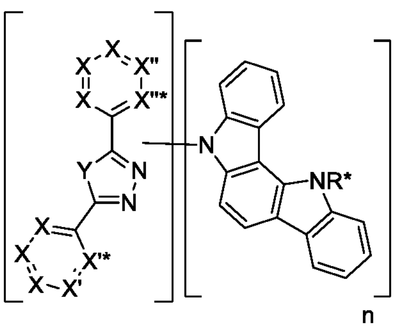

3-22

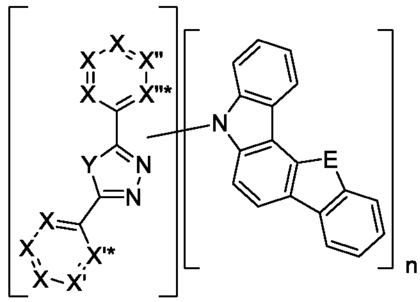

3-23

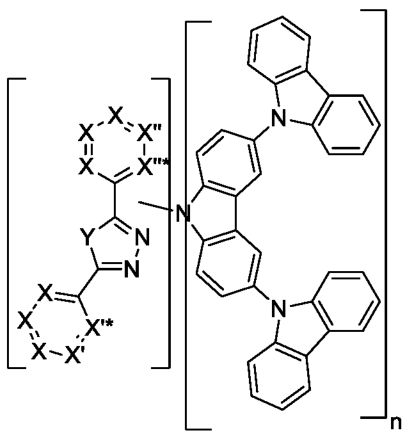

3-24

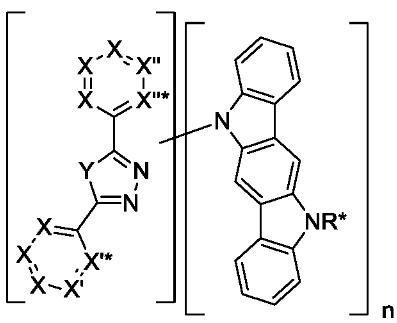

3-25

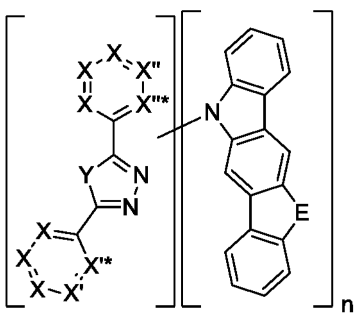

3-26

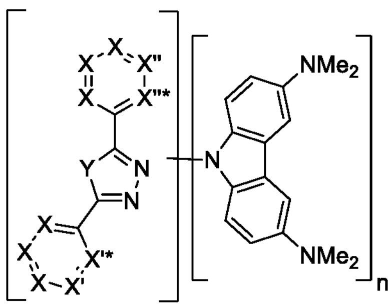

3-27

mit E = O, S, Se, $CR_2$

und wobei ansonsten die in Anspruch 2 angegebenen Definitionen gelten.

**4.** Organisches Molekül nach Anspruch 1, wobei das organische Molekül ausgewählt aus ist einer der Strukturen 4a oder 4b:

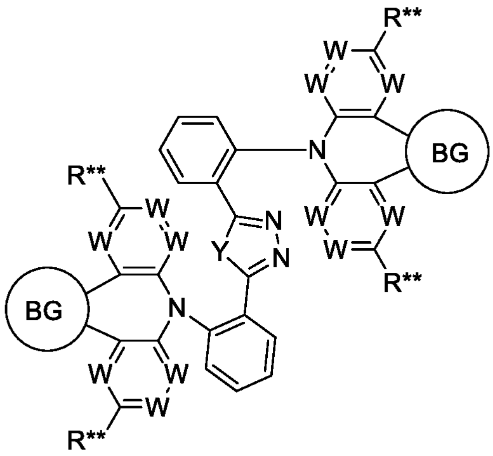

**Formel 4a**

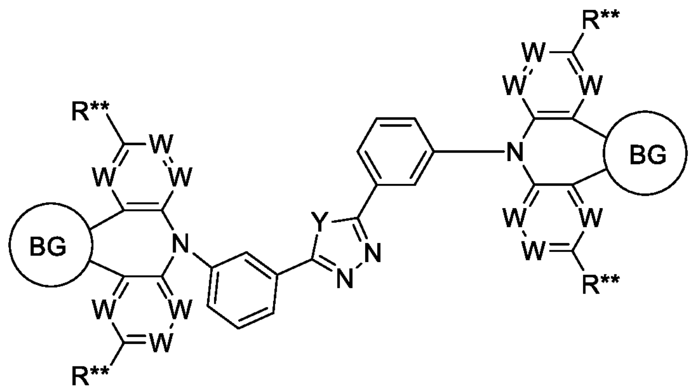

**Formel 4b**

wobei die optional vorhandene Brücke BG unabhängig voneinander ausgewählt ist aus der Gruppe bestehend aus einer Einfachbindung, $CR^*_2$, $CMe_2$, $CPh_2$, NPh, NMe, C=O, C=S, $SO_2$, O, S, $C_2H_4$, $C_2H_2$ und 1,2-Phenylen;
und wobei bei Vorhandensein einer Einfachbindung BG mindestens ein Rest R** ausgewählt ist aus einem elektronenreichen Rest wie tButyl, Methoxy, Ethoxy, Dimethylamin, Diphenylamin, Phenoxy Carbazol, Phenoxazin, Phenothiazin, Phenazin und Acridin;
und wobei ansonsten die in Anspruch 1 angegebenen Definitionen gelten.

**5.** Organisches Molekül nach Anspruch 1 oder 4, wobei das organische Molekül ausgewählt ist aus einer der Strukturen 5a oder 5b:

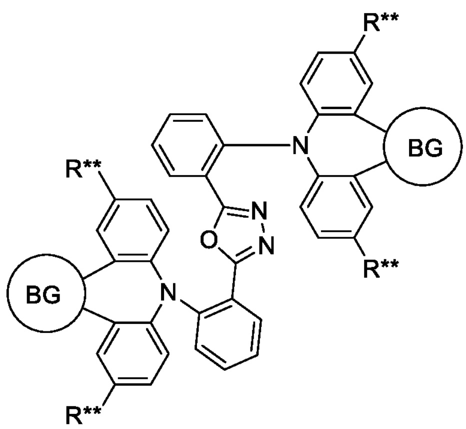

**Formel 5a**

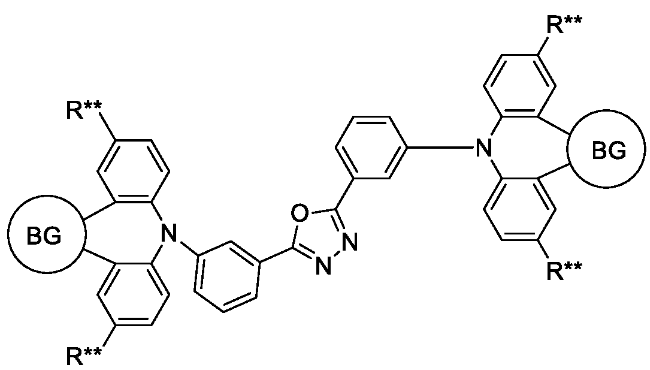

**Formel 5b**

und wobei die in Anspruch 1 und Anspruch 4 angegebenen Definitionen gelten.

**6.** Organisches Molekül nach Anspruch 1, 4 oder 5, wobei das organische Molekül ausgewählt ist aus einer der Strukturen 6a oder 6b:

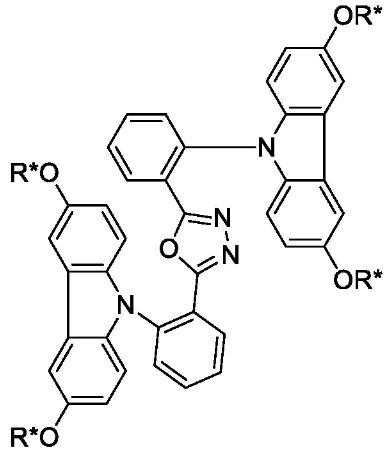

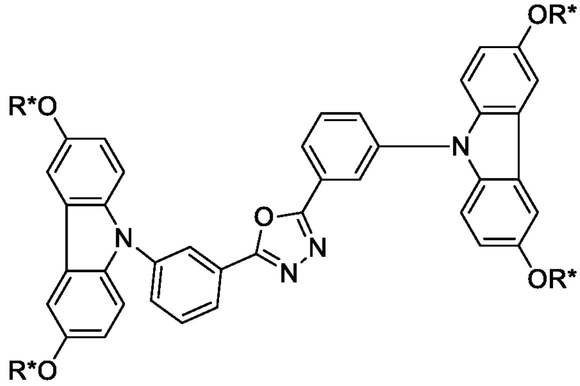

**Formel 6a** **Formel 6b**

und wobei ansonsten die in Anspruch 1 angegebenen Definitionen gelten;
und wobei R* insbesondere ein Alkylrest ist.

**7.** Organisches Molekül nach Anspruch 1 bis 6, wobei das organische Molekül an mindestens einer Position mindestens einen weiteren Rest R, insbesondere zur Steigerung der Löslichkeit und/oder der Polymerisierbarkeit, aufweist, wobei

R ist bei jedem Auftreten unabhängig voneinander ausgewählt aus der Gruppe bestehend aus H, Deuterium, Phenyl, Naphthyl, F, Cl, Br, I, $N(R^2)_2$, -CN, -NC, -SCN, - $CF_3$, $-NO_2$, -OH, C(=O)OH, C(=O)$OR^3$, C(=O)$N(R^3)_2$, C(=O)$SR^3$, C(=S)$SR^3$, $Si(R^4)_3$, $B(OR^5)_2$, $B(N(R^6)_2)_2$, C(=O)$R^3$, P(=O)$(R^7)_2$, AS(=O)$(R^7)_2$, P(=S)$(R^7)_2$, AS(=S)$(R^7)_2$, S(=O)$R^3$, S=$NR^3$, S(=O)$NR^3$, $S(=O)_2NR^3$, $S(=O)_2R^3$, O-$S(=O)_2R^3$, $SF_5$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch -$R^9$C=C$R^9$-, -C=C-, oder eine benachbarte $CH_2$-Gruppe durch -$Si(R^4)_2$-, -$Ge(R^4)_2$-, -$Sn(R^4)_2$, -C(=O)-, -C(=S)-, -C(=Se)-, -C=N-, -C(=O)O-, -C(=O)N($R^3$)-, -P(=O)($R^7$)-, -As(=O)($R^7$)-, -P(=S)($R^7$)-, - As(=S)($R^7$)-, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden; wobei $R^2$ bis $R^9$ definiert sind wie in Anspruch 1;

und wobei mittels solcher Reste, die polymerisierbare funktionelle Einheiten tragen, die mit sich selbst homopolymerisiert oder mit anderen Monomeren copolymiersiert werden können, das organische Molekül als Polymer mit Wiederholungseinheiten nach den Formeln 4 und/oder 5 erhalten wird

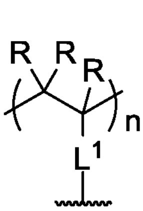

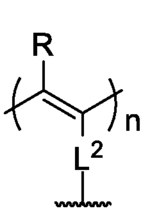

**Formel 4** **Formel 5**

mit

gewellte Linie = Position, über die die Linkergruppe $L^1$ oder $L^2$ an das organische Molekül gebunden ist;
$L^1$ und $L^2$ = gleiche oder verschiedene Linkergruppen, aufweisend zwischen 0 bis 20 Kohlenstoffatome; oder aufweisend eine Form -C(=O)O;
und wobei insbesondere $L^1$ und $L^2$ = -X-$L^3$ mit X = O oder S;
$L^3$ = eine weitere Linkergruppe ausgewählt aus der Gruppe aus einersubstituierten und unsubstituierten Alkylengruppe (linear, verzweigt oder cyclisch) und einer substituierten und unsubstituierten Arylengruppe, wobei auch Kombinationen möglich sind.

**8.** Verwendung eines organischen Moleküls nach Anspruch 1 bis 7 als lumineszierender Emitter und/oder als Hostmaterial und/oder als Elektronentransportmaterial und/oder als Lochinjektionsmaterial und/oder als Lochblockiermaterial in einem optoelektronischen Bauelement.

**9.** Verwendung nach Anspruch 8, wobei das optoelektronische Bauelement ausgewählt ist aus der Gruppe bestehend aus:

- organischen lichtemittierenden Dioden (OLEDs),
- Licht-emittierenden elektrochemischen Zellen,
- OLED-Sensoren, insbesondere in nicht hermetisch nach außen abgeschirmten Gas- und Dampf-Sensoren,
- organischen Dioden,
- organischen Solarzellen,
- organischer Transistor
- organischen Feldeffekttransistoren,
- organischen Lasern und
- Down-Konversions-Elementen.

**10.** Verwendung nach Anspruch 8 oder 9, wobei der Anteil des organischen Moleküls an dem Emitter 1 % bis 99 % beträgt.

**11.** Verwendung nach Anspruch 8 bis 10, wobei die Konzentration des organischen Moleküls als Emitter in optischen Licht emittierenden Bauelementen, insbesondere in OLEDs, zwischen 5 % und 80 % beträgt.

**12.** Optoelektronisches Bauelement, aufweisend ein organisches Molekül nach Anspruch 1 bis 7, insbesondere ausgeformt als ein Bauelement ausgewählt aus der Gruppe bestehend aus organischer lichtemittierender Diode (OLED), Licht-emittierender elektrochemischer Zelle, OLED-Sensor, insbesondere in nicht hermetisch nach außen abgeschirmten Gas- und Dampf-Sensoren, organischer Diode, organischer Solarzelle, organischem Transistor, organischem Feldeffekttransistor, organischem Laser und Down-Konversion-Element.

**13.** Optoelektronisches Bauelement nach Anspruch 12, aufweisend

- ein Substrat,
- eine Anode und
- eine Kathode, wobei die Anode und die Kathode auf das Substrat aufgebracht sind, und
- mindestens eine lichtemittierende Schicht, die zwischen Anode und Kathode angeordnet ist und die ein organisches Molekül nach Anspruch 1 bis 7 aufweist oder daraus besteht.

**14.** Optoelektronisches Bauelement nach Anspruch 13, in dem die lichtemittierende Schicht mindestens ein Hostmaterial aufweist, wobei der angeregte Singulettzustand ($S_1$) und/oder der angeregte Triplettzustand ($T_1$) des mindestens einen Hostmaterials höher ist als der angeregte Singulettzustand ($S_1$) und/oder der angeregte Triplettzustand ($T_1$) des organischen Moleküls nach Anspruch 1 bis 7.

**15.** Optoelektronisches Bauelement nach Anspruch 12 bis 14, aufweisend mindestens ein Hostmaterial bestehend aus einem Material gemäß Anspruch 1 bis 7.

**16.** Optoelektronisches Bauelement nach Anspruch 12 bis 15, wobei die lichtemittierende Schicht fluoreszente oder phosphoreszente Materialien beinhaltet und wobei es sich bei den Materialien der lichtemittierenden Schicht um organische Moleküle nach Anspruch 1 bis 7 handelt.

**17.** Optoelektronisches Bauelement nach Anspruch 16, in dem ein organisches Molekül gemäß Anspruch 1 bis 7 zusammen mit einem funktionellen Material einen Exciplex bildet.

**18.** Optoelektronisches Bauelement nach Anspruch 12 bis 17, wobei die Emission durch thermisch aktivierte verzögerte Fluoreszenz (TADF) charakterisiert ist.

**19.** Optoelektronisches Bauelement nach Anspruch 12 bis 17, in dem ein organisches Molekül nach Anspruch 1 bis 7 als Ladungstransportschicht verwendet wird.

**20.** Verfahren zur Herstellung eines optoelektronischen Bauelements, wobei ein organisches Molekül nach Anspruch 1 bis 7 verwendet wird.

**21.** Verfahren nach Anspruch 20, wobei die Verarbeitung des organischen Moleküls mittels eines Vakuumverdampfungsverfahrens oder aus einer Lösung erfolgt.

## Claims

**1.** Organic molecule having a structure of the formula 1

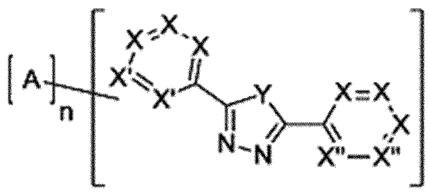

**Formula 1**

which contains a substructure A of the formula 1a

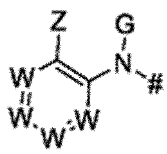

**Formula 1a**

where:

n is an integer from 1 to 4;
# indicates the attachment site via which the substructure A is bonded to the carbon atom of C-A;
Y is O, S, Se or NR*;
X, X' and X" are independently selected from the group consisting of N, CR* and C-A;
W is independently selected from the group consisting of N, CR* and CR**, where at least one CR** is present;
Z is R* radical, where R*, optionally together with G, is part of a fused or non-fused 5-, 6-, 7- or 8-membered ring system selected from the group consisting of carbazole or indole substituted by electron-rich radicals, hydroindole, hydrocarbazole, pyrrole, quinoline, hydroquinoline, azepine, benzoazepine, dibenzoazepine, hydroazepine, hydrobenzoazepine, hydrodibenzoazepine, tribenzoazepine, phenazine, indolocarbazole, indenoindole, phenoxazine, phenothiazine or dihydroacridine;
G is R* radical, where R*, optionally together with Z, is part of a fused or non-fused 5-, 6-, 7- or 8-membered ring system selected from the group consisting of carbazole or indole substituted by electron-rich radicals, hydroindole, hydrocarbazole, pyrrole, quinoline, hydroquinoline, azepine, benzoazepine, dibenzoazepine, hydroazepine, hydrobenzoazepine, hydrodibenzoazepine, tribenzoazepine, phenazine, indolocarbazole, indenoindole, phenoxazine, phenothiazine or dihydroacridine;

and where

- when n = 1 the linkage of the A unit is to an X';
- when n = 2 the linkage of at least one A unit is to an X' and, in particular, the linkage of the second A unit is to an X";

- when n = 3 the linkage of at least one A unit is to an X' and, in particular, the linkage of the second and third A units is to an X' or X";
- when n = 4 the linkage of at least one A unit is to an X' and, in particular, the linkage of the second, third and fourth A units is to an X' or X";

and where:

R** radical independently at each instance is selected from an electron-rich radical such as alkyl, methoxy, ethoxy, phenoxy, alkoxy, $NR_2$, diphenylamine, amine, carbazole, indole, hydroindole, hydrocarbazole, pyrrole, quinoline, hydroquinoline, azepine, benzoazepine, dibenzoazepine, hydroazepine, hydrobenzoazepine, hydrodibenzoazepine, tribenzoazepine, phenazine, indolocarbazole, indenoindole, phenoxazine, phenothiazine or dihydroacridine or acridine;

R* independently at each instance is selected from the group consisting of H, deuterium, phenyl, naphthyl, $N(R^2)_2$, -CN, -NC, -SCN, $-CF_3$, $-NO_2$, C(=O)OH, $C(=O)OR^3$, $C(=O)N(R^3)_2$, $C(=O)SR^3$, $C(=S)SR^3$, $Si(R^4)_3$, $B(OR^5)^2$, $B(N(R^6)_2)_2$, $C(=O)R^3$, $P(=O)(R^7)_2$, $As(=O)(R^7)_2$, $P(=S)(R^7)_2$, $AS(=S)(R^7)_2$, $S(=O)R^3$, $S=NR^3$, $S(=O)NR^3$, $S(=O)_2NR^3$, $S(=O)_2R^3$, $O-S(=O)_2R^3$, $SF_5$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which may be substituted by one or more $R^9$ radicals, where one or more adjacent $CH_2$ groups may be replaced by $-R^9C=CR^9-$, - C=C-, or one adjacent $CH_2$ group by $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)$, $-As(=S)(R^7)-$, -S(=O)-, $-S(=O)_2-$, $-NR^2-$, -O-, or -S-, and where one or more hydrogen atoms may be replaced by deuterium, F, Cl, Br, I, CN, $CF_3$ or $NO_2$, or an aromatic or heteroaromatic ring system which has 5 to 60 aromatic ring atoms and may be substituted in each case by one or more $R^2$ radicals, or an aryloxy or heteroaryloxy group which has 5 to 60 aromatic ring atoms and may be substituted by one or more $R^9$ radicals, or a diarylamino group, diheteroarylamino group or arylheteroarylamino group which has 10 to 40 aromatic ring atoms and may be substituted by one or more $R^9$ radicals, or a combination of these systems; at the same time, two or more of these R* substituents together may also form a mono- or polycyclic, aliphatic, aromatic and/or benzofused ring system;

$R^2$ independently at each instance is selected from the group consisting of H, deuterium, phenyl, naphthyl, $CF_3$, $C(=O)OR^3$ , $C(=O)N(R^2)_2$, $Si(R^4)_3$, $C(=O)R^3$, $P(=O)(R^7)_2$, $As(=O)(R^7)_2$, $P(=S)(R^7)_2$, $AS(=S)(R^7)_2$, $S(=O)R^3$, $S(=O)_2R^3$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which may be substituted by one or more $R^9$ radicals, where one or more adjacent $CH_2$ groups may be replaced by $-R^9C=CR^9-$, -C=C-, or one adjacent $CH_2$ group by $- Si(R^4)_2$, $-Ge(R^4)_2-$, $-Sn(R^4)_2$, -C(=O)-, -C(=S)-, -C(=Se)-, -C=N-, -C(=O)O-, $-C(=O)N(R^3)-$, $- P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, or -S-, and where one or more hydrogen atoms may be replaced by deuterium, F, Cl, Br, I, CN, $CF_3$ or $NO_2$, or an aromatic or heteroaromatic ring system which has 5 to 60 aromatic ring atoms and may be substituted in each case by one or more $R^9$ radicals, or an aryloxy or heteroaryloxy group which has 5 to 60 aromatic ring atoms and may be substituted by one or more $R^2$ radicals, or a diarylamino group, diheteroarylamino group or arylheteroarylamino group which has 10 to 40 aromatic ring atoms and may be substituted by one or more $R^9$ radicals, or a combination of these systems; at the same time, two or more of these $R^2$ substituents together may also form a mono- or polycyclic, aliphatic, aromatic and/or benzofused ring system;

$R^3$ independently at each instance is selected from the group consisting of H, deuterium, phenyl, naphthyl, $CF_3$ or an aliphatic, aromatic and/or heteroaromatic hydrocarbyl radical which has 1 to 20 carbon atoms and in which one or more hydrogen atoms may also be replaced by F or $CF_3$; at the same time, two or more $R^3$ substituents together may also form a mono- or polycyclic aliphatic ring system;

$R^4$ independently at each instance is selected from the group consisting of H, deuterium, phenyl, naphthyl, $N(R^2)_2$, CN, $CF_3$, OH, $C(=O)OR^3$, $C(=O)N(R^3)_2$, $C(=O)R^3$, $P(=O)(R^7)_2$, $As(=O)(R^7)_2$, $P(=S)(R^7)_2$, $AS(=S)(R^7)_2$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which may be substituted by one or more $R^9$ radicals, where one or more adjacent $CH_2$ groups may be replaced by $-R^9C=CR^9-$, -C=C-, or one adjacent $CH_2$ group by $-Si(R^4)_2-$, $- Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, $- As(=O)(R^7)-$, $-P(=S)(R^7)$, $-As(=S)(R^7)-$, -S(=O)-, $-S(=O)_2-$, $-NR^2-$, -O-, or -S-, and where one or more hydrogen atoms may be replaced by deuterium, F, Cl, Br, I, CN, $CF_3$ or $NO_2$, or an aromatic or heteroaromatic ring system which has 5 to 60 aromatic ring atoms and may be substituted in each case by one or more $R^8$ radicals, or an aryloxy or heteroaryloxy group which has 5 to 60 aromatic ring atoms and may be substituted by one or more $R^9$ radicals, or

a diarylamino group, diheteroarylamino group or arylheteroarylamino group which has 10 to 40 aromatic ring atoms and may be substituted by one or more $R^9$ radicals, or a combination of these systems; at the same time, two or more of these $R^4$ substituents together may also form a mono- or polycyclic, aliphatic, aromatic and/or benzofused ring system;

$R^5$ independently at each instance is selected from the group consisting of phenyl, naphthyl, $CF_3$, $C(=O)R^3$, $P(=O)(R^7)_2$, $As(=O)(R^7)_2$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which may be substituted by one or more $R^9$ radicals, where one or more adjacent $CH_2$ groups may be replaced by $-R^9C=CR^9-$, -C=C-, or one adjacent $CH_2$ group by $-Si(R^4)_2-$, - $Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, - $As(=O)(R^7)-$, $-P(=S)(R^7)-$, $-As(=S)(R^7)-$, -S(=O)-, $-S(=O)_2-$, $-NR^2-$, -O-, or -S-, and where one or more hydrogen atoms may be replaced by deuterium, F, Cl, Br, I, CN, $CF_3$ or $NO_2$, or an aromatic or heteroaromatic ring system which has 5 to 60 aromatic ring atoms and may be substituted in each case by one or more $R^9$ radicals, or an aryloxy or heteroaryloxy group which has 5 to 60 aromatic ring atoms and may be substituted by one or more $R^9$ radicals, or a diarylamino group, diheteroarylamino group or arylheteroarylamino group which has 10 to 40 aromatic ring atoms and may be substituted by one or more $R^9$ radicals, or a combination of these systems; at the same time, two or more of these $R^5$ substituents together may also form a mono- or polycyclic, aliphatic, aromatic and/or benzofused ring system;

$R^6$ independently at each instance is selected from the group consisting of phenyl, naphthyl, $CF_3$, $Si(R^4)_3$, $C(=O)R^3$, $P(=O)(R^7)_2$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which may be substituted by one or more $R^9$ radicals, where one or more adjacent $CH_2$ groups may be replaced by $-R^9C=CR^9-$, -C=C-, or one adjacent $CH_2$ group by $-Si(R^4)_2-$, - $Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, - $As(=O)(R^7)-$, $-P(=S)(R^7)$, $-As(=S)(R^7)$, -S(=O)-, $-S(=O)_2-$, $-NR^2-$, -O-, or -S-, and where one or more hydrogen atoms may be replaced by deuterium, F, Cl, Br, I, CN, $CF_3$ or $NO_2$, or an aromatic or heteroaromatic ring system which has 5 to 60 aromatic ring atoms and may be substituted in each case by one or more $R^9$ radicals, or an aryloxy or heteroaryloxy group which has 5 to 60 aromatic ring atoms and may be substituted by one or more R* radicals, or a diarylamino group, diheteroarylamino group or arylheteroarylamino group which has 10 to 40 aromatic ring atoms and may be substituted by one or more $R^9$ radicals, or a combination of these systems; at the same time, two or more of these $R^6$ substituents together may also form a mono- or polycyclic, aliphatic, aromatic and/or benzofused ring system;

$R^7$ independently at each instance is selected from the group consisting of phenyl, naphthyl, $N(R^2)_2$, CN, $CF_3$, $C(=O)OR^3$, $C(=O)N(R^3)_2$, $Si(R^4)_3$, $C(=O)R^3$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which may be substituted by one or more $R^9$ radicals, where one or more adjacent $CH_2$ groups may be replaced by $-R^9C=CR^9-$, -C=C-, or one adjacent $CH_2$ group by $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$, - $P(=O)(R^7)-$, $-As(=O)(R^7)-$, $-P(=S)(R^7)$, $-As(=S)(R^7)-$, -S(=O)-, $-S(=O)_2-$, $-NR^2-$, -O-, or -S-, and where one or more hydrogen atoms may be replaced by deuterium, F, Cl, Br, I, CN, $CF_3$ or $NO_2$, or an aromatic or heteroaromatic ring system which has 5 to 60 aromatic ring atoms and may be substituted in each case by one or more $R^9$ radicals, or an aryloxy or heteroaryloxy group which has 5 to 60 aromatic ring atoms and may be substituted by one or more $R^9$ radicals, or a diarylamino group, diheteroarylamino group or arylheteroarylamino group which has 10 to 40 aromatic ring atoms and may be substituted by one or more $R^3$ radicals, or a combination of these systems; at the same time, two or more of these $R^7$ substituents together may also form a mono- or polycyclic, aliphatic, aromatic and/or benzofused ring system;

$R^8$ independently at each instance is selected from the group consisting of H, deuterium, phenyl, naphthyl, F, $CF_3$ or an aliphatic, aromatic and/or heteroaromatic hydrocarbyl radical which has 1 to 20 carbon atoms and in which one or more hydrogen atoms may also be replaced by F or $CF_3$; at the same time, two or more $R^8$ substituents together may also form a mono- or polycyclic aliphatic ring system;

$R^9$ independently at each instance is selected from the group consisting of H, deuterium, phenyl, naphthyl, $N(R^2)_2$, CN, $CF_3$, $NO_2$, OH, COOH, $C(=O)OR^3$, $C(=O)N(R^3)_2$, $Si(R^4)_3$, $B(OR^5)_2$, $C(=O)R^3$, $P(=O)(R^7)_2$, $P(=S)(R^7)_2$, $As(=O)(R^7)_2$, $P(=S)(R^7)_2$, $S(=O)R^3$, $S(=O)_2R^3$, $OSO_2R^3$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which may be substituted by one or more $R^8$ radicals, where one or more adjacent $CH_2$ groups may be replaced by $-R^3C=CR^3-$, -C=C-, or one non-adjacent $CH_2$ group by $-Si(R^4)_2-$, $-Ge(R^4)_2-$, - $Sn(R^4)_2$, -C(=O)-, -C(=S)-, -C(=Se)-, -C=N-, -C(=O)O-, $-C(=O)N(R^3)-$, $-P(=O)(R^7)-$, - $As(=O)(R^7)-$, $-P(=S)(R^7)$, $-As(=S)(R^7)-$, -S(=O)-, $-S(=O)_2-$, $-NR^2-$, -O-,

or -S-, and where one or more hydrogen atoms may be replaced by deuterium, F, Cl, Br, I, CN, $CF_3$ or $NO_2$, or an aromatic or heteroaromatic ring system which has 5 to 60 aromatic ring atoms and may be substituted in each case by one or more $R^8$ radicals, or an aryloxy or heteroaryloxy group which has 5 to 60 aromatic ring atoms and may be substituted by one or more $R^3$ radicals, or a diarylamino group, diheteroarylamino group or arylheteroarylamino group which has 10 to 40 aromatic ring atoms and may be substituted by one or more $R^8$ radicals, or a combination of these systems; at the same time, two or more of these $R^9$ substituents together may also form a mono- or polycyclic, aliphatic, aromatic and/or benzofused ring system.

**2.** Organic molecule according to Claim 1, wherein the organic molecule is selected from a structure of formula 2

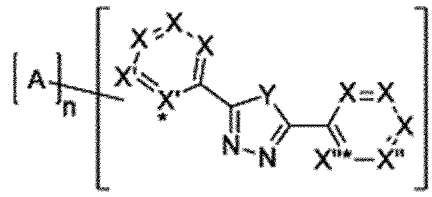

**Formula 2**

where the linkage of an A unit is to X'*;
and where, in the case that n > 1, the linkage of a second A unit is to X"*;
and where the definitions given in Claim 1 are otherwise applicable.

**3.** Organic molecule according to Claim 2, wherein the Z and G are part of a 5-, 6-, 7- or 8-membered ring system substituted by electron-rich radicals, especially by alkyl, methoxy, ethoxy, phenoxy, alkoxy, $NR_2$, diphenylamine, amine, carbazole, indole, hydroindole, hydrocarbazole, pyrrole, quinoline, hydroquinoline, azepine, benzoazepine, dibenzoazepine, hydroazepine, hydrobenzoazepine, hydrodibenzoazepine, tribenzoazepine, phenazine, indolocarbazole, indenoindole, phenoxazine, phenothiazine or dihydroacridine or acridine, and which result correspondingly in the structures 3-1 to 3-27:

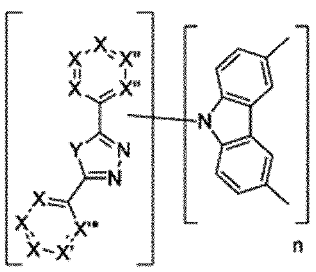

3-1

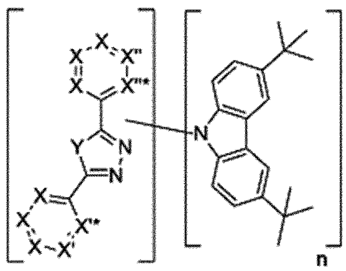

3-2

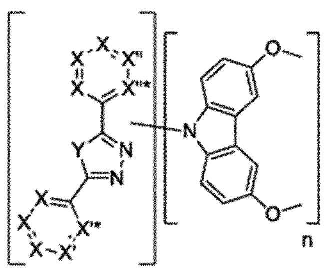

3-3

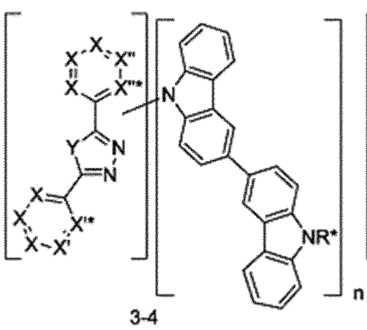

3-4

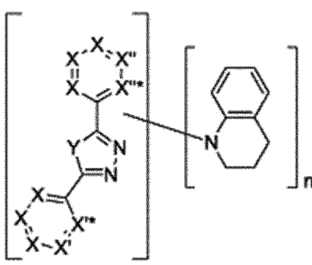

3-5

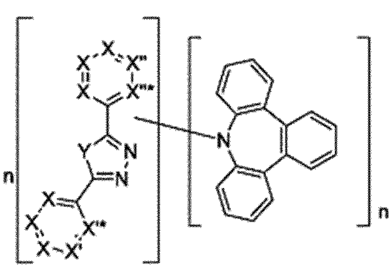

3-6

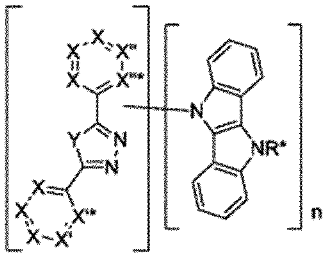

3-7

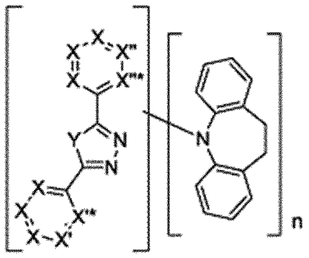

3-8

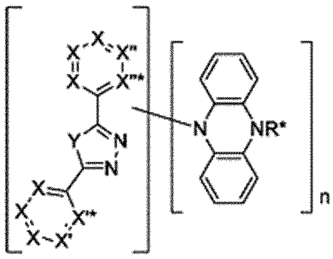

3-9

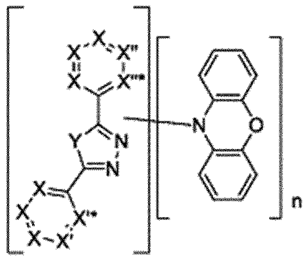

3-10

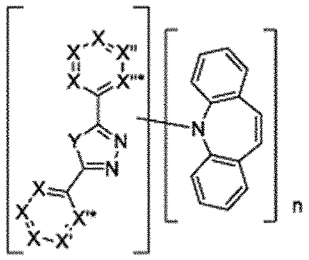

3-11

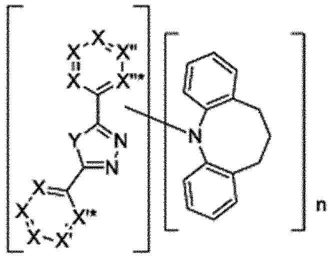

3-12

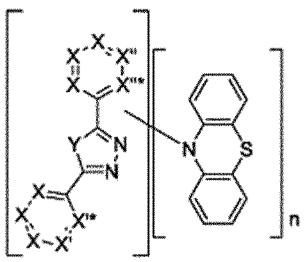

3-13

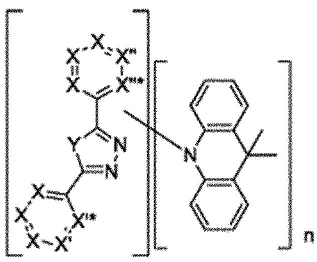

3-14

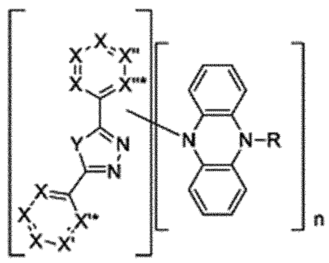

3-15

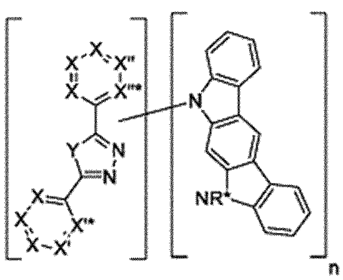

3-16

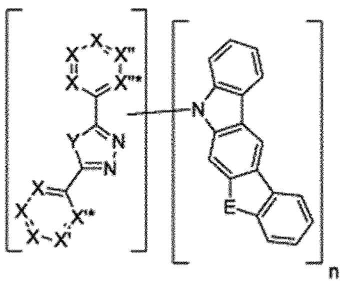

3-17

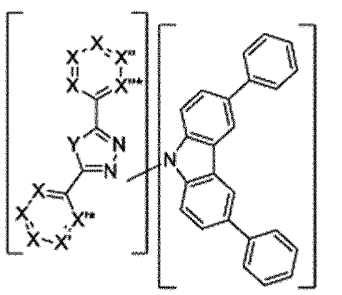

3-18

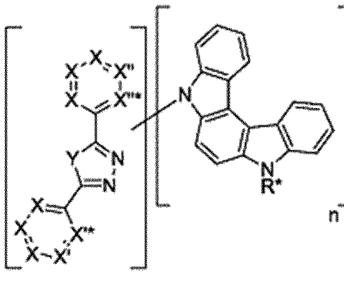

3-19

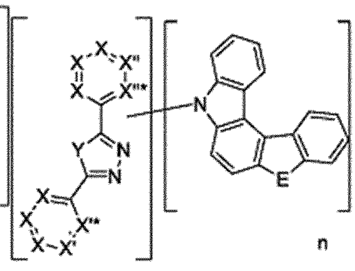

3-20

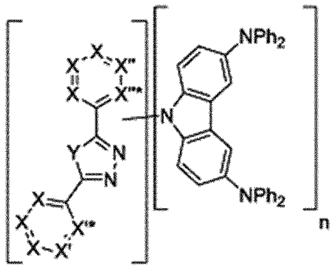

3-21

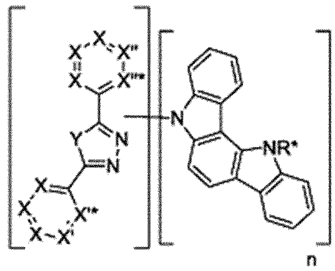

3-22

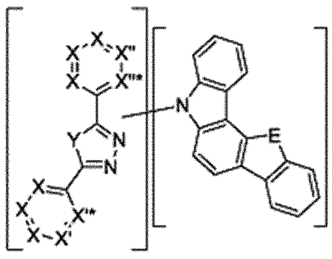

3-23

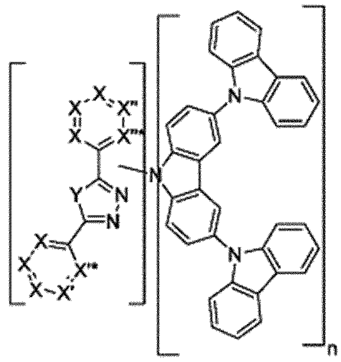

3-24

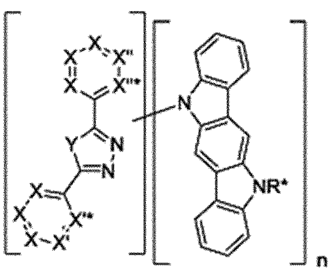

3-25

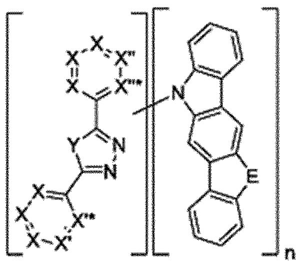

3-26

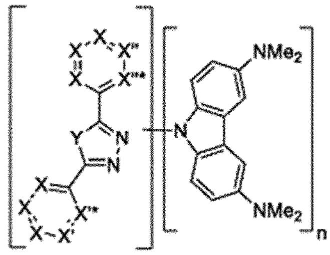

3-27

with E = O, S, Se, $CR_2$,
and where the definitions given in Claim 2 are otherwise applicable.

**4.** Organic molecule according to Claim 1, wherein the organic molecule is selected from one of the structures 4a or 4b:

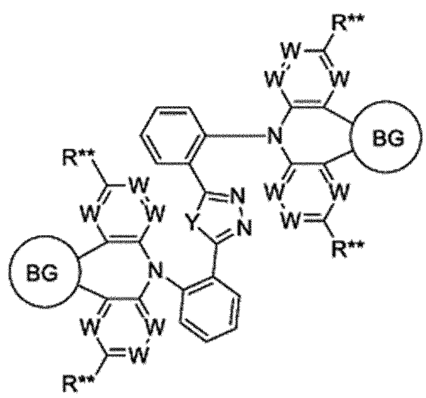

**Formula 4a**

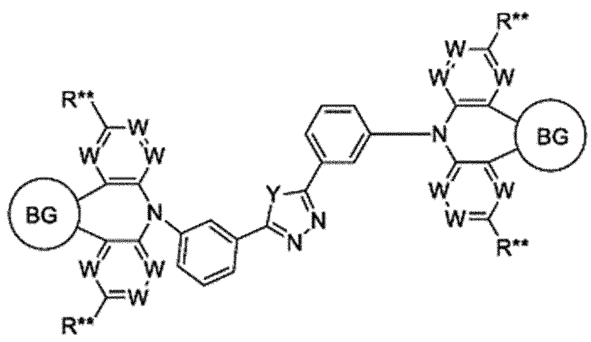

**Formula 4b**

where the optionally present bridge BG is independently selected from the group consisting of a single bond, $CR^*_2$, $CMe_2$, $CPh_2$, NPh, NMe, C=O, C=S, $SO_2$, O, S, $C_2H_4$, $C_2H_2$ and 1,2-phenylene;
and where, in the presence of a single bond BG, at least one R** radical is selected from an electron-rich radical such as t-butyl, methoxy, ethoxy, dimethylamine, diphenylamine, phenoxy, carbazole, phenoxazine, phenothiazine, phenazine and acridine;
and where the definitions given in Claim 1 are otherwise applicable.

**5.** Organic molecule according to Claim 1 or 4, wherein the organic molecule is selected from one of the structures 5a or 5b:

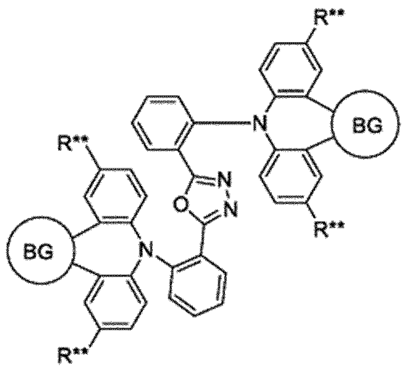

**Formula 5a**

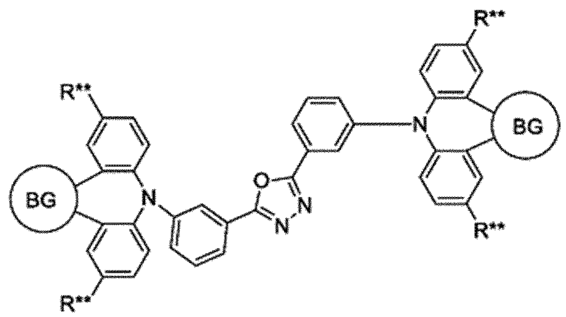

**Formula 5b**

and where the definitions given in Claim 1 and Claim 4 are applicable.

6. Organic molecule according to Claim 1, 4 or 5, wherein the organic molecule is selected from one of the structures 6a or 6b:

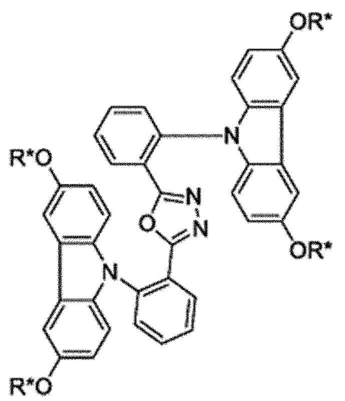

**Formula 6a**

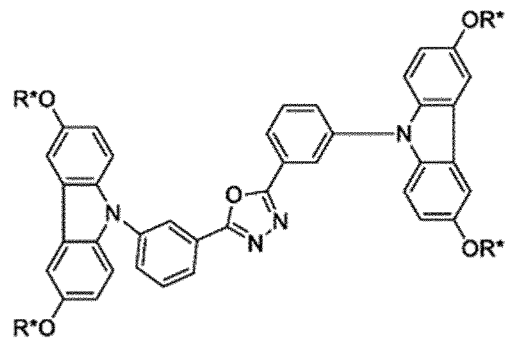

**Formula 6b**

and where the definitions given in Claim 1 are otherwise applicable;
and where R* is especially an alkyl radical.

7. Organic molecule according to Claims 1 to 6, wherein the organic molecule has at least one further R radical at at least one position, especially for enhancing solubility and/or polymerizability, where
R independently at each instance is selected from the group consisting of H, deuterium, phenyl, naphthyl, F, Cl, Br, I, $N(R^2)_2$, -CN, -NC, -SCN, $-CF_3$, $-NO_2$, -OH, C(=O)OH, $C(=O)OR^3$, $C(=O)N(R^3)_2$, $C(=O)SR^3$, $C(=S)SR^3$, $Si(R^4)_3$, $B(OR^5)_2$, $B(N(R^6)_2)_2$, $C(=O)R^3$, $P(=O)(R^7)_2$, $As(=O)(R^7)_2$, $P(=S)(R^7)_2$, $AS(=S)(R^7)_2$, $S(=O)R^3$, $S=NR^3$, $S(=O)NR^3$, $S(=O)_2NR^3$, $S(=O)^2R^3$, $O-S(=O)_2R^3$, $SF_5$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which may be substituted by one or more $R^9$ radicals, where one or more adjacent $CH_2$ groups may be replaced by $-R^9C=CR^9-$, -C=C-, or one adjacent $CH_2$ group by $-Si(R^4)_2-$, $-Ge(R^4)_2-$, $-Sn(R^4)_2$, - C(=O)-, -C(=S)-, -C(=Se)-, -C=N-, -C(=O)O-, $-C(=O)N(R^3)-$, $-P(=O)(R^7)-$, $-As(=O)(R^7)-$, - $P(=S)(R^7)-$, $-As(=S)(R^7)-$, -S(=O)-, $-S(=O)_2-$, $-NR^2-$, -O-, or -S-, and where one or more hydrogen atoms may be replaced by deuterium, F, Cl, Br, I, CN, $CF_3$ or $NO_2$, or an aromatic or heteroaromatic ring system which has 5 to 60 aromatic ring atoms and may be substituted in each case by one or more $R^2$ radicals, or an aryloxy or heteroaryloxy group which has 5 to 60 aromatic ring atoms and may be substituted by one or more $R^9$ radicals, or a diarylamino group, diheteroarylamino group or arylheteroarylamino group which has 10 to 40 aromatic ring atoms and may be substituted by one or more $R^9$ radicals, or a combination of these systems; at the same time, two or more of these R substituents together may also form a mono- or polycyclic, aliphatic, aromatic and/or benzofused ring system; where $R^2$ to $R^9$ are as defined in Claim 1; and where, by means of those radicals that bear polymerizable functional units that can be homopolymerized with themselves or copolymerized with other monomers,

the organic molecule is obtained as polymer having repeat units of the formulae 4 and/or 5

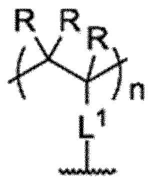

Formula 4

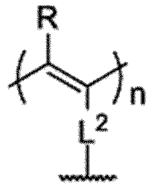

Formula 5

with
wavy line = position via which the linker group $L^1$ or $L^2$ is bonded to the organic molecule;
$L^1$ and $L^2$ = identical or different linker groups having from 0 to 20 carbon atoms; or having a - C(=O)O form;
and where, in particular, $L^1$ and $L^2$ = -X-$L^3$ with X = O or S;
$L^3$ = a further linker group selected from the group of a substituted and unsubstituted alkylene group (linear, branched or cyclic) and a substituted and unsubstituted arylene group, where combinations are also possible.

**8.** Use of an organic molecule according to Claims 1 to 7 as luminescent emitter and/or as host material and/or as electron transport material and/or as hole injection material and/or as hole blocker material in an optoelectronic component.

**9.** Use according to Claim 8, wherein the optoelectronic component is selected from the group consisting of:

- organic light-emitting diodes (OLEDs),
- light-emitting electrochemical cells,
- OLED sensors, especially in gas and vapour sensors that are not hermetically shielded from the outside,
- organic diodes,
- organic solar cells,
- organic transistor,
- organic field-effect transistors,
- organic lasers and
- down-conversion elements.

**10.** Use according to Claim 8 or 9, wherein the proportion of the organic molecule in the emitter is 1% to 99%.

**11.** Use according to Claims 8 to 10, wherein the concentration of the organic molecule as emitter in optical light-emitting components, especially in OLEDs, is between 5% and 80%.

**12.** Optoelectronic component including an organic molecule according to Claims 1 to 7, especially in the form of a component selected from the group consisting of organic light-emitting diode (OLED), light-emitting electrochemical cell, OLED sensor, especially in gas and vapour sensors that are not hermetically shielded from the outside, organic diode, organic solar cell, organic transistor, organic field-effect transistor, organic laser and down-conversion element.

**13.** Optoelectronic component according to Claim 12, including

- a substrate,
- an anode and
- a cathode, where the anode and the cathode have been applied to the substrate, and
- at least one light-emitting layer which is disposed between anode and cathode and which includes or consists of an organic molecule according to Claims 1 to 7.

**14.** Optoelectronic component according to Claim 13, in which the light-emitting layer includes at least one host material, where the excited singlet state ($S_1$) and/or the excited triplet state ($T_1$) of the at least one host material is higher than the excited singlet state ($S_1$) and/or the excited triplet state ($T_1$) of the organic molecule according to Claims 1 to 7.

**15.** Optoelectronic component according to Claims 12 to 14, including at least one host material consisting of a material

according to Claims 1 to 7.

**16.** Optoelectronic component according to Claims 12 to 15, wherein the light-emitting layer includes fluorescent or phosphorescent materials and wherein the materials in the light-emitting layer are organic molecules according to Claims 1 to 7.

**17.** Optoelectronic component according to Claim 16, in which an organic molecule according to Claims 1 to 7 together with a functional material forms an exciplex.

**18.** Optoelectronic component according to Claims 12 to 17, wherein the emission is **characterized by** thermally activated delayed fluorescence (TADF).

**19.** Optoelectronic component according to Claims 12 to 17, in which an organic molecule according to Claims 1 to 7 is used as charge transport material.

**20.** Process for producing an optoelectronic component, wherein an organic molecule according to Claims 1 to 7 is used.

**21.** Process according to Claim 20, wherein the organic molecule is processed by means of a vacuum evaporation process or from a solution.

## Revendications

**1.** Molécule organique, comportant une structure de formule 1

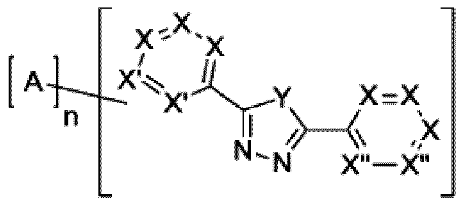

**Formule 1**

qui contient une structure partielle A de formule 1a

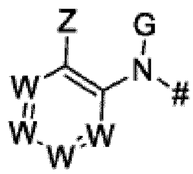

**Formule 1a**

où

n est un nombre entier valant de 1 à 4 ;
# indique par quelle position d'attachement la structure partielle A est liée à l'atome de carbone de C-A ;
Y représente O, S, Se ou NR* ;
X, X' et X" sont choisis chacun indépendamment dans le groupe constitué par N, CR* et C-A;
W est choisi chaque fois indépendamment dans le groupe constitué par N, CR* et CR**, au moins un radical CR** étant présent ;
Z représente un radical R*, R* en option ensemble avec G faisant partie d'un système cyclique à 5, 6, 7 ou 8 chaînons, condensé ou non condensé, choisi dans le groupe constitué par un groupe carbazole ou indole substitué par des radicaux riches en électrons, hydro-indole, hydrocarbazole, pyrrole, quinoléine, hydroquinoléine, azépine, benzoazépine, dibenzoazépine, hydroazépine, hydrobenzoazépine, hydrodibenzoazépine, tribenzoazépine, phénazine, indolocarbazole, indéno-indole, phénoxazine, phénothiazine ou dihydroacridine ;
G représente un radical R*, R* en option ensemble avec Z faisant partie d'un système cyclique à 5, 6, 7 ou 8 chaînons, condensé ou non condensé, choisi dans le groupe constitué par un groupe carbazole ou indole substitué par des radicaux riches en électrons, hydro-indole, hydrocarbazole, pyrrole, quinoléine, hydroquinoléine, azépine, benzoazépine, dibenzoazépine, hydroazépine, hydrobenzoazépine, hydrodibenzoazépine, tribenzoazépine, phénazine, indolocarbazole, indéno-indole, phénoxazine, phénothiazine ou dihydroacridine ;

et où il s'applique que

- lorsque n = 1 l'attachement de l'unité A s'effectue au niveau d'un X' ;
- lorsque n = 2 l'attachement d'au moins une unité A s'effectue au niveau d'un X' et qu'en particulier l'attachement de la deuxième unité A s'effectue au niveau d'un X" ;
- lorsque n = 3 l'attachement d'au moins une unité A s'effectue au niveau d'un X' et qu'en particulier l'attachement de la deuxième et troisième unité A s'effectue au niveau d'un X' ou X" ;
- lorsque n = 4 l'attachement d'au moins une unité A s'effectue au niveau d'un X' et qu'en particulier l'attachement de la deuxième, troisième et quatrième unité A s'effectue au niveau d'un X' ou X" ;

et où :

le radical R** est choisi indépendamment à chaque occurrence parmi un radical riche en électrons, tel qu'un groupe alkyle, méthoxy, éthoxy, phénoxy, alcoxy, $NR_2$, diphénylamino, amino, carbazole, indole, hydro-indole, hydrocarbazole, pyrrole, quinoléine, hydroquinoléine, azépine, benzoazépine, dibenzoazépine, hydroazépine, hydrobenzoazépine, hydrodibenzoazépine, tribenzoazépine, phénazine, indolocarbazole, indéno-indole, phénoxazine, phénothiazine ou dihydroacridine ou acridine ;
R* est choisi indépendamment à chaque occurrence dans le groupe constitué par H, le deutérium, les groupes phényle, naphtyle, $N(R^2)_2$, -CN, -NC, -SCN, $-CF_3$, $-NO_2$, C(=O)OH, $C(=O)OR^3$, $C(=O)N(R^3)_2$, $C(=O)SR^3$, $C(=S)SR^3$, $Si(R^4)_3$, $B(OR^5)_2$, $B(N(R^6)_2)_2$, $C(=O)R^3$, $P(=O)(R^7)_2$, $As(=O)(R^7)_2$, $P(=S)(R^7)_2$, $AS(=S)(R^7)_2$, $S(=O)R^3$, $S=NR^3$, $S(=O)NR^3$, $S(=O)^2NR^3$, $S(=O)_2R^3$, $O-S(=O)_2R^3$, $SF_5$, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux $R^9$, un ou plusieurs groupes $CH_2$ contigus pouvant être remplacés par - $R^9C=CR^9$-, -C°C-, ou un groupe $CH_2$ voisin pouvant être remplacé par $-Si(R^4)_2-$, $-Ge(R^4)_2-$, - $Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, ou -S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut dans chaque cas être substitué par un ou plusieurs radicaux $R^2$, ou un groupe aryloxy ou hétéroaryloxy ayant de 5 à 60 atomes formant le cycle aromatique, qui peut être substitué par un ou plusieurs radicaux $R^9$, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^9$, ou une combinaison de ces systèmes ; deux ou plus de deux de ces substituants R* peuvent en outre également former ensemble un système cyclique mono- ou polycyclique, aliphatique, aromatique et/ou soudé à un noyau benzénique ;
$R^2$ est choisi indépendamment à chaque occurrence dans le groupe constitué par H, le deutérium, les groupes phényle, naphtyle, $-CF_3$, $C(=O)OR^3$, $C(=O)N(R^3)_2$, $Si(R^4)_3$, $C(=O)R^3$, $P(=O)(R^7)_2$, $AS(=O)(R^7)_2$, $P(=S)(R^7)_2$, $AS(=S)(R^7)_2$, $S(=O)R^3$, $S(=O)_2R^3$, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux $R^9$, un ou plusieurs groupes $CH_2$ contigus pouvant être remplacés par $-R^9C=CR^9-$, -C°C-, ou un groupe $CH_2$ voisin pouvant être remplacé par $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$ $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, ou -S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut dans chaque cas être substitué par un ou plusieurs radicaux $R^9$, ou un groupe aryloxy ou hétéroaryloxy ayant de 5 à 60 atomes formant le cycle aromatique, qui peut être substitué par un ou plusieurs radicaux $R^9$, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^9$, ou une combinaison de ces systèmes ; deux ou plus de deux de ces substituants $R^2$ peuvent en outre également former ensemble un système cyclique mono- ou polycyclique, aliphatique,

aromatique et/ou soudé à un noyau benzénique ;

$R^3$ est choisi indépendamment à chaque occurrence dans le groupe constitué par H, le deutérium, les groupes phényle, naphtyle, $CF_3$ ou un radical hydrocarboné aliphatique, aromatique et/ou hétéroaromatique ayant de 1 à 20 atomes de carbone, dans lequel un ou plusieurs atomes d'hydrogène peuvent également être remplacés par F ou $CF_3$; deux ou plus de deux de ces substituants $R^3$ peuvent en outre également former ensemble un système cyclique mono- ou polycyclique, aliphatique ;

$R^4$ est choisi indépendamment à chaque occurrence dans le groupe constitué par H, le deutérium, les groupes phényle, naphtyle, $N(R^2)_2$, CN, $CF_3$, OH, $C(=O)OR^3$, $C(=O)N(R^3)_2$, $C(=O)R^3$, $P(=O)(R^7)_2$, $As(=O)(R^7)_2$, $P(=S)(R^7)_2$, $AS(=S)(R^7)_2$, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux $R^9$, un ou plusieurs groupes $CH_2$ contigus pouvant être remplacés par $-R^9C=CR^9-$, -C°C-, ou un groupe $CH_2$ voisin pouvant être remplacé par $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, ou -S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut dans chaque cas être substitué par un ou plusieurs radicaux $R^8$, ou un groupe aryloxy ou hétéroaryloxy ayant de 5 à 60 atomes formant le cycle aromatique, qui peut être substitué par un ou plusieurs radicaux $R^9$, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^9$, ou une combinaison de ces systèmes ; deux ou plus de deux de ces substituants $R^4$ peuvent en outre également former ensemble un système cyclique mono- ou polycyclique, aliphatique, aromatique et/ou soudé à un noyau benzénique ;

$R^5$ est choisi indépendamment à chaque occurrence dans le groupe constitué par les groupes phényle, naphtyle, $CF_3$, $C(=O)R^3$, $P(=O)(R^7)_2$, $As(=O)(R^7)_2$, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux $R^9$, un ou plusieurs groupes $CH_2$ contigus pouvant être remplacés par $-R^9C=CR^9-$, -C°C-, ou un groupe $CH_2$ voisin pouvant être remplacé par $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, ou -S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut dans chaque cas être substitué par un ou plusieurs radicaux $R^9$, ou un groupe aryloxy ou hétéroaryloxy ayant de 5 à 60 atomes formant le cycle aromatique, qui peut être substitué par un ou plusieurs radicaux $R^9$, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^9$, ou une combinaison de ces systèmes ; deux ou plus de deux de ces substituants $R^5$ peuvent en outre également former ensemble un système cyclique mono- ou polycyclique, aliphatique, aromatique et/ou soudé à un noyau benzénique ;

$R^6$ est choisi indépendamment à chaque occurrence dans le groupe constitué par les groupes phényle, naphtyle, $CF_3$, $Si(R^4)_3$, $C(=O)R^3$, $P(=O)(R^7)_2$, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux $R^9$, un ou plusieurs groupes $CH_2$ contigus pouvant être remplacés par $-R^9C=CR^9-$, -C°C-, ou un groupe $CH_2$ voisin pouvant être remplacé par $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, ou -S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut dans chaque cas être substitué par un ou plusieurs radicaux $R^9$, ou un groupe aryloxy ou hétéroaryloxy ayant de 5 à 60 atomes formant le cycle aromatique, qui peut être substitué par un ou plusieurs radicaux R*, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^9$, ou une combinaison de ces systèmes ; deux ou plus de deux de ces substituants $R^6$ peuvent en outre également former ensemble un système cyclique mono- ou polycyclique, aliphatique, aromatique et/ou soudé à un noyau benzénique ;

$R^7$ est choisi indépendamment à chaque occurrence dans le groupe constitué par les groupes phényle, naphtyle, $N(R^2)_2$, CN, $CF_3$, $C(=O)OR^3$, $C(=O)N(R^3)_2$, $Si(R^4)_3$, $C(=O)R^3$, un groupe alkyle, alcoxy ou thioalcoxy linéaire ayant de 1 à 40 atomes de carbone ou un groupe alcényle ou alcynyle linéaire ayant de 2 à 40 atomes de

carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux $R^9$, un ou plusieurs groupes $CH_2$ contigus pouvant être remplacés par $-R^9C=CR^9-$, -C°C-, ou un groupe $CH_2$ voisin pouvant être remplacé par $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, ou -S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut dans chaque cas être substitué par un ou plusieurs radicaux $R^9$, ou un groupe aryloxy ou hétéroaryloxy ayant de 5 à 60 atomes formant le cycle aromatique, qui peut être substitué par un ou plusieurs radicaux $R^9$, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^3$, ou une combinaison de ces systèmes ; deux ou plus de deux de ces substituants $R^7$ peuvent en outre également former ensemble un système cyclique mono- ou polycyclique, aliphatique, aromatique et/ou soudé à un noyau benzénique ;
$R^8$ est choisi indépendamment à chaque occurrence dans le groupe constitué par H, le deutérium, les groupes phényle, naphtyle, F, $CF_3$, ou un radical hydrocarboné aliphatique, aromatique et/ou hétéroaromatique ayant de 1 à 20 atomes de carbone, dans lequel un ou plusieurs atomes d'hydrogène peuvent également être remplacés par F ou $CF_3$; deux ou plus de deux de ces substituants $R^8$ peuvent en outre également former ensemble un système cyclique mono- ou polycyclique, aliphatique ;
$R^9$ est choisi indépendamment à chaque occurrence dans le groupe constitué par H, le deutérium, les groupes phényle, naphtyle, $N(R^2)_2$, CN, $CF_3$, $NO_2$, OH, COOH, $C(=O)OR^3$ $C(=O)N(R^3)_2$, $Si(R^4)_3$, $B(OR^5)_2$, $C(=O)R^3$, $P(=O)(R^7)_2$, $P(=S)(R^7)_2$, $AS(=O)(R^7)_2$, $P(=S)(R^7)_2$, $S(=O)R^3$, $S(=O)_2R^3$, $OSO_2R^3$, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux $R^8$, un ou plusieurs groupes $CH_2$ non contigus pouvant être remplacés par $-R^3C=CR^3-$, -C°C-, ou un groupe $CH_2$ voisin pouvant être remplacé par $-Si(R^4)_2-$, $-Ge(R^4)_2-$, - $Sn(R^4)_2$, -C(=O)-, -C(=S)-, -C(=Se)-, -C=N-, -C(=O)O-, $-C(=O)N(R^3)-$, $-P(=O)(R^7)-$, - $As(=O)(R^7)-$, $-P(=S)(R^7)-$, $-As(=S)(R^7)-$, -S(=O)-, $-S(=O)_2-$, $-NR^2-$, -O-, ou -S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut dans chaque cas être substitué par un ou plusieurs radicaux $R^8$, ou un groupe aryloxy ou hétéroaryloxy ayant de 5 à 60 atomes formant le cycle aromatique, qui peut être substitué par un ou plusieurs radicaux $R^3$, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^8$, ou une combinaison de ces systèmes ; deux ou plus de deux de ces substituants $R^9$ peuvent en outre également former ensemble un système cyclique mono- ou polycyclique, aliphatique, aromatique et/ou soudé à un noyau benzénique ;

2. Molécule organique selon la revendication 1, où la molécule organique est choisie parmi une structure de formule 2

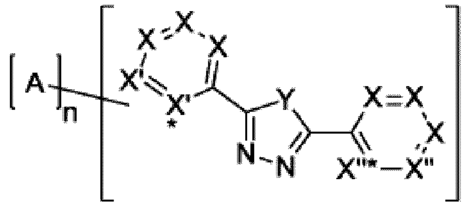

**Formule 2**

où l'attachement d'une unité A s'effectue au niveau de X'* ;
et où dans le cas de n > 1 l'attachement d'une deuxième unité A s'effectue au niveau de X"* ;
et où quant au reste s'appliquent les définitions indiquées dans la revendication 1.

3. Molécule organique selon la revendication 2, dans laquelle Z et G font partie d'un système cyclique à 5, 6, 7 ou 8 chaînons, qui est substitué par des radicaux riches en électrons, en particulier par alkyle, méthoxy, éthoxy, phénoxy, alcoxy, $NR_2$, diphénylamino, amino, carbazole, indole, hydro-indole, hydrocarbazole, pyrrole, quinoléine, hydroquinoléine, azépine, benzoazépine, dibenzoazépine, hydroazépine, hydrobenzoazépine, hydrodibenzoazépine, tribenzoazépine, phénazine, indolocarbazole, indéno-indole, phénoxazine, phénothiazine ou dihydroacridine ou acridine et de sorte qu'il en résulte les structures 3-1 à 3-27 :

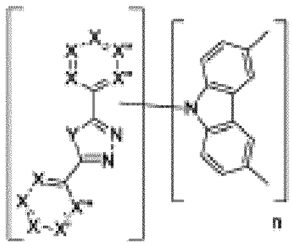

3-1

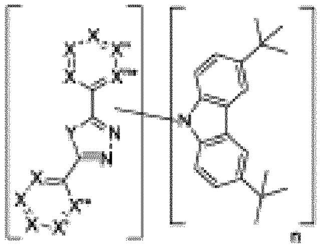

3-2

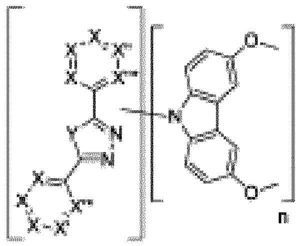

3-3

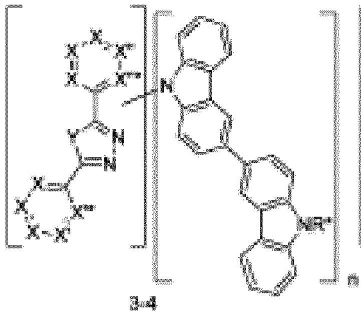

3-4

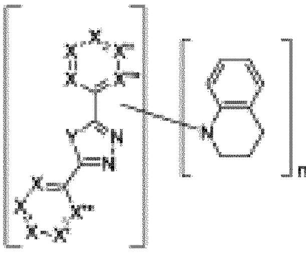

3-5

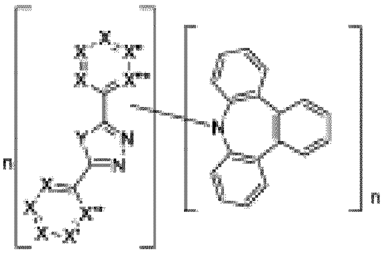

3-6

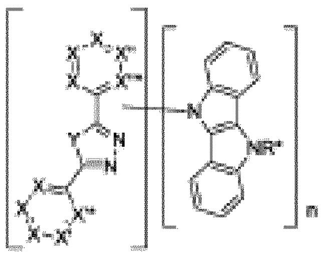

3-7

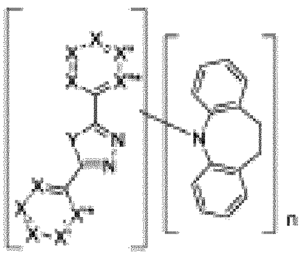

3-8

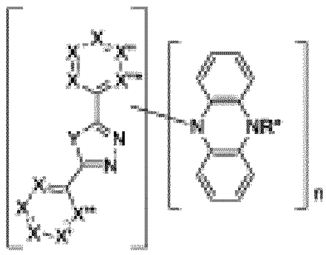

3-9

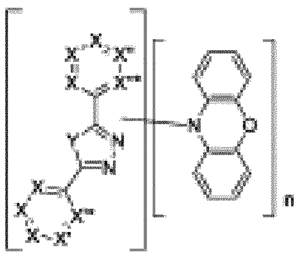

3-10

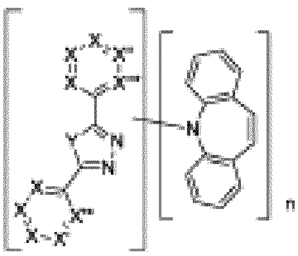

3-11

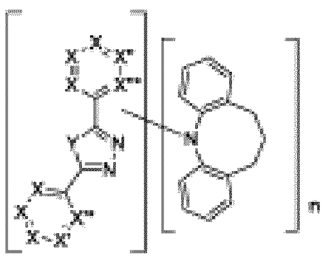

3-12

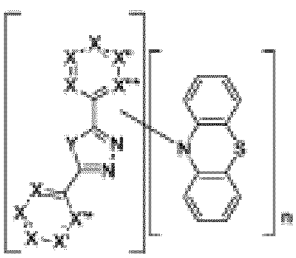

3-13

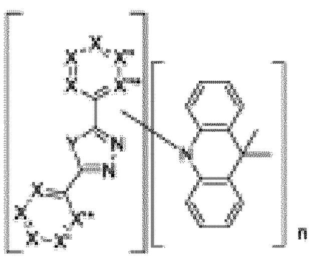

3-14

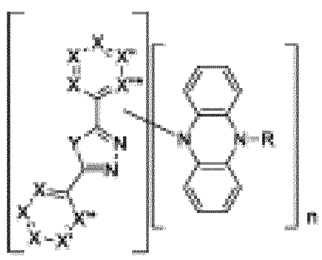

3-15

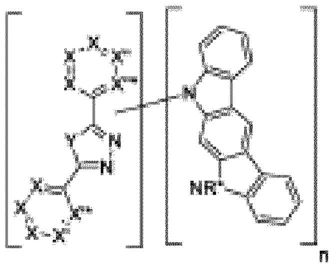

3-16

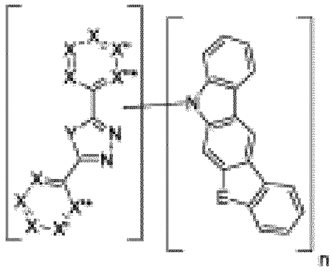

3-17

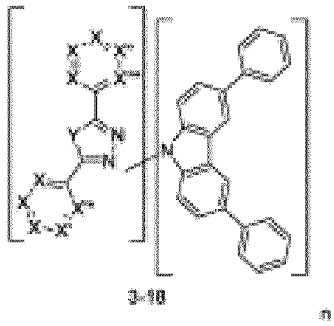

3-18

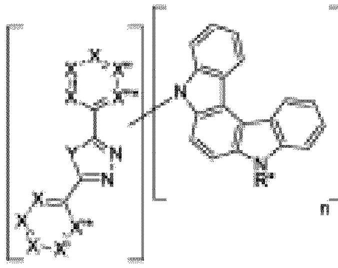

3-19

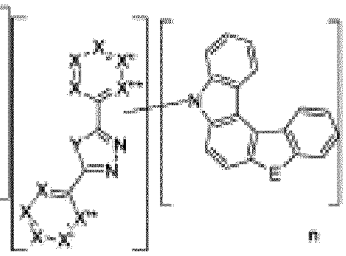

3-20

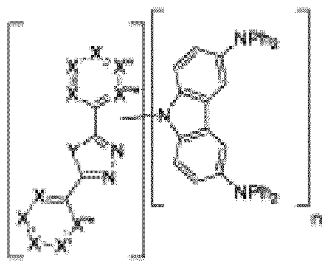

3-21

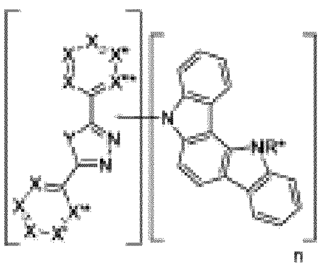

3-22

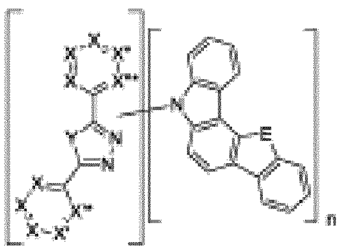

3-23

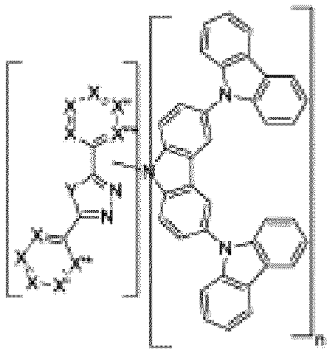

3-24

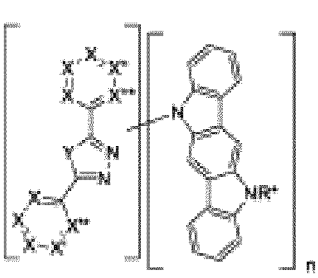

3-25

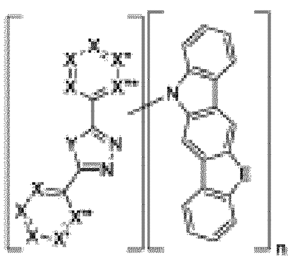

3-26

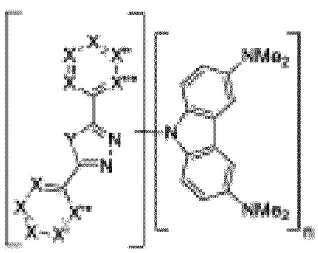

3-27

où E = O, S, Se, $CR_2$
et où quant au reste s'appliquent les définitions indiquées dans la revendication 2.

**4.** Molécule organique selon la revendication 1, où la molécule organique est choisie parmi l'une des structures 4a ou 4b :

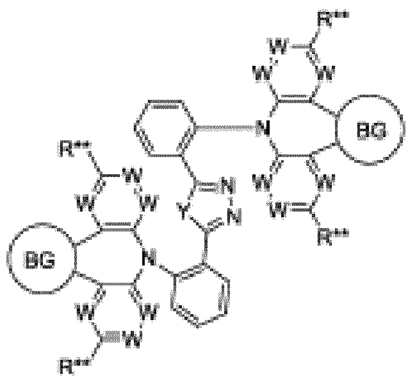

**Formule 4a**

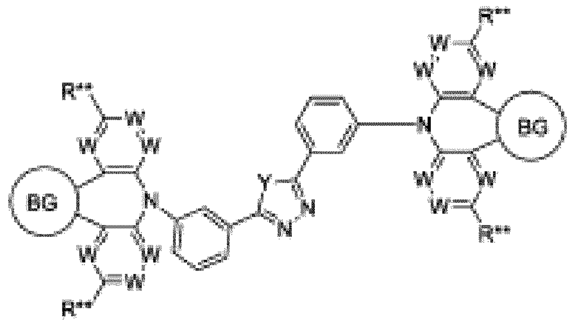

**Formule 4b**

où le pont BG présent en option est choisi chaque fois indépendamment dans le groupe constitué par une simple liaison, $CR^*_2$, $CMe_2$, $CPh_2$, NPh, NMe, C=O, C=S, $SO_2$, O, S, $C_2H_4$, $C_2H_2$ et 1,2-phénylène ;
et où en cas de présence d'une simple liaison BG, au moins un radical R** est choisi parmi un radical riche en électrons, tel que tert-butyle, méthoxy, éthoxy, diméthylamino, diphénylamino, phénoxy, carbazole, phénoxazine, phénothiazine, phénazine et acridine ;
et où quant au reste s'appliquent les définitions indiquées dans la revendication 1.

**5.** Molécule organique selon la revendication 1 ou 4, où la molécule organique est choisie parmi l'une des structures 5a ou 5b :

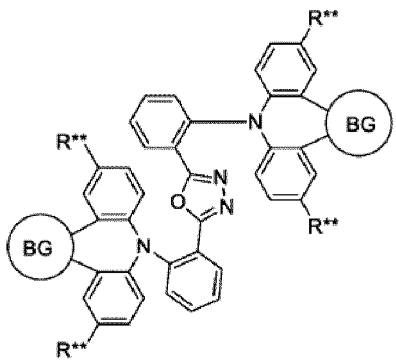

**Formule 5a**

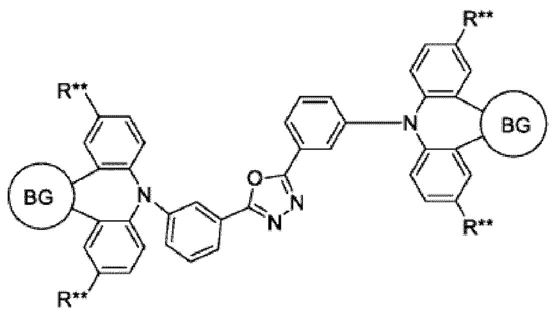

**Formule 5b**

et où s'appliquent les définitions indiquées dans la revendication 1 et la revendication 4.

**6.** Molécule organique selon la revendication 1, 4 ou 5, où la molécule organique est choisie parmi l'une des structures 6a ou 6b :

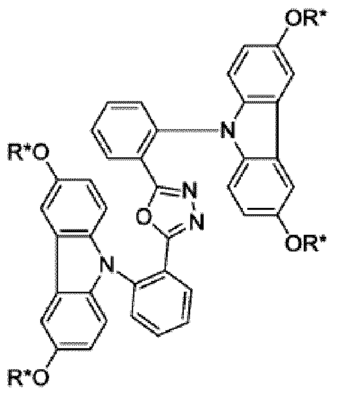

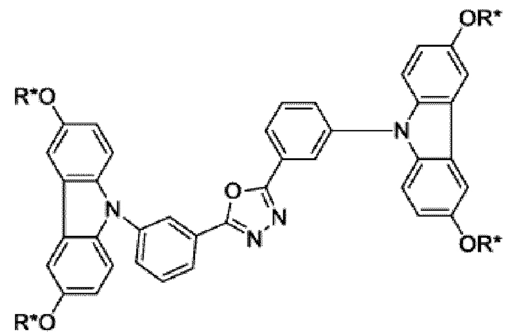

**Formule 6a** **Formule 6b**

et où quant au reste s'appliquent les définitions indiquées dans la revendication 1 ;
et où R* est en particulier un radical alkyle.

**7.** Molécule organique selon l'une quelconque des revendications 1 à 6, où la molécule organique présente en au moins une position au moins un autre radical R, en particulier pour l'augmentation de la solubilité et/ou de l'aptitude à la polymérisation, où
R est choisi indépendamment à chaque occurrence dans le groupe constitué par H, le deutérium, les groupes phényle, naphtyle, F, Cl, Br, I, $N(R^2)_2$, -CN, -NC, -SCN, $-CF_3$,$-NO_2$, -OH, C(=O)OH, $C(=O)OR^3$, $C(=O)N(R^3)_2$, $C(=O)SR^3$, $C(=S)SR^3$, $Si(R^4)_3$, $B(OR^5)_2$, $B(N(R^6)_2)_2$, $C(=O)R^3$, $P(=O)(R^7)_2$, $As(=O)(R^7)_2$, $P(=S)(R^7)_2$, $As(=S)(R^7)_2$, $S(=O)R^3$, $S=NR^3$, $S(=O)NR^3$, $S(=O)_2NR^3$, $S(=O)_2R^3$, $O-S(=O)_2R^3$, $SF_5$, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux $R^9$, un ou plusieurs groupes $CH_2$ contigus pouvant être remplacés par $-R^9C=CR^9-$, -C°C-, ou un groupe $CH_2$ voisin pouvant être remplacé par $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, ou -S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut dans chaque cas être substitué par un ou plusieurs radicaux $R^2$, ou un groupe aryloxy ou hétéroaryloxy ayant de 5 à 60 atomes formant le cycle aromatique, qui peut être substitué par un ou plusieurs radicaux $R^9$, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^9$, ou une combinaison de ces systèmes ; deux ou plus de deux de ces substituants R peuvent en outre également former ensemble un système cyclique mono- ou polycyclique, aliphatique, aromatique et/ou soudé à un noyau benzénique ; $R^2$ à $R^9$ étant tels que définis dans la revendication 1 ;
et où au moyen de tels radicaux qui portent des unités fonctionnelles aptes à la polymérisation, qui peuvent être homopolymérisés avec eux-mêmes ou copolymérisés avec d'autres monomères, on obtient la molécule organique sous forme de polymère à motifs répétitifs selon la formule 4 et/ou la formule 5

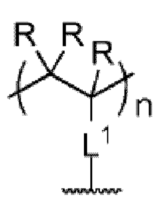

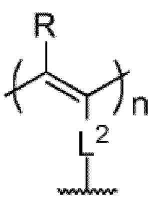

**Formule 4** **Formule 5**

où
trait ondulé = position par laquelle le groupe de liaison $L^1$ ou $L^2$ est attaché à la molécule organique ;
$L^1$ et $L^2$ = des groupes de liaison identiques ou différents, comportant entre 0 et 20 atomes de carbone ; ou présentant une forme -C(C=O)O ;

et où en particulier $L^1$ et $L^2$ = -X-$L^3$ où X = O ou S ;
$L^3$ = un autre groupe de liaison choisi dans le groupe constitué par un groupe alkylène substitué et un groupe alkylène non substitué (linéaires, ramifiés ou cycliques) et un groupe arylène substitué et un groupe arylène non substitué, des associations étant également possibles.

**8.** Utilisation d'une molécule organique selon l'une quelconque des revendications 1 à 7 en tant qu'émetteur luminescent et/ou en tant que matériau hôte et/ou en tant que matériau transporteur d'électrons et/ou en tant que matériau d'injection de trous et/ou en tant que matériau de blocage de trous dans un composant optoélectronique.

**9.** Utilisation selon la revendication 8, dans laquelle le composant optoélectronique est choisi dans le groupe constitué par :

- des diodes électroluminescentes organiques (OLED),
- des cellules électrochimiques photoémettrices,
- des capteurs OLED, en particulier dans des capteurs de gaz et de vapeur non isolés hermétiquement de l'extérieur,
- des diodes organiques,
- des cellules solaires organiques,
- des transistors organiques,
- des transistors à effet de champ organiques,
- des lasers organiques et
- des éléments d'abaissement de fréquence.

**10.** Utilisation selon la revendication 8 ou 9, dans laquelle la proportion de la molécule organique dans l'émetteur vaut de 1 % à 99 %.

**11.** Utilisation selon l'une quelconque des revendications 8 à 10, dans laquelle la concentration de la molécule organique en tant qu'émetteur dans des composants luminescents optiques, en particulier dans des OLED, est comprise entre 5 % et 80 %.

**12.** Composant optoélectronique, comportant une molécule organique selon l'une quelconque des revendications 1 à 7, en particulier configuré sous forme d'un composant choisi dans le groupe constitué par des diodes électroluminescentes organiques (OLED), une cellule électrochimique photoémettrice, un capteur OLED, en particulier dans des capteurs de gaz et de vapeur non isolés hermétiquement de l'extérieur, des diodes organiques, une cellule solaire organique, un transistor organique, un transistor à effet de champ organique, un laser organique et un élément d'abaissement de fréquence.

**13.** Composant optoélectronique selon la revendication 12, comportant

- un substrat,
- une anode et
- une cathode, l'anode et la cathode étant appliquées sur le substrat, et
- au moins une couche photoémettrice qui est disposée entre l'anode et la cathode et qui comporte ou consiste en une molécule organique selon l'une quelconque des revendications 1 à 7.

**14.** Composant optoélectronique selon la revendication 13, dans lequel la couche photoémettrice comporte au moins un matériau hôte, où en particulier l'état singulet excité ($S_1$) et/ou l'état triplet excité ($T_1$) dudit au moins un matériau hôte est plus élevé que l'état singulet excité ($S_1$) et/ou que l'état triplet excité ($T_1$) de la molécule organique selon l'une quelconque des revendications 1 à 7.

**15.** Composant optoélectronique selon l'une quelconque des revendications 12 à 14, comportant au moins un matériau hôte consistant en un matériau selon l'une quelconque des revendications 1 à 7.

**16.** Composant optoélectronique selon l'une quelconque des revendications 12 à 15, dans lequel la couche photoémettrice comporte des matériaux fluorescents ou phosphorescents et dans lequel pour ce qui est des matériaux de la couche photoémettrice il s'agit de molécules organiques selon l'une quelconque des revendications 1 à 7.

**17.** Composant optoélectronique selon la revendication 16, dans lequel une molécule organique selon l'une quelconque

des revendications 1 à 7 forme conjointement avec un matériau fonctionnel un exciplexe.

**18.** Composant optoélectronique selon l'une quelconque des revendications 12 à 17, dans lequel l'émission est **caractérisée par** une fluorescence retardée activée thermiquement (TADF).

**19.** Composant optoélectronique selon l'une quelconque des revendications 12 à 17, dans lequel une molécule organique selon l'une quelconque des revendications 1 à 7 est utilisée en tant que couche de transport de charge.

**20.** Procédé pour la production d'un composant optoélectronique, dans lequel on utilise une molécule organique selon l'une quelconque des revendications 1 à 7.

**21.** Procédé selon la revendication 20, dans lequel on effectue la mise en oeuvre de la molécule organique par un procédé de dépôt sous vide en phase vapeur ou à partir d'une solution.

Figur 1

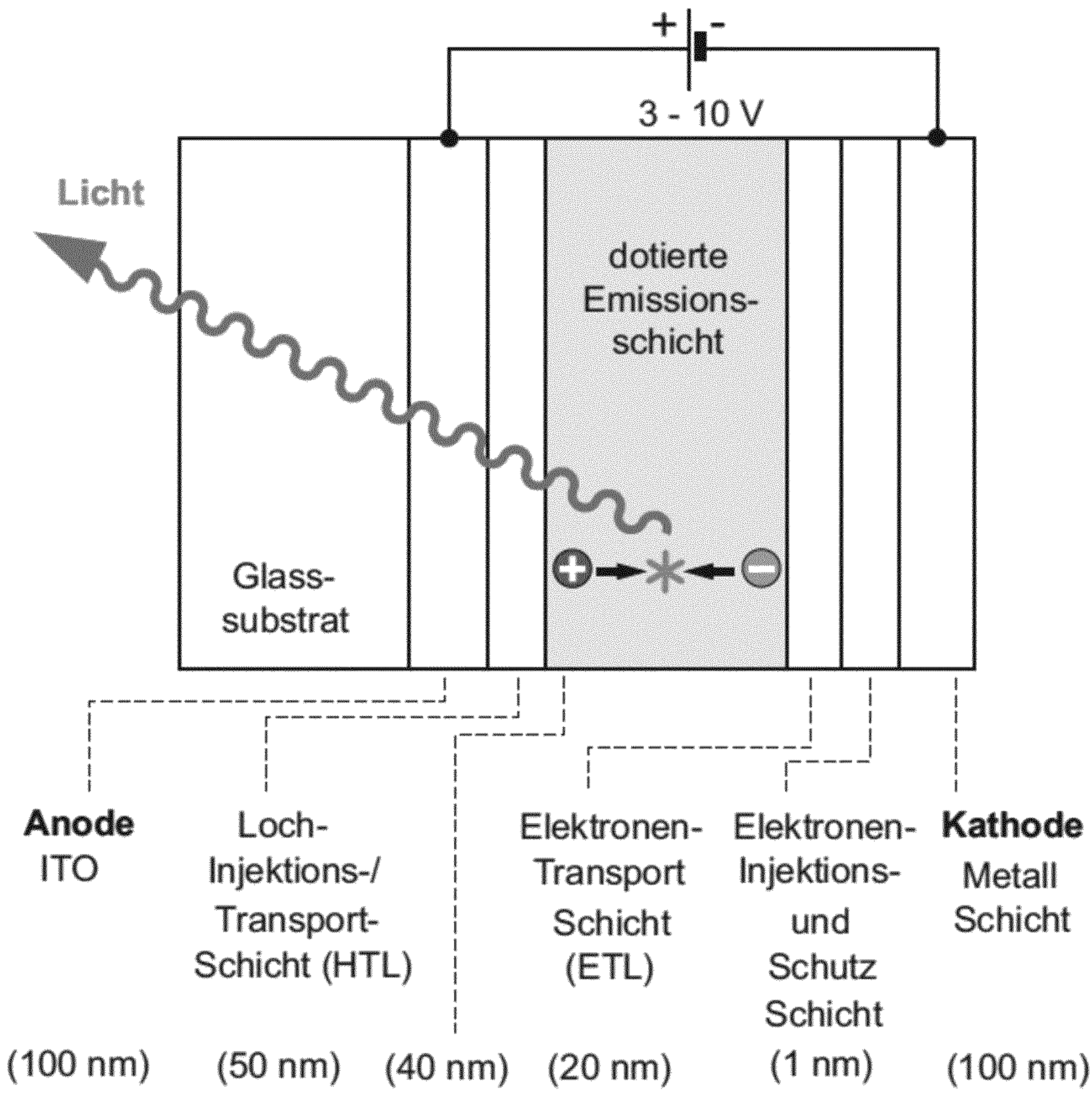
+ -
3 - 10 V
Licht
dotierte Emissions-schicht
Glass-substrat
Anode ITO (100 nm)
Loch-Injektions-/ Transport-Schicht (HTL) (50 nm)
(40 nm)
Elektronen-Transport Schicht (ETL) (20 nm)
Elektronen-Injektions- und Schutz Schicht (1 nm)
Kathode Metall Schicht (100 nm)

Figur 2

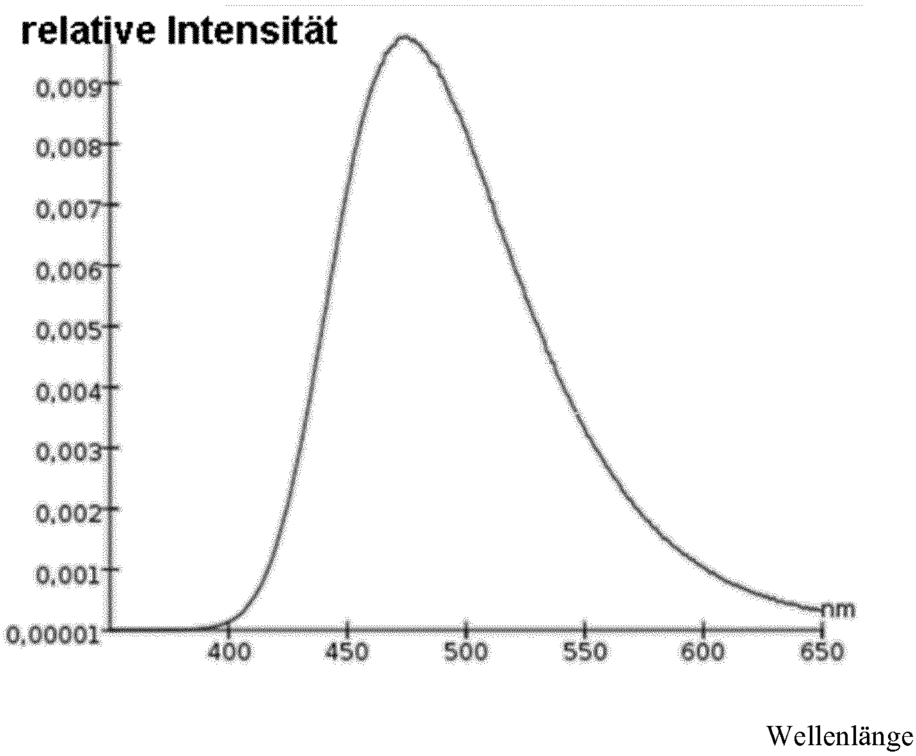


Figur 3

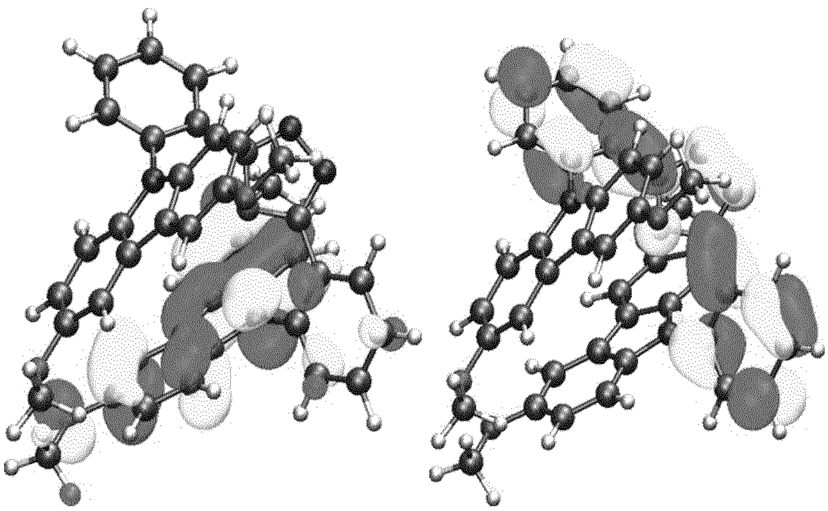

HOMO LUMO

| Beispiel | HOMO-Bild | LUMO-Bild |
|---|---|---|
| 3 | 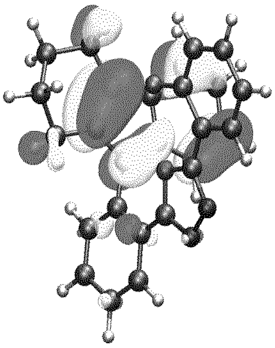 | 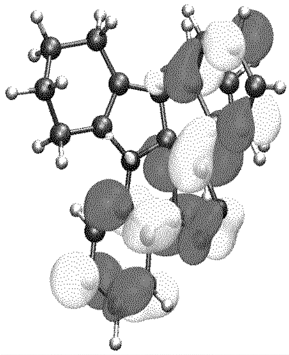 |
| 4 | 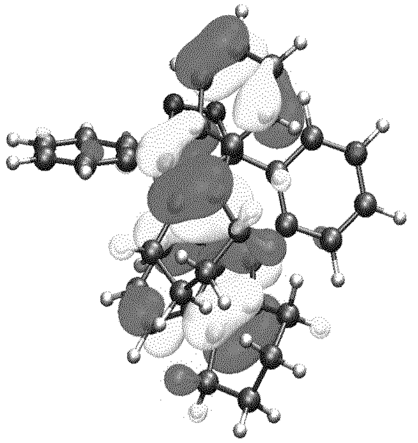 | 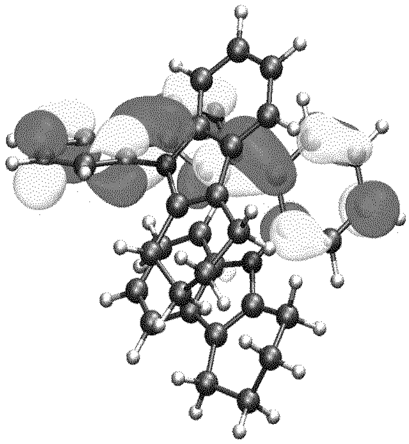 |
| 5 | 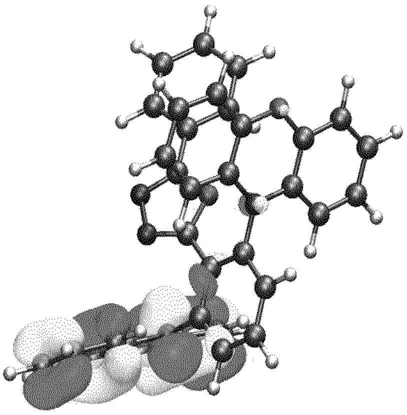 | 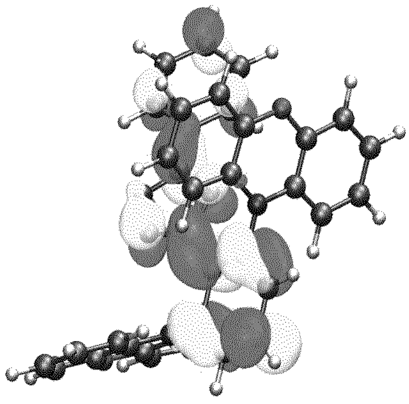 |
| 6 | 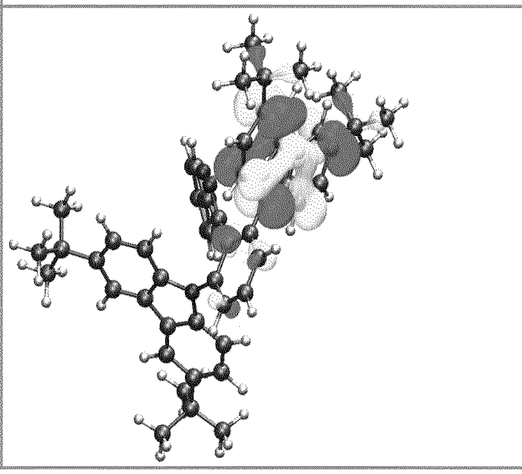 | 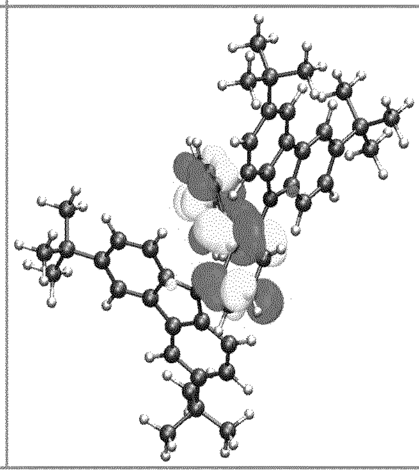 |

| | | |
|---|---|---|
| 7 | 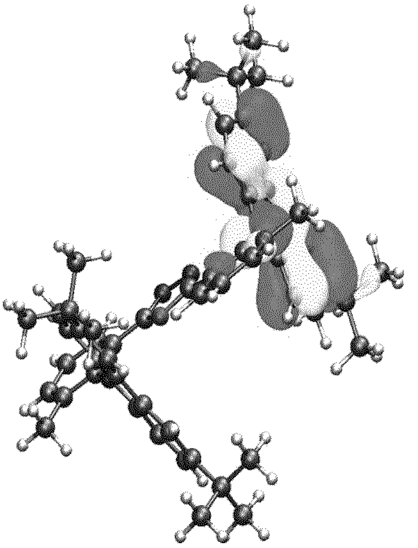 | 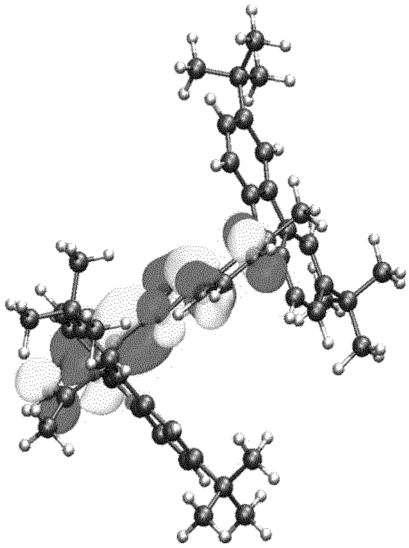 |
| 8 | 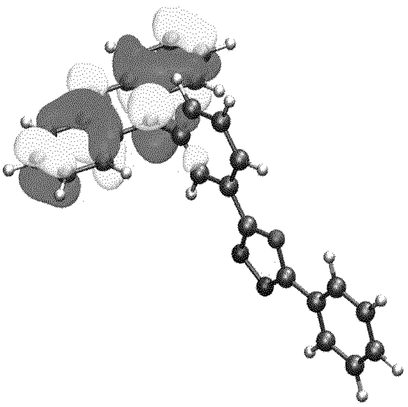 | 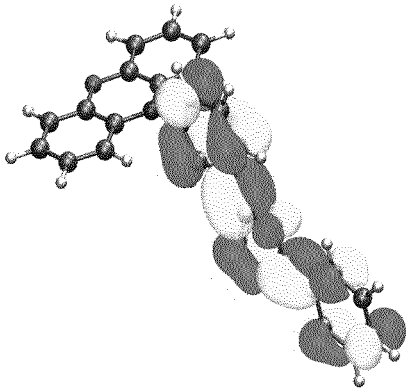 |
| 9 | 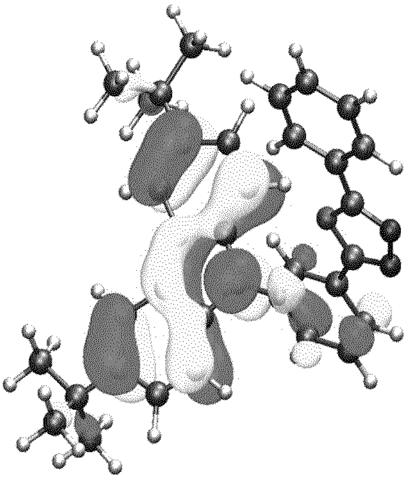 | 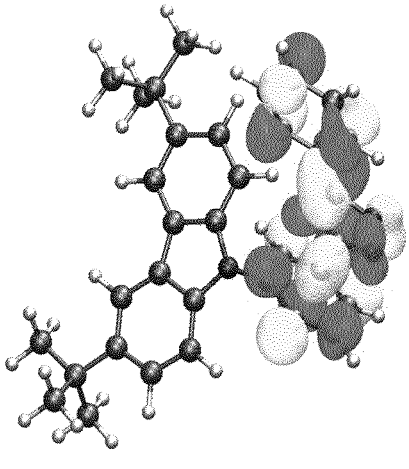 |

| | | |
|---|---|---|
| 10 | 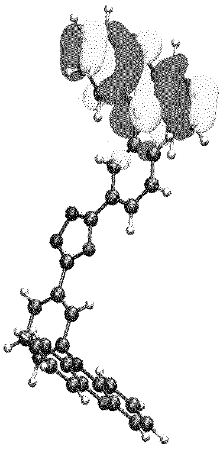 | 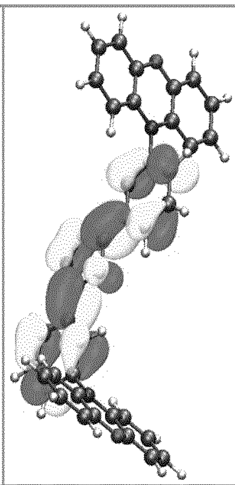 |
| 11 | 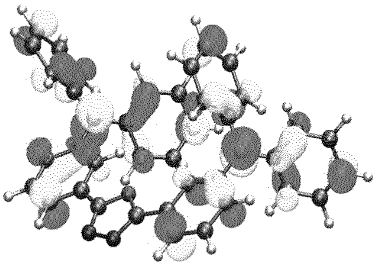 | 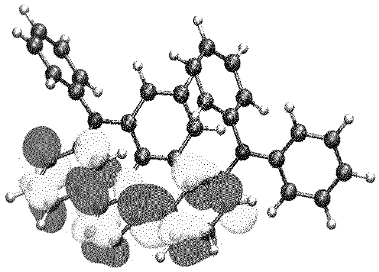 |
| 12 | 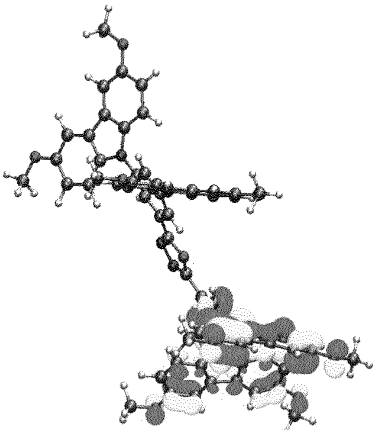 | 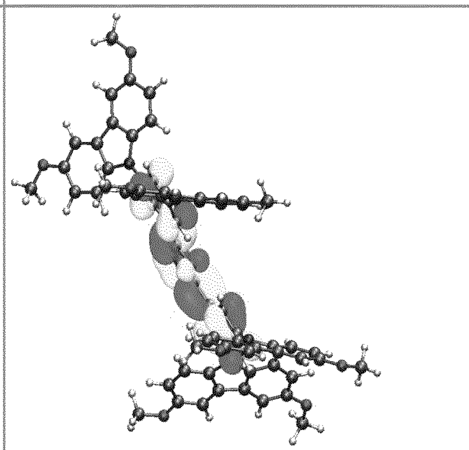 |
| 13 | 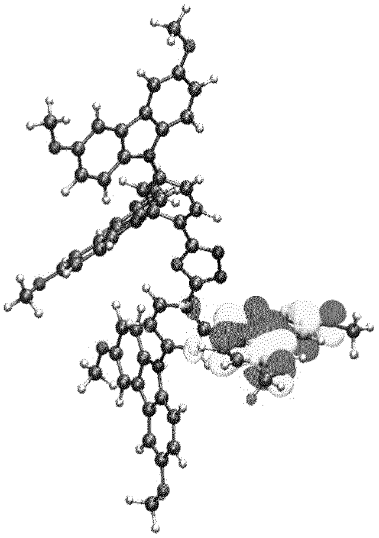 | 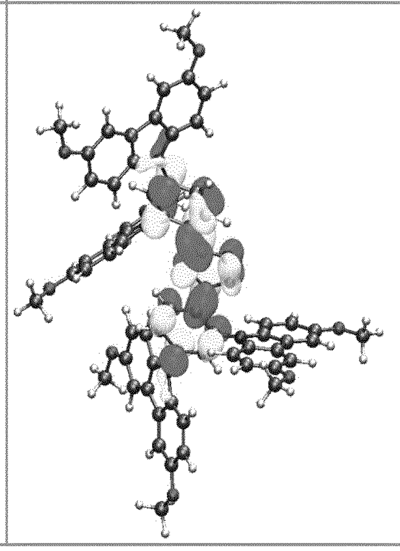 |

| | | |
|---|---|---|
| 14 | 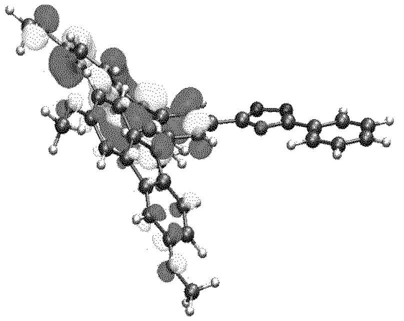 | 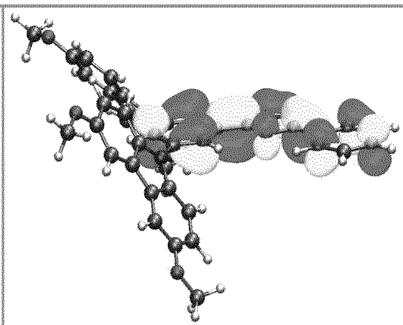 |
| 15 | 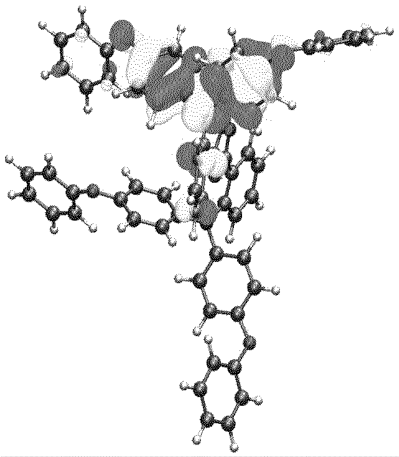 | 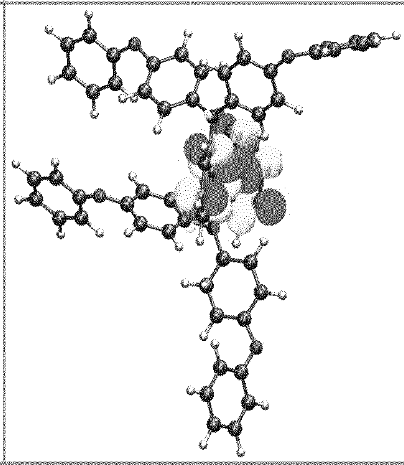 |
| 16 | 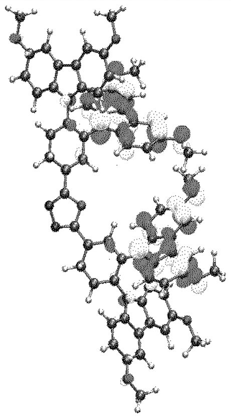 | 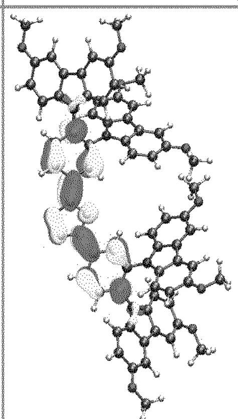 |
| 17 | 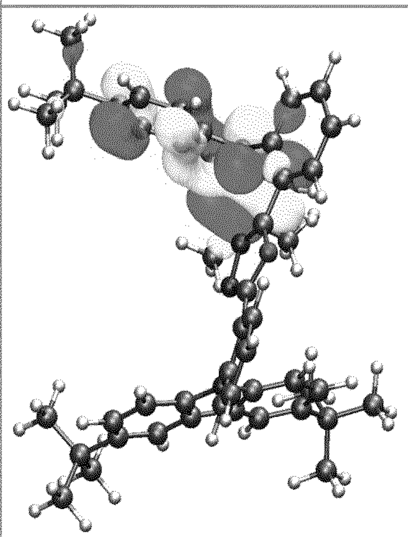 | 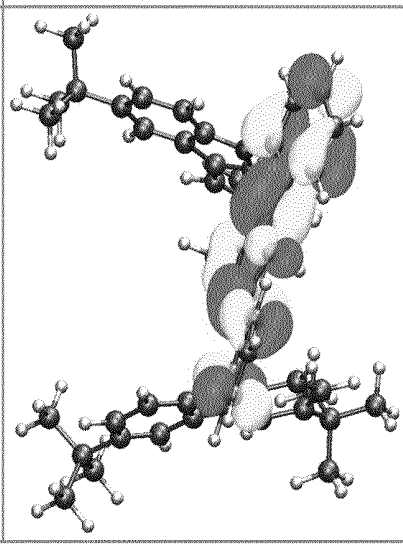 |

| | | |
|---|---|---|
| 18 | 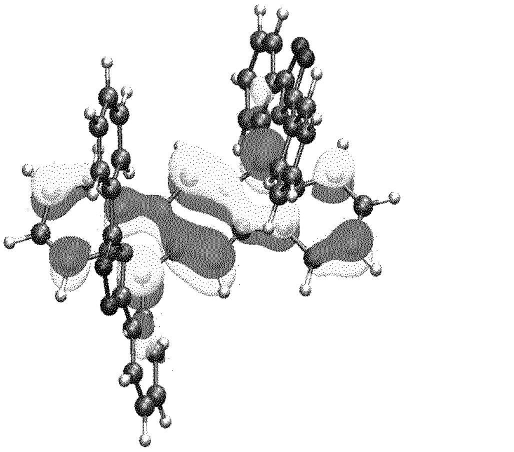 | 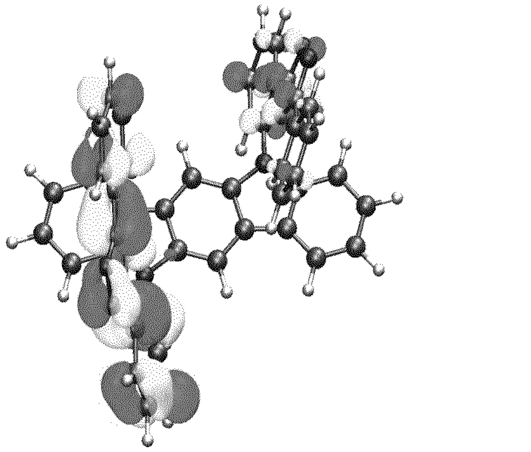 |
| 19 | 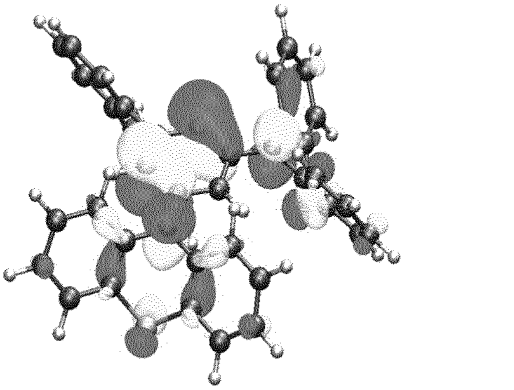 | 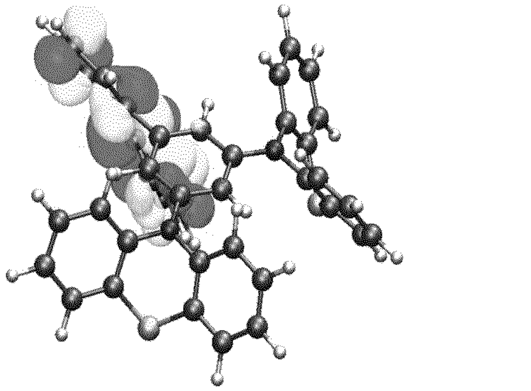 |
| 20 | 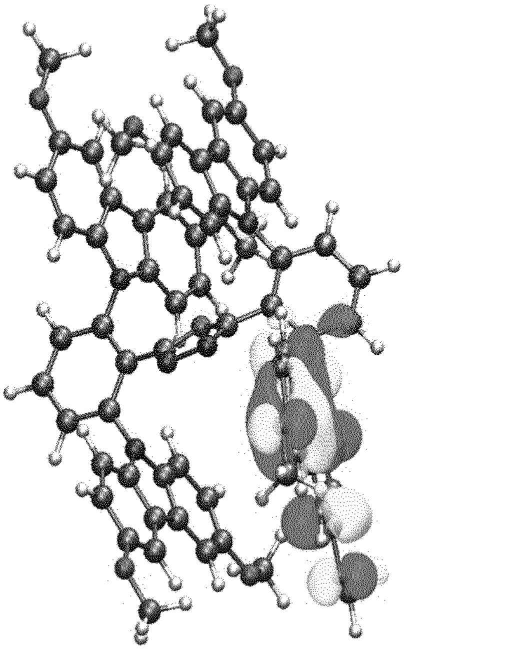 | 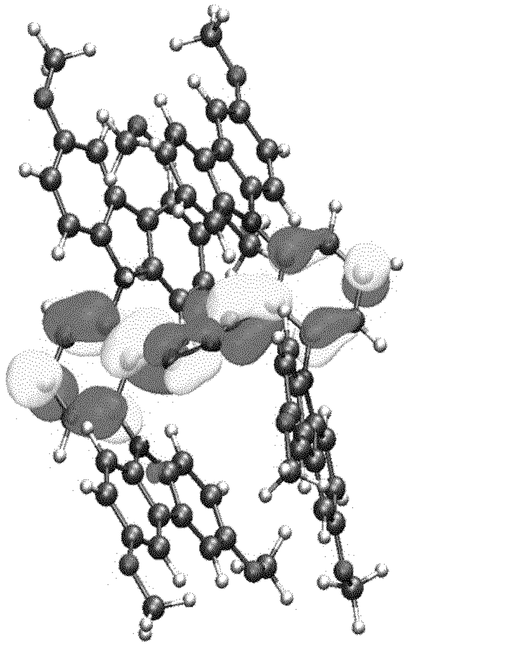 |
| 21 | 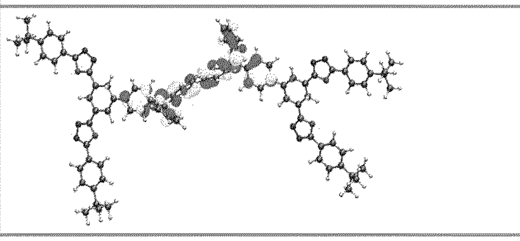 | 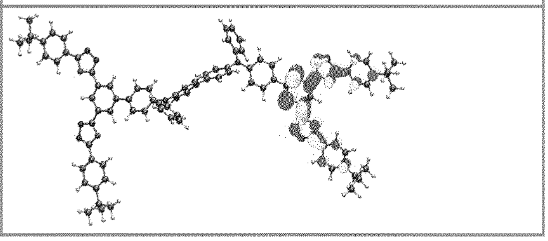 |

| | | |
|---|---|---|
| 22 | 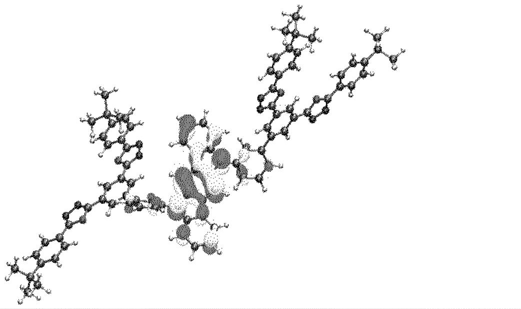 | 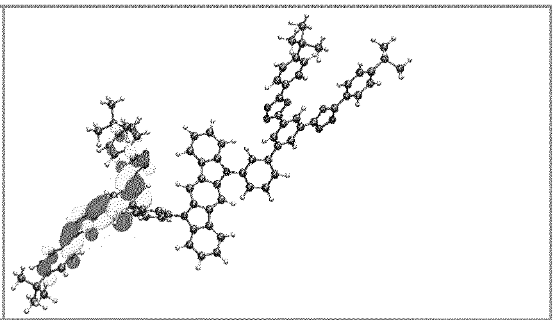 |
| 23 | 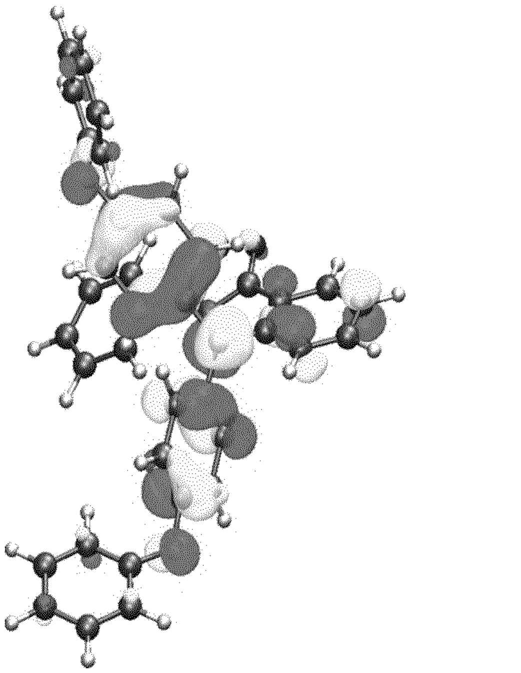 | 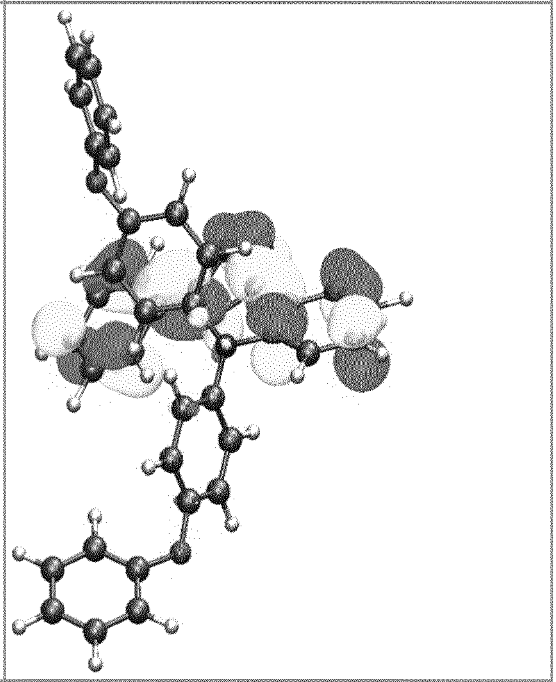 |
| 24 | 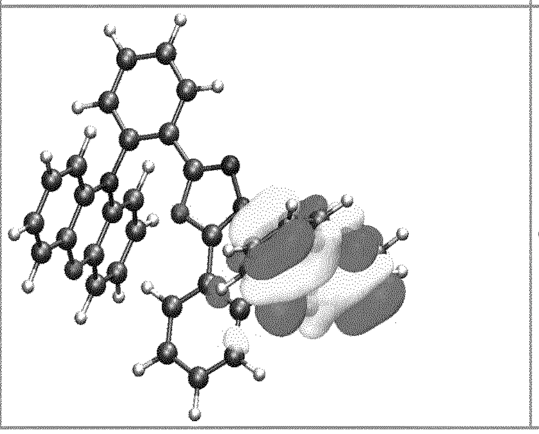 | 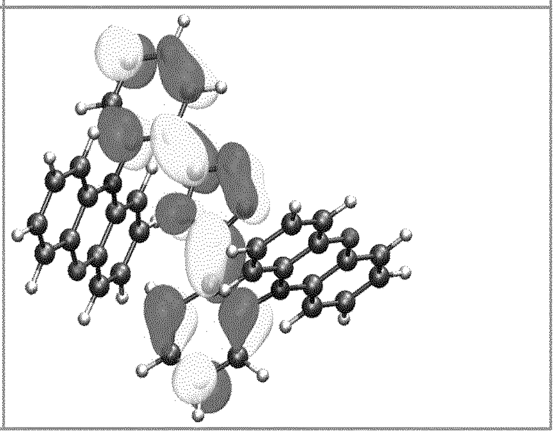 |

| | | |
|---|---|---|
| 25 | 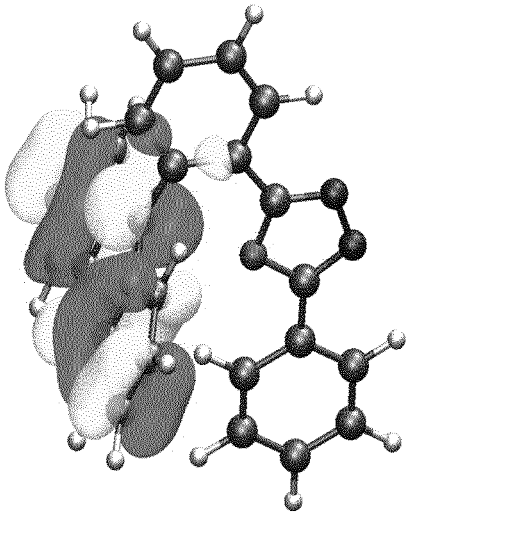 | 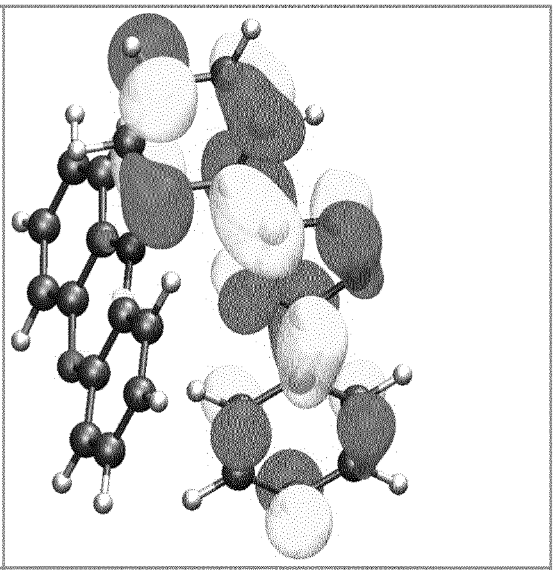 |
| 26 | 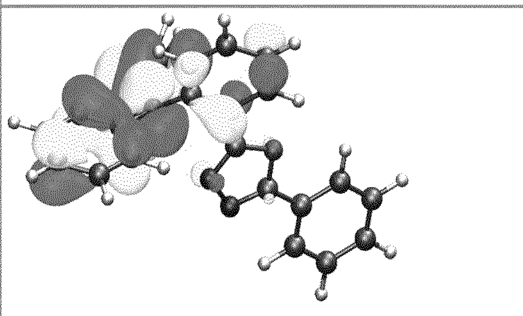 | 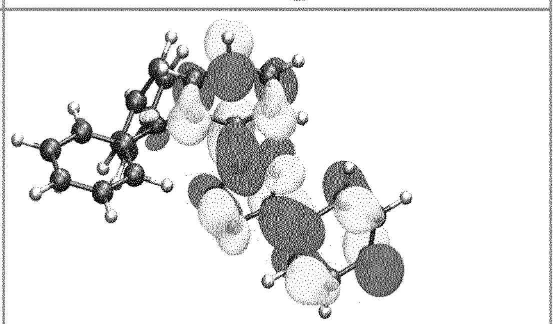 |
| 27 | 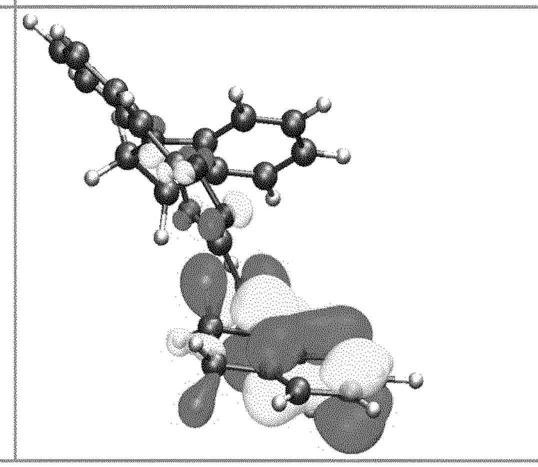 | 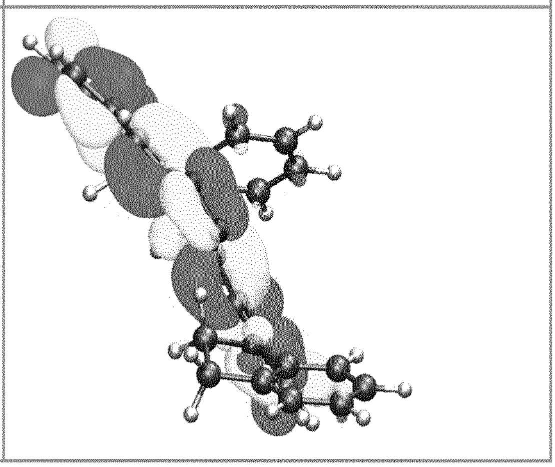 |

| | | |
|---|---|---|
| 28 | 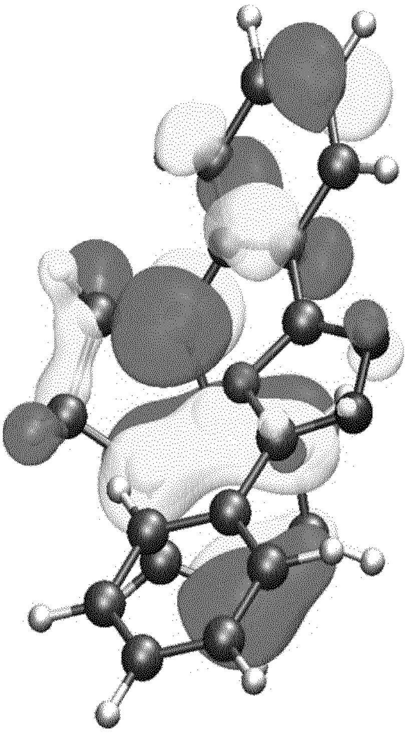 | 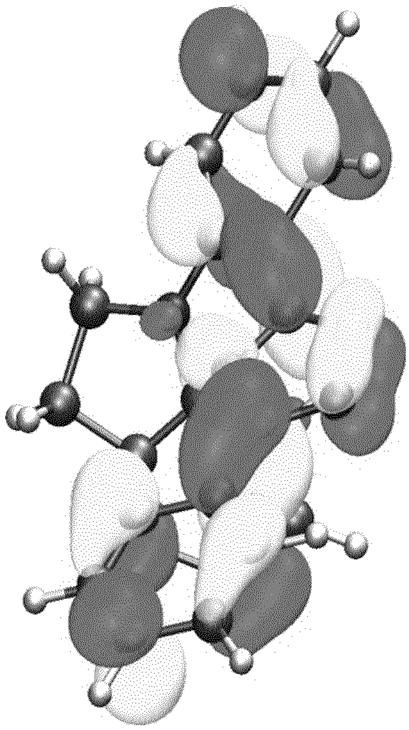 |
| 29 | 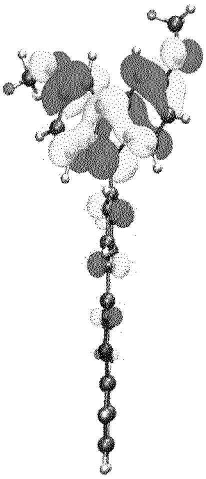 | 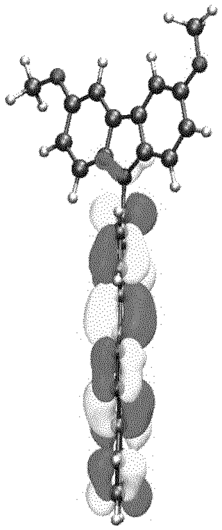 |
| 30 | 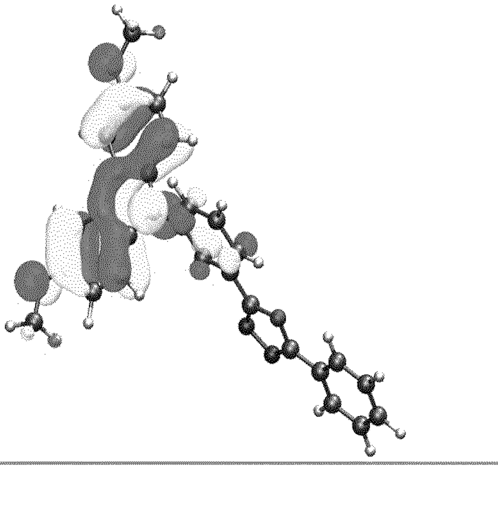 | 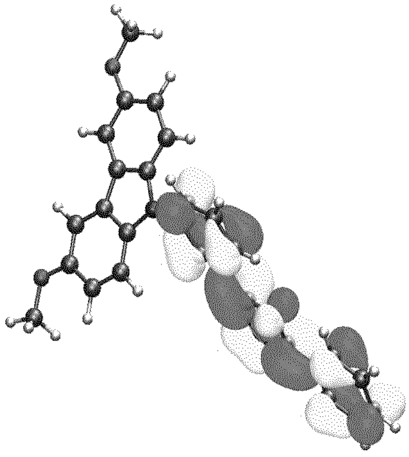 |

| | | |
|---|---|---|
| **31** | 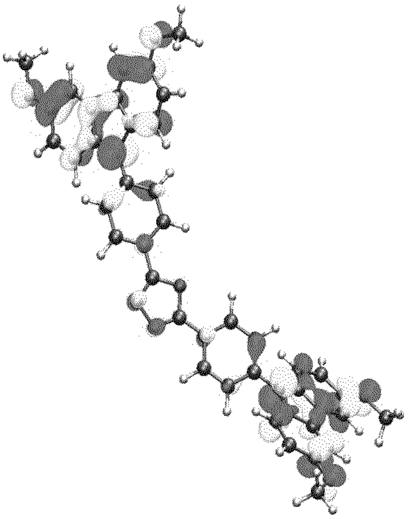 | 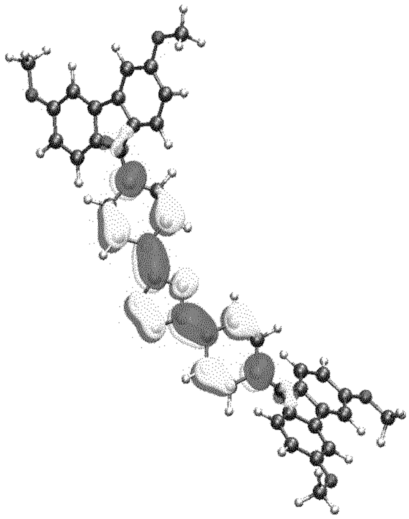 |
| **32** | 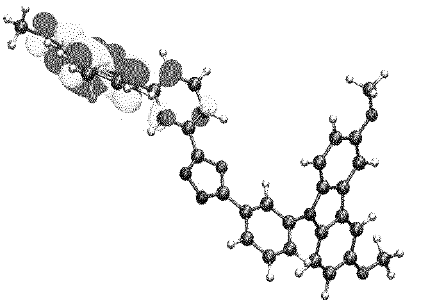 | 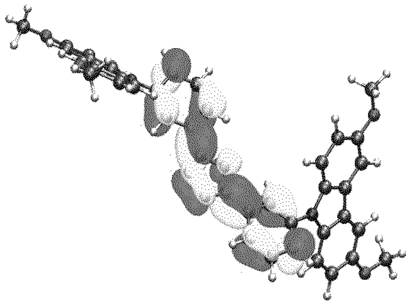 |
| **33** | 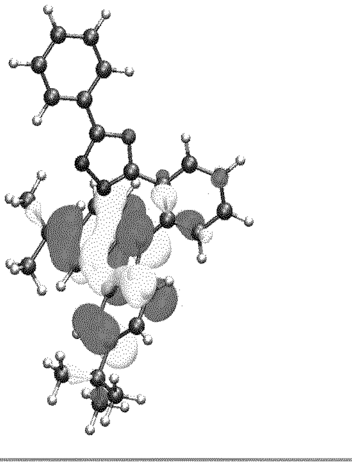 | 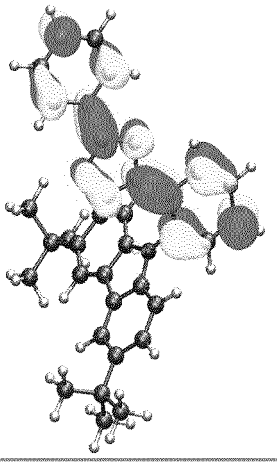 |

| | | |
|---|---|---|
| 34 | 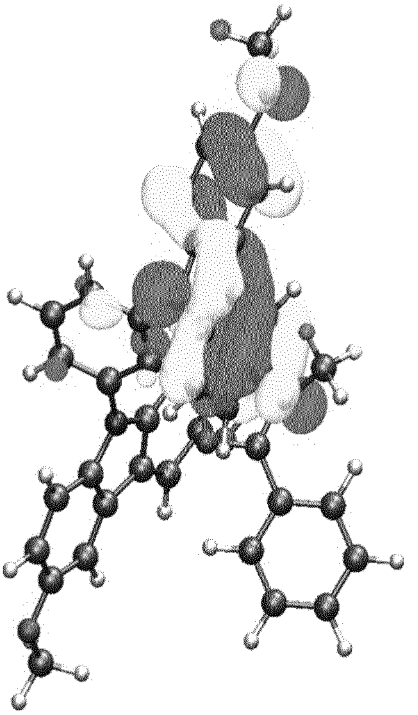 | 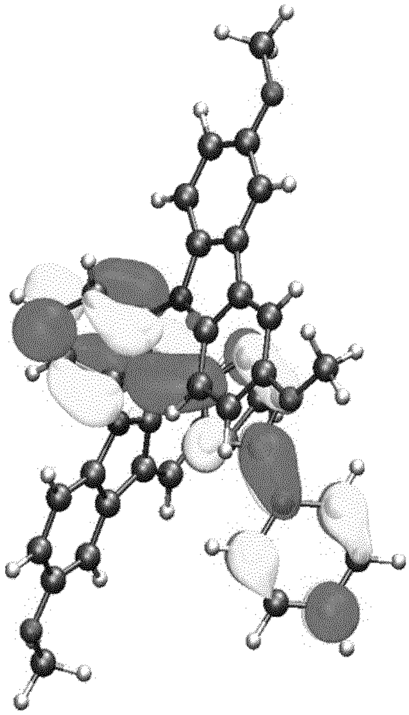 |
| 35 | 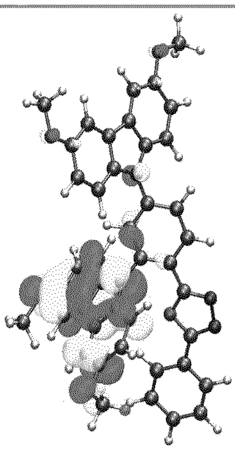 | 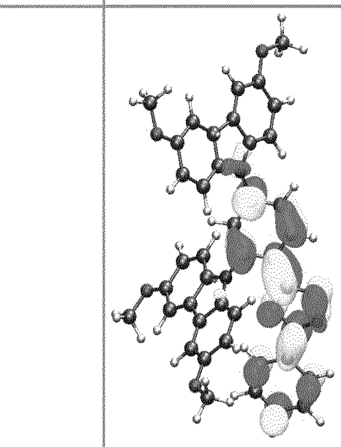 |
| 36 | 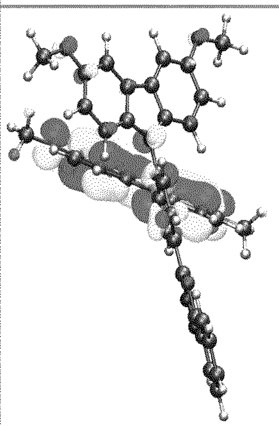 | 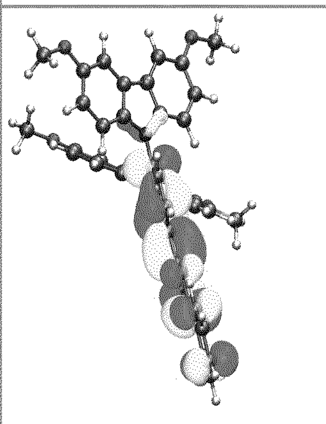 |

| | | |
|---|---|---|
| 37 | 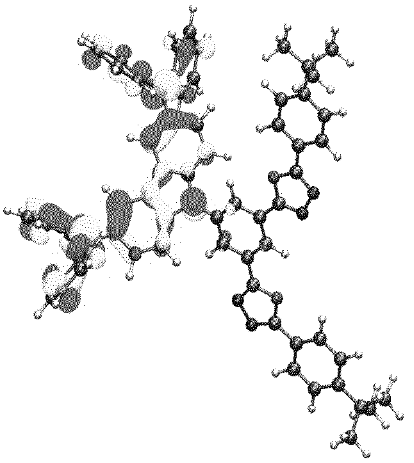 | 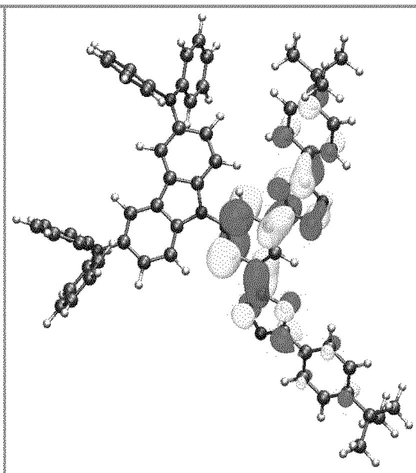 |
| 38 | 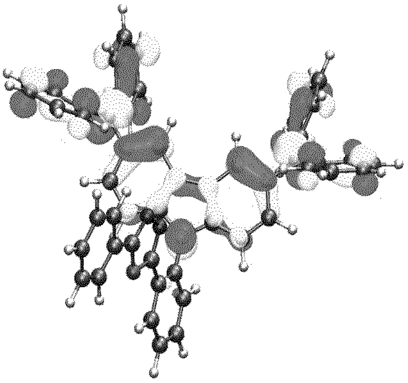 | 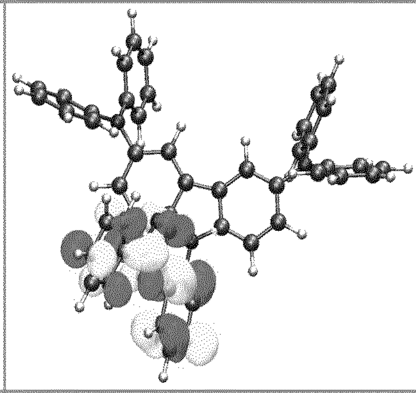 |
| 39 | 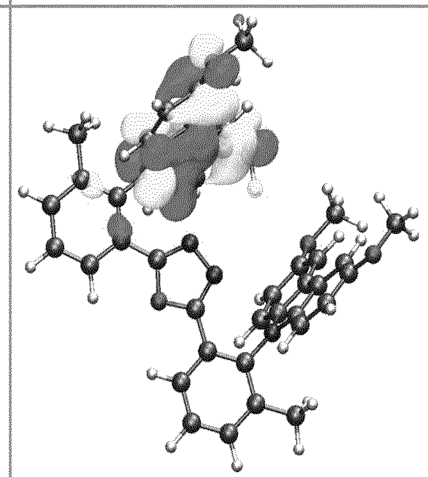 | 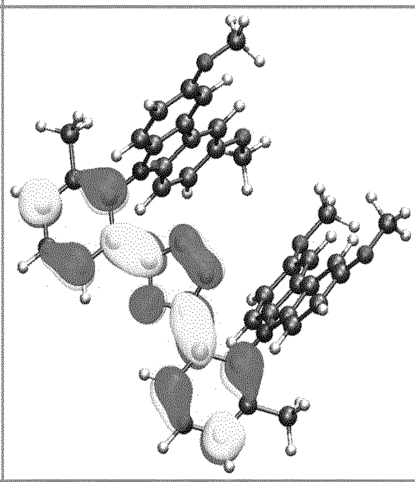 |
| 40 | 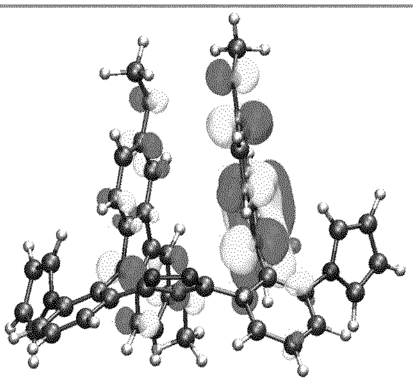 | 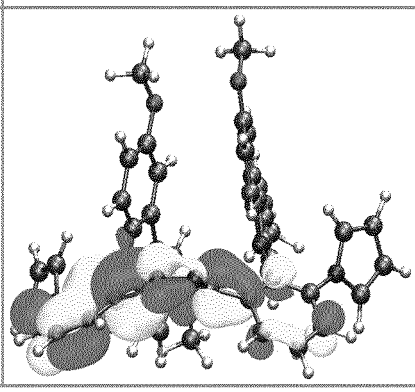 |

| | | |
|---|---|---|
| **41** | 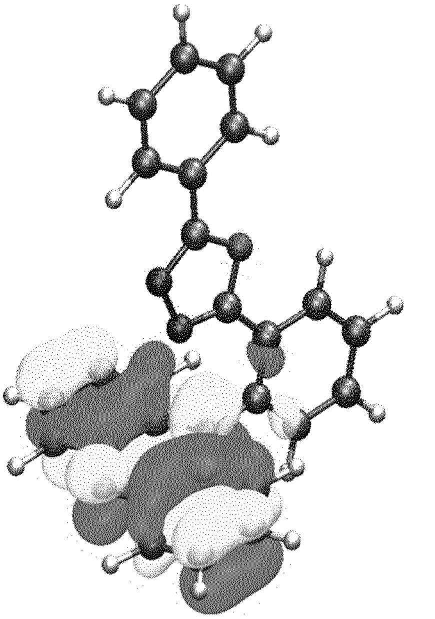 | 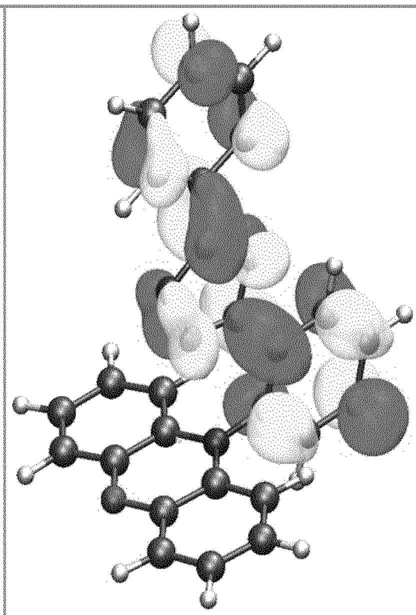 |
| **42** | 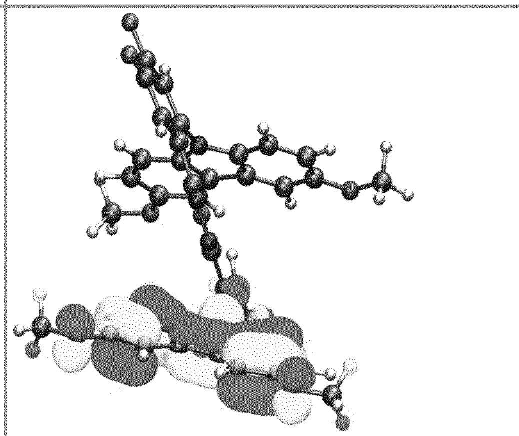 | 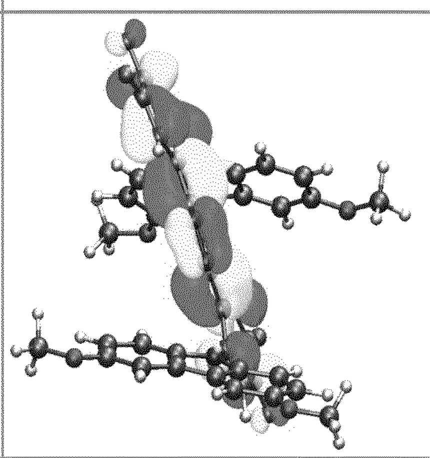 |
| **43** | 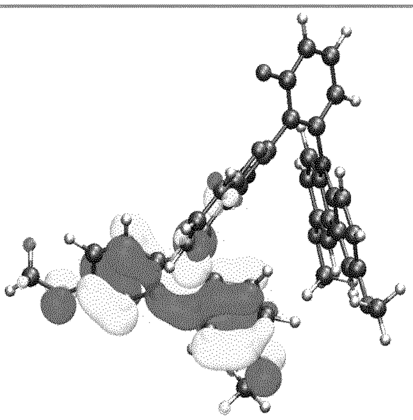 | 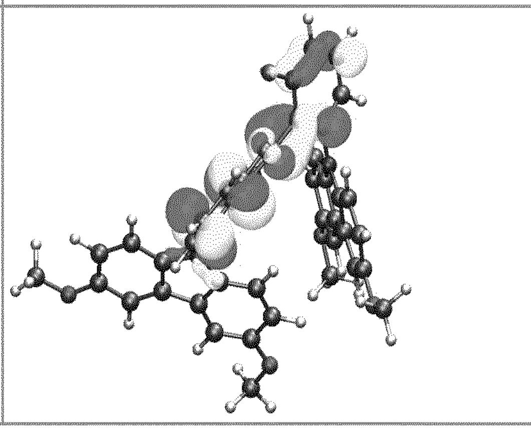 |

| | | |
|---|---|---|
| 44 | 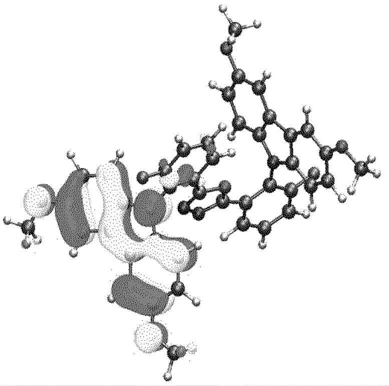 | 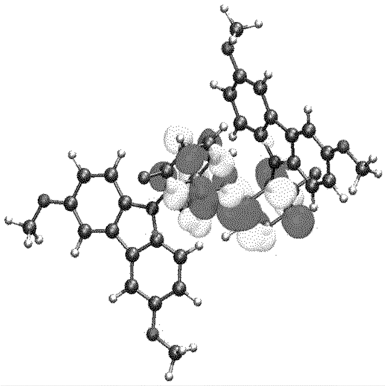 |
| 45 | 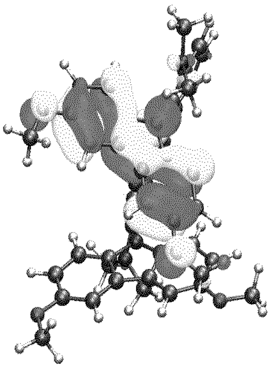 | 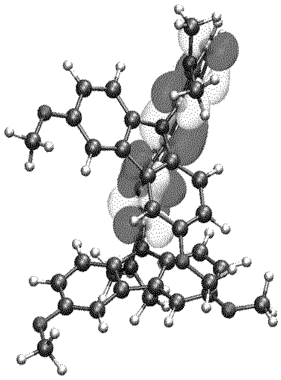 |
| 46 | 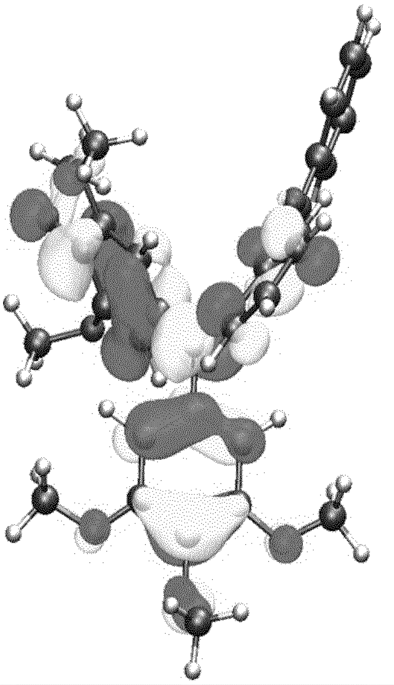 | 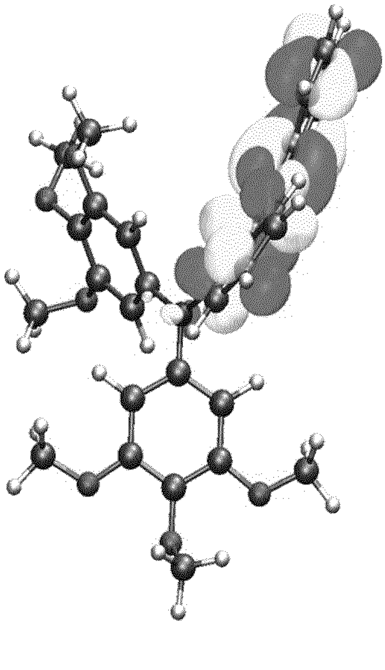 |
| 47 | 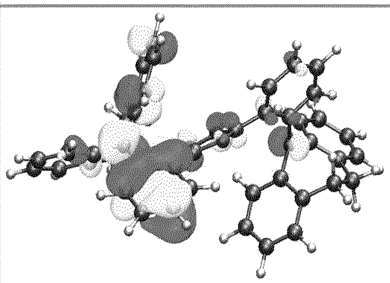 | 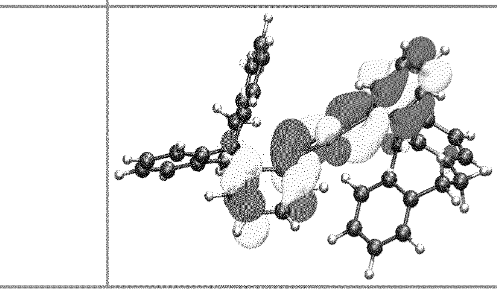 |

| | | |
|---|---|---|
| 48 | 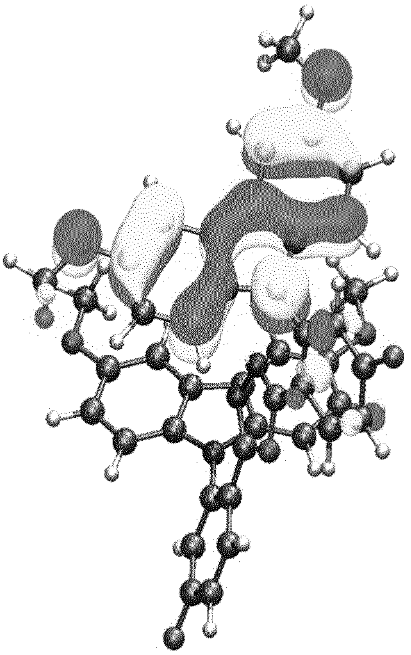 | 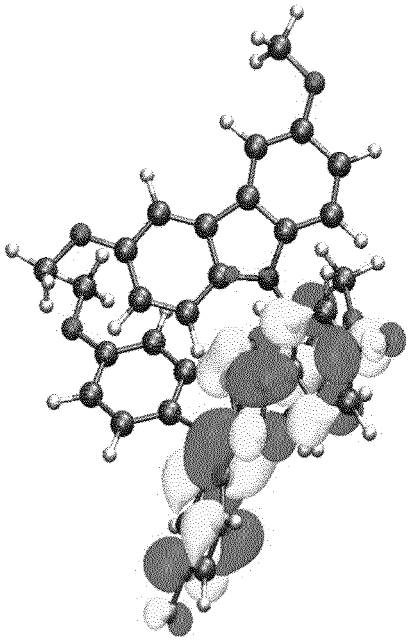 |
| 49 | 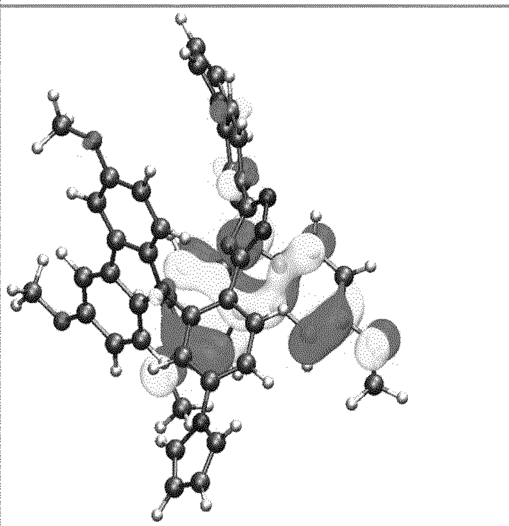 | 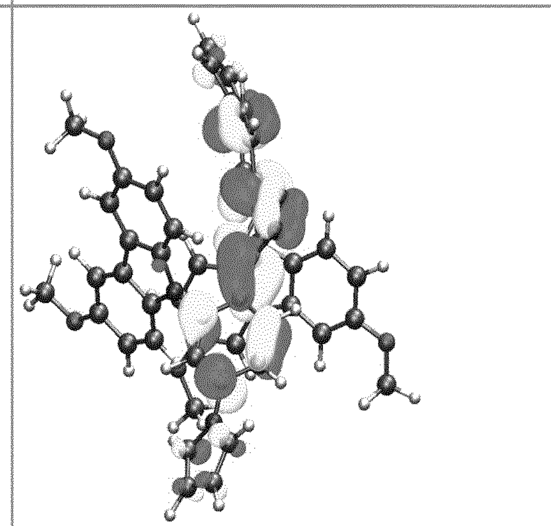 |
| 50 | 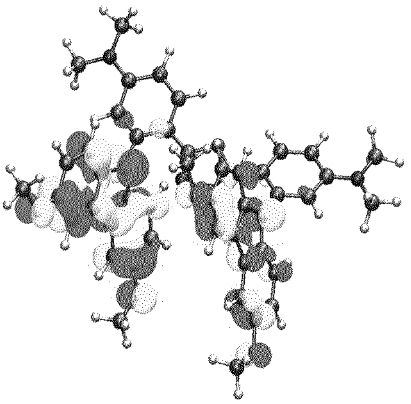 | 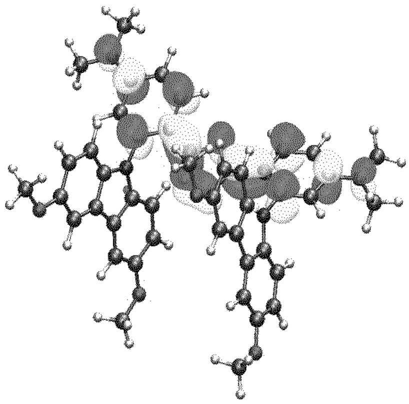 |

| | | |
|---|---|---|
| 51 | 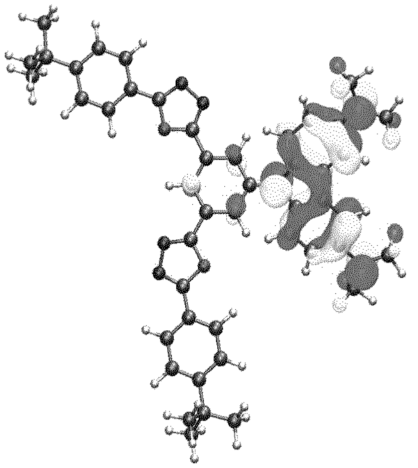 | 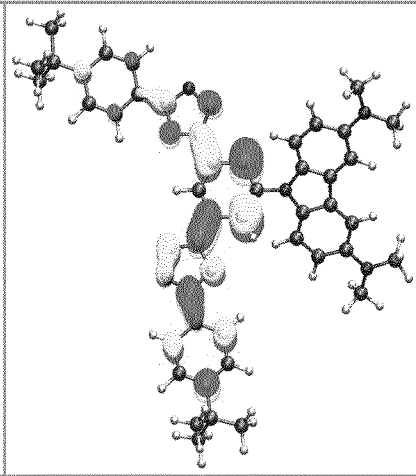 |
| 52 | 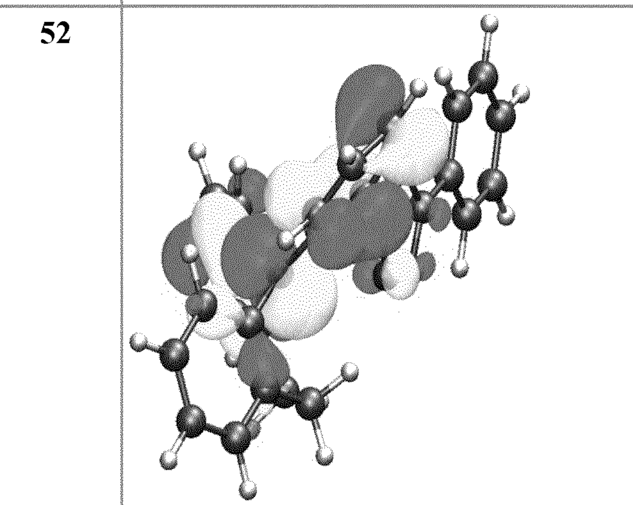 | 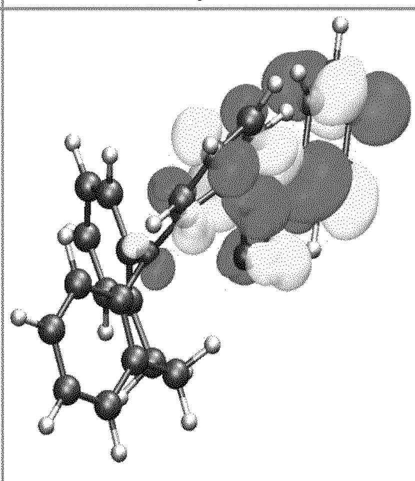 |
| 53 | 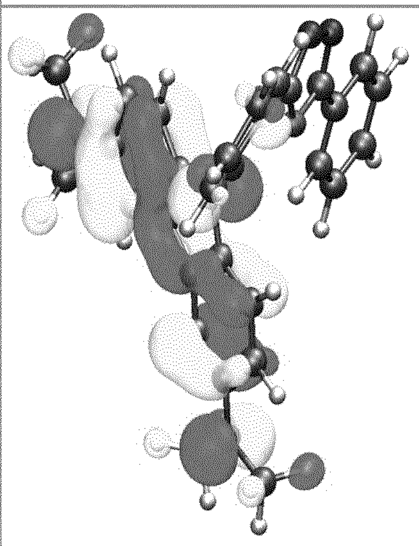 | 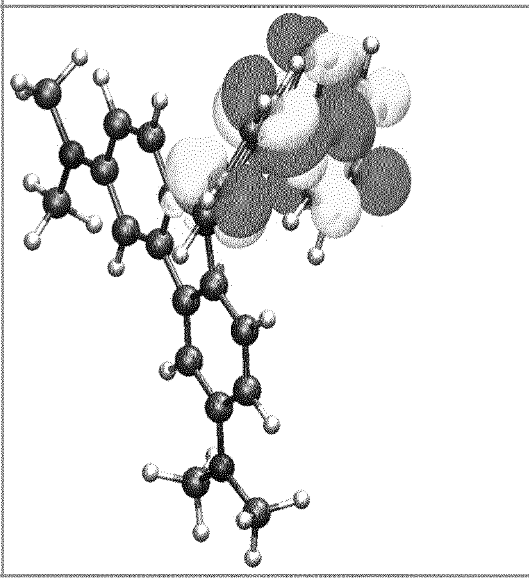 |

| | | |
|---|---|---|
| 54 | 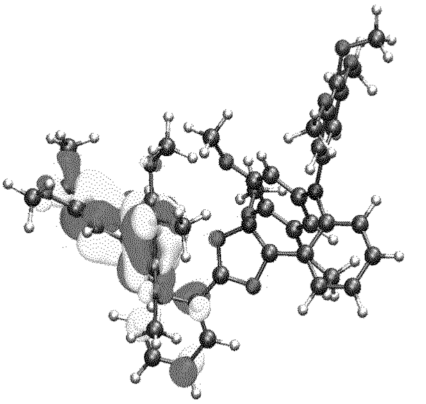 | 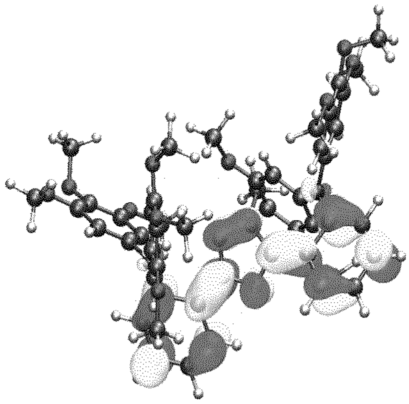 |
| 55 | 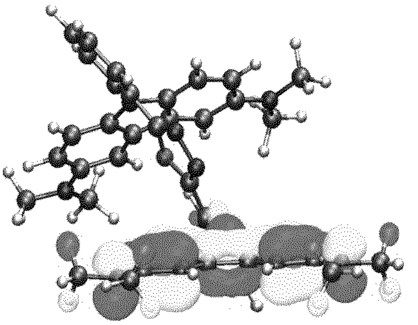 | 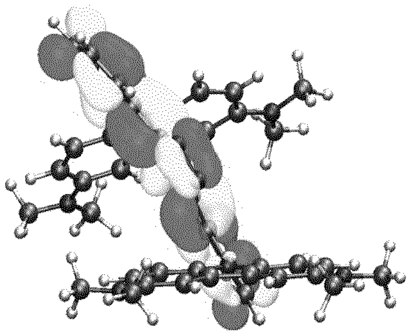 |
| 56 | 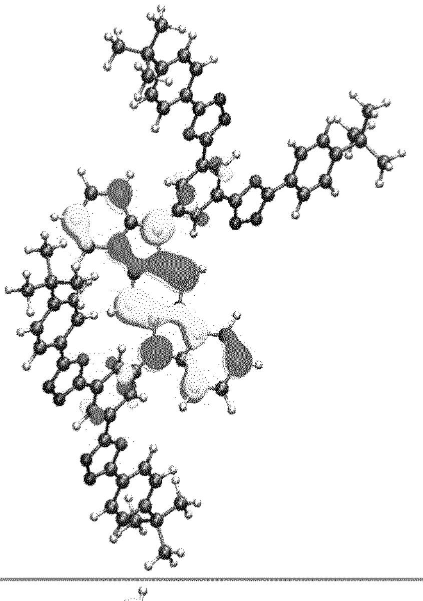 | 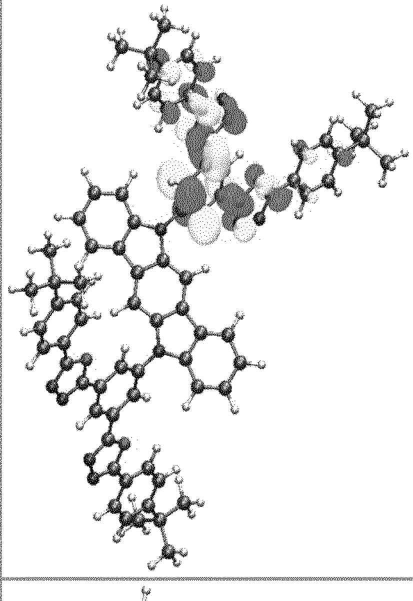 |
| 57 | 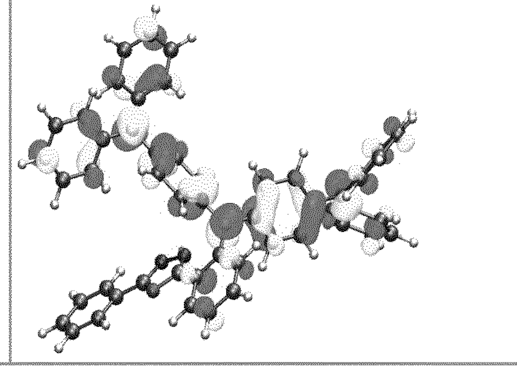 | 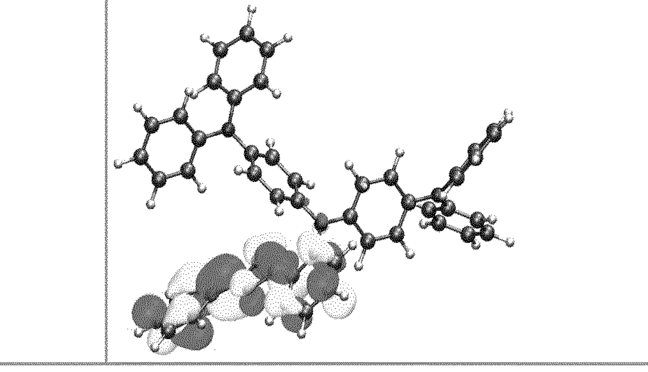 |

| | | |
|---|---|---|
| **58** | 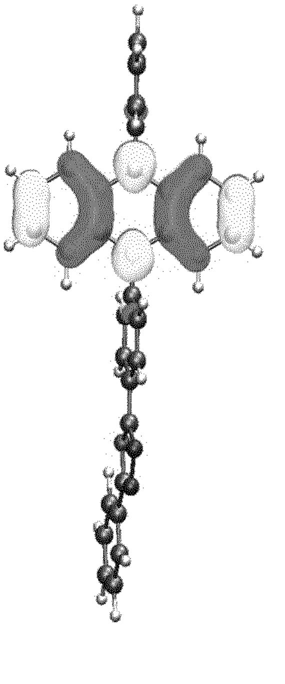 | 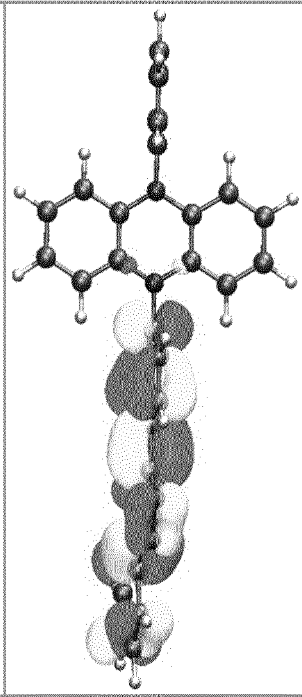 |
| **59** | 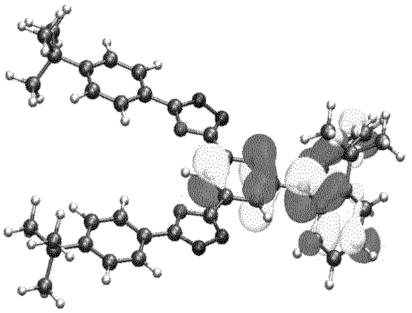 | 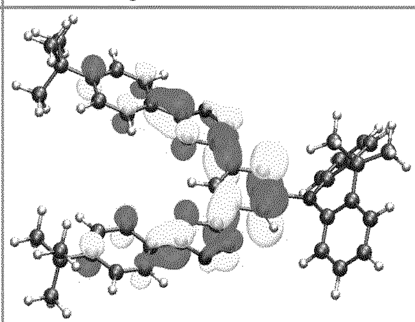 |
| **60** | 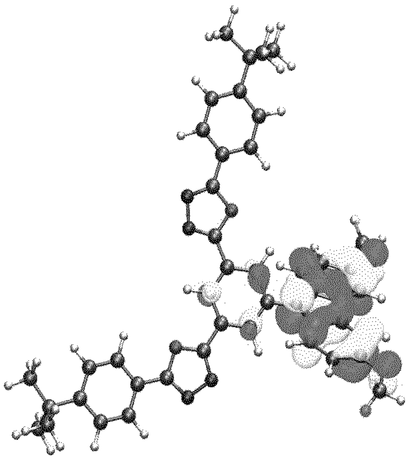 | 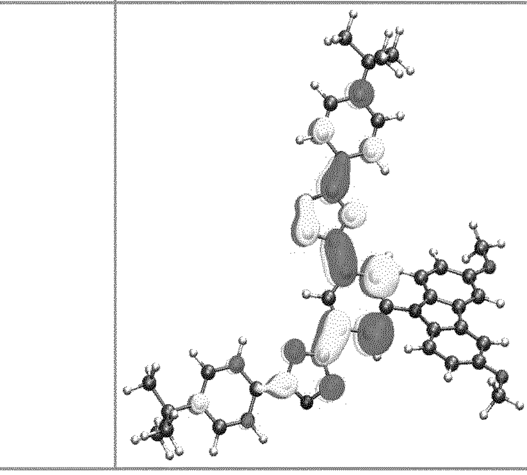 |

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 0879868 A2
- WO 2008149828 A1
- US 2007222376 A1


### In der Beschreibung aufgeführte Nicht-Patentliteratur


- **H. YERSIN.** *Top. Curr. Chem.,* 2004, vol. 241, 1
- **H. YERSIN.** Highly Efficient OLEDs with Phosphorescent Materials. Wiley-VCH, 2008
- **TANG et al.** *Appl. Phys. Lett.,* 1987, vol. 51, 913
- **M. A. BALDO ; D. F. O'BRIEN ; M. E. THOMPSON ; S. R. FORREST.** *Phys. Rev. B,* 1999, vol. 60, 14422
- *Nature Photonics,* 2014, vol. 8, 326-332
- **VOLZ et al.** *Chem Mater.,* 2013, vol. 25 (17), 3414-3426
- *Chem Mater.,* 2013, vol. 25 (17), 3414-3426
- **YERSIN et al.** *J. Am. Chem. Soc.,* 2014, vol. 136 (45), 16032-16038